# EUROPÄISCHE PATENTSCHRIFT

(11) **EP 2 589 275 B1**
(45) Veröffentlichungstag und Bekanntmachung des Hinweises auf die Patenterteilung: **18.04.2018**
(21) Anmeldenummer: 11728610.4
(22) Anmeldetag: 17.06.2011
(51) Int. Cl.: H05K 7/14, H01R 9/24

(54) **BUSFÄHIGES ANSCHLUSS- UND/ODER FUNKTIONSMODUL UND ANSCHLUSSSYSTEM MIT DERARTIGEN MODULEN**
BUS-CAPABLE CONNECTING AND/OR FUNCTIONAL MODULE AND CONNECTING SYSTEM COMPRISING SUCH MODULES
MODULE FONCTIONNEL ET/OU DE CONNEXION COMPATIBLE BUS ET SYSTÈME DE CONNEXION COMPRENANT DES MODULES DE CE TYPE

(30) Priorität: 08.04.2011 DE 202011000834 U; 02.08.2010 DE 202010010904 U; 29.06.2010 DE 202010007945 U
(43) Veröffentlichungstag der Anmeldung: 08.05.2013
(73) Patentinhaber: Weidmüller Interface GmbH & Co. KG, 32758 Detmold (DE)
(72) Erfinder: BERGER, Timo, 33813 Oerlinghausen (DE); FEHLING, Stephan, 32791 Lage (DE); GRIESE, Björn, 33102 Paderborn (DE); KULTURIDI, Georg, 33605 Bielefeld (DE); LÜCKE-JANSSEN, Daniela, 49504 Lotte (DE); NIGGEMANN, Matthias, 32694 Dörentrup (DE); OPITZ, Gordon, 32130 Enger (DE); PÜSCHNER, Klaus, Detmold 32760 (DE); SCHNATWINKEL, Michael, 32051 Herford (DE); SCHUMACHER, Ralf, 32657 Lemgo (DE); WOHLGEMUTH, Klaus, 32689 Kalletal (DE)
(74) Vertreter: Specht, Peter
(86) Internationale Anmeldenummer: PCT/EP2011/060115
(87) Internationale Veröffentlichungsnummer: WO 2012/000807

(56) Entgegenhaltungen:
- EP-A1- 0 364 618
- EP-A1- 1 524 890
- DE-A1- 19 651 961
- DE-A1- 19 822 564

## Beschreibung

Die Erfindung betrifft ein busfähiges Anschluss- und/oder Funktionsmodul zur Steuerung und/oder Überwachung technischer Prozesse und/oder zur Industrie- und/oder Gebäudeautomatisierung nach dem Oberbegriff des Anspruchs 1 und ein Anschlusssystem mit derartigen Anschluss- und/oder Funktionsmodulen.

Anschluss- und/oder Funktionsmodule sind beispielsweise aus der gattungsgemäßen EP 0 364 618 B1, der DE 44 02 002 A1, der EP 0 709 933 A2 und der DE 199 64 156 A1 bekannt. Während die EP 95 113 730 A1 Anschluss- und/oder Funktionsmodule mit einem eher blockartigen Aufbau mit einer Mehrzahl an Anschlussebenen zum Anschluss externer Leiter offenbart, ist aus der gattungsgemäßen DE 199 64 156 A1 eine Mischbauweise mit scheibenartigen Geräten mit jeweils zwei zueinander parallelen Anschlussebenen und blockartigen Geräten mit einer Mehrzahl aus Anschlussebenen bekannt.

Die gattungsgemäße EP 0 364 618 B1 derselben Anmelderin weist Basisklemmenträger auf, in die Druckkontakte eingesetzt sind, die einander im aneinander gereihten Zustand kontaktieren und die derart über mehrere Module hinweg durchgehende Busleitungen ausbilden. Zum Kontaktieren einer Leiterplatte einer auf die Basisklemmenträger aufsetzbaren Elektronikeinheit dienen Steckverbinder.

Ein Modul mit den Merkmalen des Oberbegriffs des Anspruchs 1 ist aus DE 196 51 961 A1 bekannt.

Ein Problem der aus dem Stand der Technik bekannten Lösungen besteht darin, dass die bekannten Anschluss- und/oder Funktionsmodule in der Regel nur für eine bestimmte Anschlussgröße von Leitern geeignet sind, so z.B. 1,5mm², selten für größere Querschnitte, so z.B. 4mm² und kaum angepasst auf die Sensorleitungen, so z.B. 0,34 mm². In der Regel werden unterschiedlichste Leitertechniken realisiert (1 Leiter, 2 Leiter, 3 Leiter, 4 Leiter), was Versprünge in den Modullängen senkrecht zur Tragschiene bedingt. Es gibt daneben zwar auch Anschlusssysteme mit Anschluss- und/oder Funktionsmodulen mit einer einheitlichen Modullänge. Derartige Systeme sind aber in der Regel wiederum wenig flexibel, da sie oftmals für den jeweiligen Einsatzzweck zu viel oder zu wenige Anschlüsse für Leiter oder Steckvorrichtungen aufweisen.

Die zuvor geschilderte, zu geringe Anpassbarkeit des Anschlusssystems an die jeweilige Applikation spiegelt sich - was nachstehend deutlicher werden wird - auch in anderen Aspekten des Standes der Technik wieder.

Es ist daher gegenüber dem Stand der Technik die Aufgabe der Erfindung, ein Anschlusssystem und Anschluss- und/oder Funktionsmodule mit einem jeweils besonders klar strukturierten und an verschiedenste Applikationen leicht anpassbaren Aufbau zu schaffen, welches für den Bediener sehr leicht handhabbar ist.

Die Erfindung löst diese Aufgabe durch den Gegenstand des Anspruchs 1 und auch durch die Gegenstände der weiteren unabhängigen Ansprüche. Die Gegenstände dieser Ansprüche sind allein für sich als selbstständige Erfindungen zu betrachten, entfalten aber auch in Kombination eine besonders vorteilhafte kombinatorische Wirkung. Vorteilhafte Ausgestaltungen sind den Unteransprüchen zu entnehmen.

Erfindungsgemäß werden beispielsweise folgende Probleme gelöst: Es wird eine weitgehende Standardisierung und Modularisierung der Anschlussebene und eine Funktionenintegration über / in die Anschlussebene bei gleichzeitiger Konturstandardisierung unterschiedlichster Produktkategorien erreicht.

Dabei wird eine Funktionenintegration, Netzwerkfähigkeit, Verarbeitungsfähigkeit und Steckbarkeit von Produktkategorien der Steuerungs-, Signalanpassungs- und Übergabeebene vorgeschlagen.

Nach einer besonders bevorzugten Ausgestaltung wird auch eine Integration von verschiedensten Funktionen Remote I/O, Signalwandler, Relaisbausteine, Übergabeelemente, Reihenklemmen, ... in nur einem System erreicht.

Erreicht wird zudem nach einer vorteilhaften Ausgestaltung auch eine Netzwerkfähigkeit von bisher nicht kommunikationsfähigen Betriebsmitteln wie Signalwandler, Relaisbausteine, Zeitrelais, Reihenklemmen. Derart ergibt sich ein deutlicher Mehrwert für den Kunden durch Vernetzung (und Verschmelzung) der Komponenten.

Erreichbar ist auch eine Integration von kleinen Controllern und Laufzeitsystemen, die einerseits zur Kommunikation und andererseits zur optionalen Signalverarbeitung genutzt werden können.

Erreicht wird vorzugsweise auch eine Steckbarkeit durch Definition von Standardsteckgesichtern am Leiterplatten- und Gehäuserand.

Insbesondere die Integration der Übergabe- und Signalanpassungsebene in die Remote I/O-Station schafft Platz-, Übersichtlichkeits- und Verdrahtungszeit-Vorteile.

Der bekannte Schaltschrankaufbau innerhalb einer Station wird grundlegend verändert und optimiert, sodass zur objektorientierten Programmierung eine objektorientierte HW-Zusammenstellung und eine objektorientierte Verdrahtung (bei weiterer Dezentralisierung auf die Maschinenmodule) stattfinden kann.

Die Module und damit Automatisierungsobjekte einer Lötmaschine könnten z.B. sein: Zuführmodul, Fluxermodul, Vorwärmmodul, Lötwellenmodul, Kühlmodul.

Dazu werden die Funktionen einer Reihenklemme (Übergabeebene) vorzugsweise in Leiterplattenverbinder (PCB) integriert, diese PCB-Komponenten mit den Elektronikkomponenten der Signalanpassungsebene kombiniert und diese Bausteine auf eine Plattform von I/O-Elektroniken gesetzt.

Geschaffen wird ein ganzheitliches, durchgängiges, Produktkategorien übergreifendes System von HW-/SW-Komponenten für die Verbindung, Übertragung, Anpassung, Verarbeitung, Überwachung und Zustandsprognose (CM) von Energie, Daten und Signalen.

Insgesamt ergibt sich ein ganzheitliches Bausteinesystem (Produktfamilie) aus busfähigen, aktiven und passiven Komponenten für ein ganzheitliches, sicheres Automatisierungsnetzwerk. In Verbindung mit dem Wissen um die Applikation und entsprechenden Dienstleitungen können passgenaue Lösungen für den Kunden wirtschaftlich bereitgestellt werden.

Es wird eine Lösungsstandardisierung von Produktkategorien der Steuerungs-, Signalanpassungs- und Übergabeebene vorgeschlagen:
- gleiches Raster verschiedener Produktkategorien wie z.B. Remote I/O, Signalwandler, Relaisbausteine, Übergabeelemente, Reihenklemmen, ...;
- gleiche Produktlängen verschiedener Produktkategorien
- damit standardmäßig gleiche Produktkontur verschiedener Produktkategorien
- gleiche Steckplätze und Verrastungskonturen für unterschiedlichste Elektroniken, Anschlussquerschnitte und -techniken
- gleiche Bauräume (oder eine Vielfaches) für unterschiedliche Steckelektroniken
- Anordnung / Vorzugsbelegungen von Funktionen zu Bauräumen über die Produktkategorien hinweg.

Dadurch ergibt sich für den Kunden bzw. Nutzer folgender Nutzen:
- applikationsspezifische / -gerechte Funktionen- und Gerätezusammenstellung
- hohe Flexibilität bzgl. Funktionalität, Mischbarkeit der Module und Erweiterbarkeit der Station
- gleiches Zubehör, hohe Wiederverwendung von HW- und SW-Komponenten
- platzsparender Aufbau
- geringerer Verdrahtungsaufwand / Reduzierung der Anzahl händischer Schnittstellen zwischen den Komponenten
- identische, intuitive Handhabung mit wenig Arbeitsschritten, weniger Fehlermöglichkeiten
- wirtschaftliche Lösung. Durch Wiederverwendbarkeit von Einzelteilen u. Baugruppen in unterschiedlichen Produktkategorien werden hohe Stückzahlen erzeugt.

Die Erfindung ermöglicht in ihren verschiedenen Ausgestaltungen ein übergreifendes System und eine Lösungsstandardisierung einerseits mit einer besonders weitgehenden Kombinierbarkeit / Aneinanderreihbarkeit und weitgehender äußerlich gleieher oder zumindest weitgehend ähnlicher Form unterschiedlicher Produktkategorien nebeneinander, die auf derselben oder unterschiedlichen Tragschienen positioniert werden, und andererseits auf die Kombinierbarkeit/ Stapelbarkeit unterschiedlicher Produktkategorien der I/O-Ebene, Signalanpassungsebene und Übergabeebene übereinander.

Im Wesentlichen handelt es sich um Stationen von busfähigen Reihenklemmen (bRK), die aus einer I/O-Ebene und einer aufsteckbaren Steckebene, die in der Regel als Anschluss- / Verdrahtungsebene ausgeprägt ist, besteht. Optional kann eine Signalanpassungsebene zwischen I/O- und Anschlussebene integriert werden.

Dabei wird als Signalanpassungsebene eine Signalanpassungselektronik zwischen die I/O-Ebene mit der I/O-Elektronik und die Anschlussebene schaltbar bzw. integrierbar/integriert, welche eingehende Signale "anpasst" bzw. umsetzt, zu deren Verarbeitung/Anpassung die I/O-Ebene bzw. die I/O-Elektronik an sich nicht ausgelegt ist, z.B., weil eine anzuschließendes Gerät wie ein Sensor einen Ausgabebereich von Spannungen aufweist, zu deren Verarbeitung die I/O-Elektronik nicht ausgelegt ist. Dies wird durch eine individuell setzbare Signalanpassungsebene bzw. Signalanpassungs-Funktionsbausteine behoben, welche auf die Anschluss- und Funktionsmodule direkt aufsetzbar sind. Derart wird der Einsatzbereich der Erfindung deutlich erhöht.

Geschaffen wird nach einer Variante auch eine Kombination von mit Gehäusen und Anschlusstechnik umbauten, aufrecht stehenden und flach liegenden Leiterplatten zu hohen (z.B. ca. 76mm) und niedrigen (z.B. ca. 44mm) Scheiben / Blöcken mit aufrecht stehenden Leiterplatten und zu niedrigen (ca. 44mm) Blöcken mit flach liegenden Leiterplatten für busfähige (I/O), aktive (Relaismodule, alleinstehende Signalwandler) und passive (Reihenklemme) Komponenten, wobei die Kontaktierungspunkte von Power- und Datenbus einerseits und die Lagen der Anschlussebenen andererseits der hohen und niedrigen Scheiben / Blöcke höhenmäßig aufeinander abgestimmt sind.

Vor der Beschreibung bevorzugter Ausführungsbeispiele sei angemerkt, dass nachfolgend einige bevorzugte Ausgestaltungen auch im Detail beschrieben werden, dass die Erfindung aber nicht auf diese Ausgestaltungen beschränkt ist sondern im Rahmen der Ansprüche beliebig variiert ausgestaltet werden kann. Insbesondere sind Begriffe wie "oben", "unten", "vorne" oder "hinten" nicht einschränkend zu verstehen sondern beziehen sich lediglich auf die jeweils dargestellte Anordnung. Zudem sind, wenn einzelne Bestandteile erläutert werden, diese - wenn nicht anders erwähnt - grundsätzlich auch in mehrfacher Ausgestaltung denkbar. Unter den Schutzbereich fallen zudem auch kinematische Umkehrungen der dargestellten Anordnungen.

Nachfolgend wird die Erfindung unter Bezug auf die Zeichnung anhand von Ausführungsbeispielen näher beschrieben. Es zeigt:
- Fig. 1a: eine perspektivische Ansicht eines ersten Anschluss- und/oder Funktionsmoduls;
- Fig. 1b ein: Anschluss- und/oder Funktionsmodul ähnlich zu Fig. 1a mit teilausgeblendeter Vordergehäusewand;
- Fig. 1c, 1d: das Anschluss- und/oder Funktionsmodul aus Fig. 1b einmal mit eingeschobenen und einmal mit ausgefahrenen Verriegelungsschiebern;
- Fig. 2a-e: ein Handhaben eines Anschluss- und/oder Funktionsmoduls in mehreren Schritten;
- Fig. 3a-d: ein Ansetzen einer Anschluss- und/oder Funktionseinheit mit einem Rahmen an ein Anschluss- und/oder Funktionsmodul in mehreren Schritten;
- Fig. 4a, b: zwei verschiedene perspektivische Ansichten eines Rahmen mit Steckplätzen;
- Fig. 5a, b: eine perspektivische Ansicht eines Rahmen mit Steckplätzen und darin eingesetzten Anschlussbausteinen und eine perspektivische Ansicht eines Rahmen mit Steckplätzen und eine Auswahl von darin einsetzbaren Funktionsbausteinen;
- Fig. 6a - d: eine perspektivische Ansicht einer Reihung von Basisklemmenträgern und Anschluss- und Funktionseinheiten vor und nach dem Einsetzen eines Elektronikgehäuses, welches sich über vier Rasterbreiten erstreckt zur Bildung eines stehenden Blocks "vier Raster breit";
- Fig. 7a - d: eine perspektivische Ansicht einer Reihung von Basisklemmenträgern und Anschluss- und Funktionseinheiten vor und nach dem Einsetzen eines Elektronikgehäuses, welches sich über zwei Rasterbreiten erstreckt zur Bildung eines stehenden Blocks "zwei Raster breit";
- Fig. 8a, b: verschiedene Ansichten eines als Einspeisescheibe auslegten Anschlussmoduls mit großen Anschlüssen und Beschriftungsflächen/-schildern;
- Fig. 9: eine schematische Darstellung einer möglichen Anschlussbelegung und einer möglicher Markierungssystematik;
- Fig. 10a, b, c: verschiedene Ansichten und Varianten eines als Passiv-Reihenklemme auslegten Anschlussmoduls des Anschlusssystems;
- Fig. 11a - o: eine schematische Darstellung verschiedener Passiv-Reihenklemmen in einer Auslegung als Anschlussmodul des Anschlusssystems;
- Fig. 12a, b: verschiedene Ansichten eines Anschlussmoduls mit steckbaren Funktionsbausteinen, die wiederum eine steckbare Elektronik - beispielhaft eine Elektronikleiterplatte - und eine darauf aufsteckbare Anschlussebene aufweisen;
- Fig. 13a - c: verschiedene Ansichten steckbarer Funktionsbausteine, insbesondere zum Einstecken in Steckplätze des Rahmens, die wiederum eine steckbare Elektronik und eine darauf aufsteckbare Anschlussebene aufweisen;
- Fig. 14a, b: verschiedene Ansichten eines Anschlussmoduls mit steckbaren Funktionsbausteinen, die wiederum eine steckbare Elektronik und eine darauf aufsteckbare Anschlussebene aufweisen;
- Fig. 15a, b: verschiedene Ansichten des Anschlussmoduls aus Fig. 14 mit eingesteckten Funktionsbausteinen, in welche die Anschlussebene eingesteckt ist;
- Fig. 16a, b: eine große Elektronik mit stehender Verdrahtung an zwei Anschluss- und/oder Funktionsmodulen;
- Fig. 17a - e: eine große Elektronik mit stehender Verdrahtung an zwei Anschluss- und/oder Funktionsmodulen;
- Fig. 18a, b: eine große Elektronik mit stehender Verdrahtung an zwei Anschluss- und/oder Funktionsmodulen;
- Fig. 19a - d: eine weitere große Elektronik mit stehender Verdrahtung an zwei Anschluss- und/oder Funktionsmodulen;
- Fig. 20a-d: Ansichten eines Anschlussmoduls mit einem seitlichen Steckplatz und mit einem darin eingesetzten Funktionsbaustein;
- Fig. 21a-d: Ansichten eines Anschlussmoduls mit einem seitlichen Steckplatz für einen Funktionsbaustein und einen weiteren Funktionsbaustein, hier in 90°- Auslegung;
- Fig. 21e-h: Ansichten eines Anschlussmoduls mit zwei seitlichen Steckplätzen jeweils für einen weiteren Funktionsbaustein, hier ebenfalls in 90°- Auslegung;
- Fig. 22a-b: Ansichten eines Anschlussmoduls mit einem seitlichen Steckplatz für einen Steckvorrichtung, insbesondere zur Modulbusweiterleitung zu einer anderen Station;
- Fig. 23a-c: Ansichten eines ersten Funktionsmoduls, welches als Markierscheibe ausgebildet ist und je einen seitlichen Schienenhalter aufweist, der zur Halterung einer oder mehrerer Sammelschienen dient;
- Fig. 24a, b: Ansichten eines weiteren Funktionsmoduls, welches als Markierscheibe ausgebildet ist und einen seitlichen Schienenhalter aufweist, der zur Halterung einer oder mehrerer Sammelschienen dient;
- Fig. 25a: eine perspektivische Ansicht eines flachen blockartig ausgebildeten Anschluss- und Funktionsmoduls;
- Fig. 25b, c: Ansichten eines flachen blockartig ausgebildeten Anschluss- und Funktionsmoduls, mit steckbaren Funktionsbausteinen;
- Fig. 26: eine perspektivische Ansicht eines blockartig ausgebildeten Anschluss- und Funktionsmoduls mit Relais und Sicherungen und Anschlussvorrichtungen;
- Fig. 27, 28: weitere Ansichten des blockartig ausgebildeten Anschluss- und Funktionsmoduls mit Relais und Sicherungen und Anschlussvorrichtungen;
- Fig. 29 - 34: verschiedene Stationen aus einer Mehrzahl von Anschluss- und Funktionsmodulen;
- Fig. 35: eine Ansicht eines Anschluss- und Funktionsmoduls mit einer integrierten Signalanpassungsebene zwischen der Übergabeebene (Anschlussebene) und der I/O-Ebene; und
- Fig. 36: eine Ansicht eines flachen blockartigen Anschluss- und Funktionsmoduls mit einer integrierten Signalanpassungsebene zwischen der Übergabeebene (Anschlussebene) und der I/O-Ebene; und
- Fig. 37: Ansichten einer "niedrigen" Anschluss- und Funktionsscheibe;
- Fig. 38 a-d: eine weitere Ausführungsform eines flachen blockartig ausgebildeten Anschluss- und Funktionsmoduls mit steckbaren Relais und Funktionsbausteinen mit Sicherungen und Anschlusstechnik, diese alternativ zum Flachkabelstecker;
- Fig. 39 a-d: perspektivische Ansichten eines weiteren Anschluss- und Funktionsmoduls mit einer wechselbaren Elektronik;
- Fig. 40 a, b: Ansichten eines weiteren Anschluss- und Funktionsmoduls;
- Fig. 41 a, b: Zubehörteile für das Modul aus Fig. 40;
- Fig. 42: eine Ansicht eines weiteren Anschluss- und Funktionsmoduls;
- Fig. 43 a-c: eine weitere Ausführungsform einer Anschluss- und/oder Funktionseinheit, in die, wie Fig. 43a-b zeigt, verschiedene Funktionsbausteine anordbar sind; und

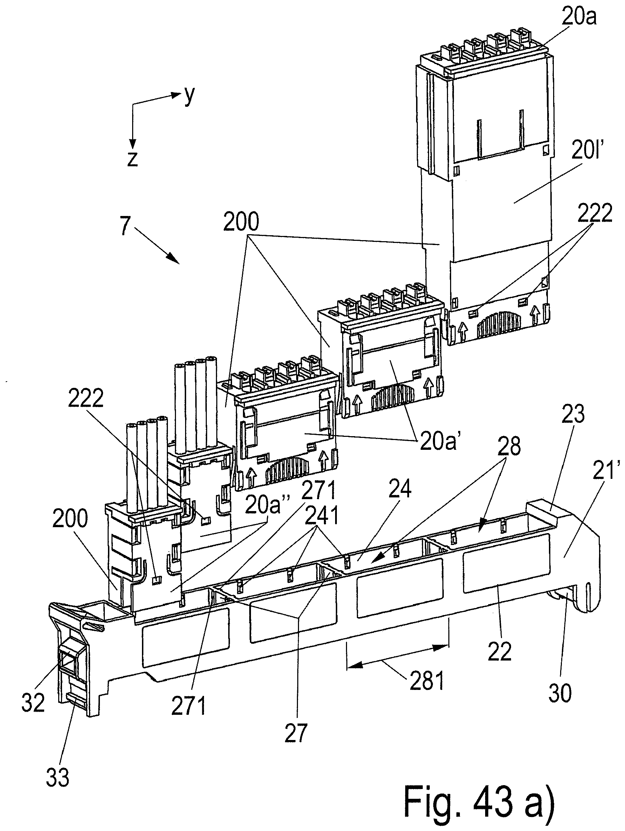

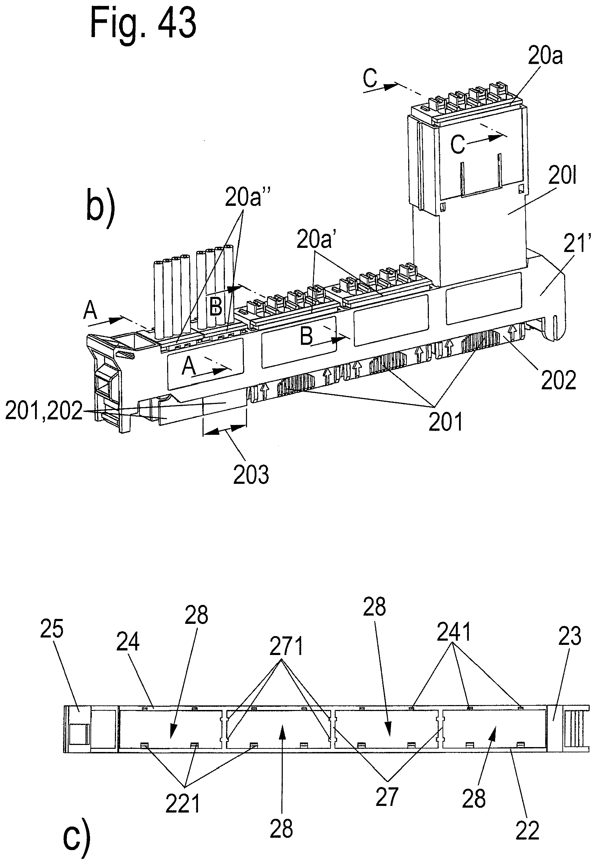

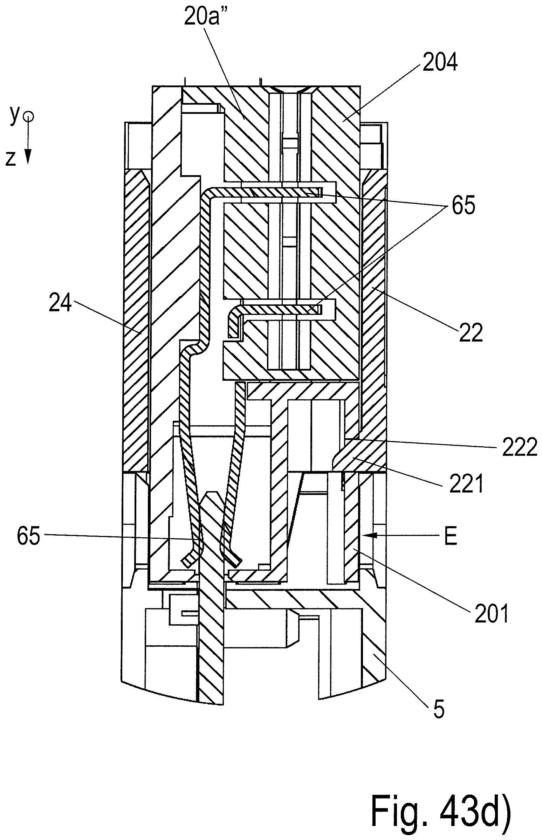

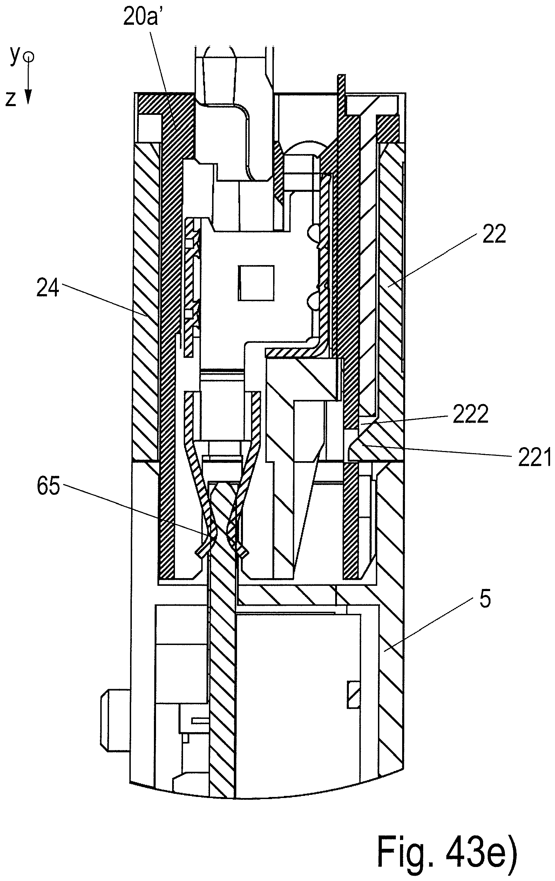

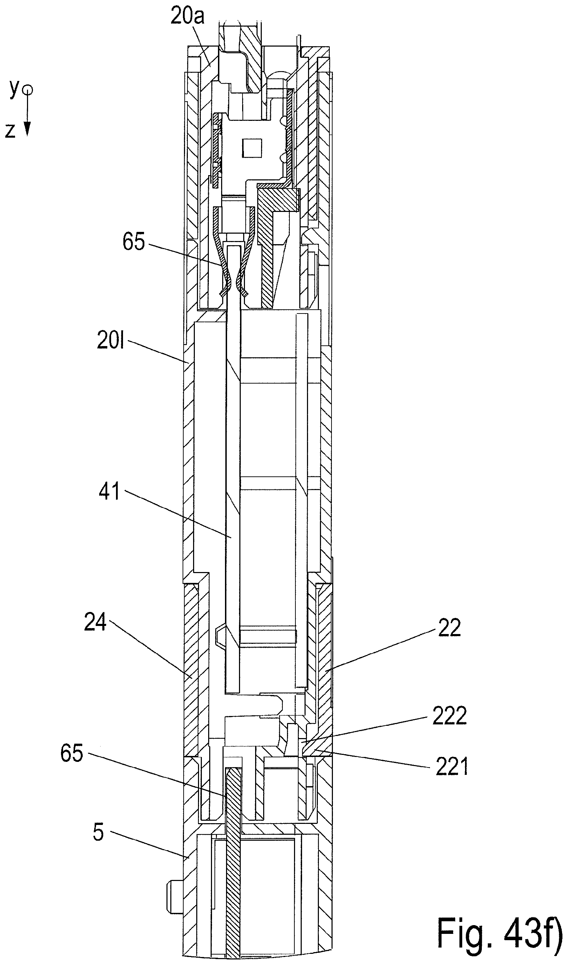

- Fig. 43 d-f: jeweils einen Schnitt A-A, B-B beziehungsweise C-C durch einen der Funktionsbausteine der Anschluss- und/oder Funktionseinheit der Fig. 43 b.

Erläutert werden nachstehend beispielhafte Anschluss- und/oder Funktionsmodule zur Steuerung und/oder Überwachung technischer Prozesse und/oder zur Industrie- und/oder Gebäudeautomatisierung und ein Anschlusssystem mit derartigen Anschluss- und/oder Funktionsmodulen. Der Begriff des Anschluss- und/oder Funktionsmoduls ist derart zu verstehen, dass jeweils wenigstens eine oder mehrere der durch die Begriffswahl "und/oder" vorgegebenen Optionen erfüllt ist bzw. sind. So können Anschlussmodule vorgesehen sein, die nur dem reinen Anschluss externer Geräte mittels eines Leiter- oder Steckeranschlusses dienen. Es können aber auch Funktionsmodule ohne Anschlussmöglichkeit für externe Leiter (beispielsweise Markiermodule) vorgesehen sein. In der Regel werden aber sowohl Anschlussfunktionen für externe Geräte bzw. deren Leiter als auch sonstige insbesondere elektronische Funktionen (z.B. eine Signalverarbeitung) realisiert.

Dabei sind die Anschluss- und Funktionsmodule aneinander reihbar, wobei sie übergreifende Busse ausbilden, welche an eine übergeordnete Steuerung direkt oder beispielsweise über ein Gateway anschließbar sind.

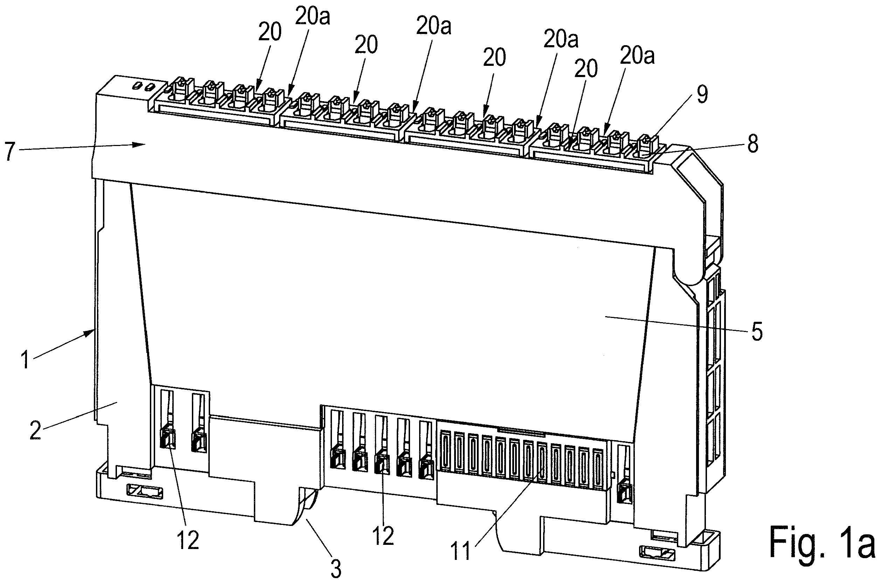

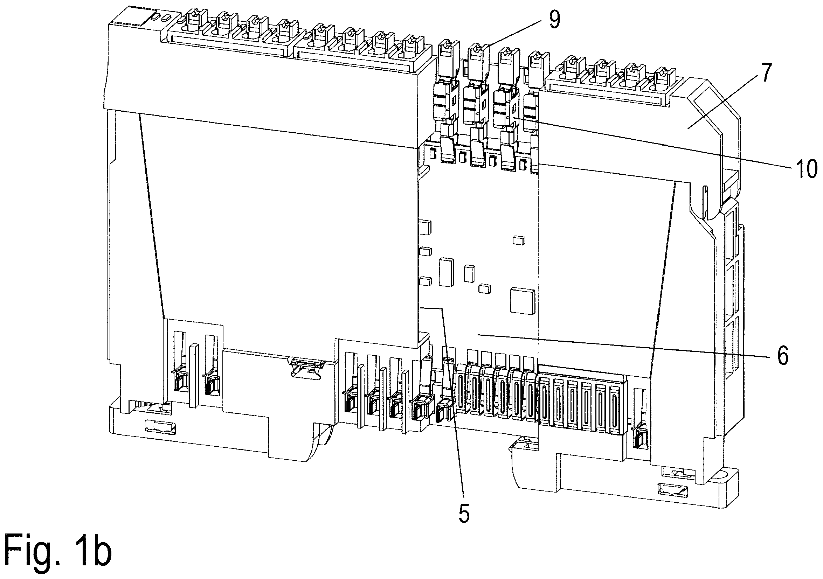

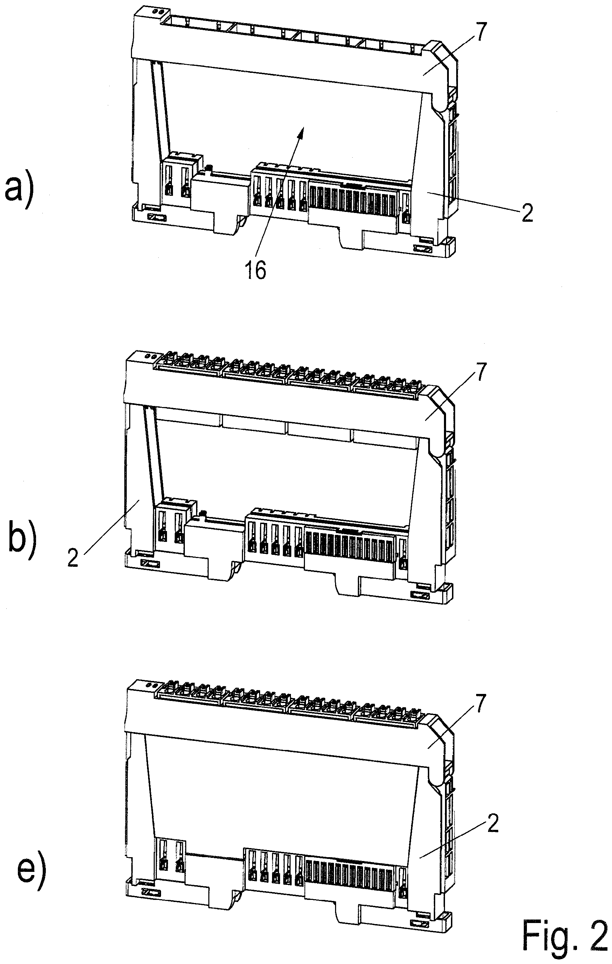

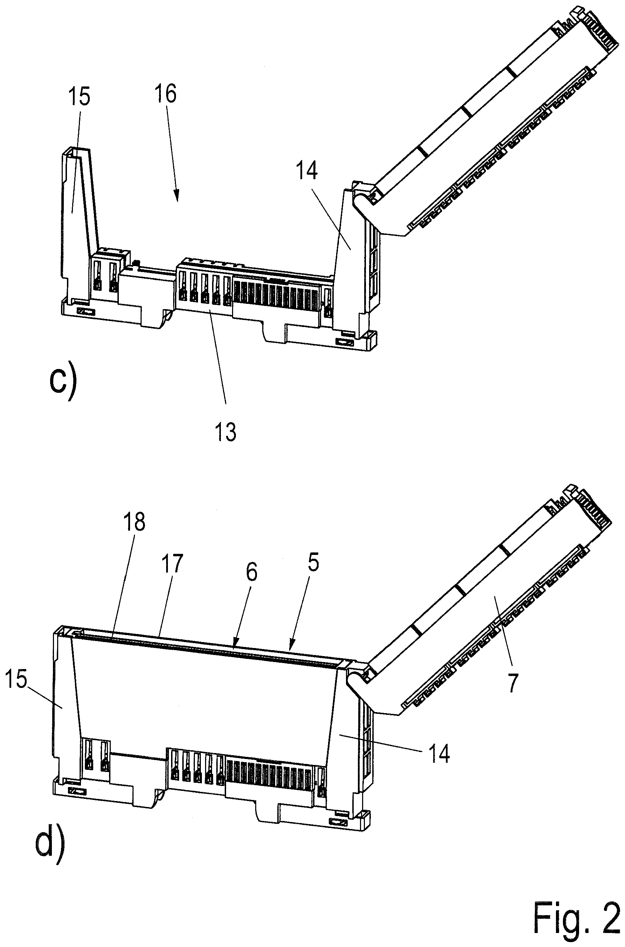

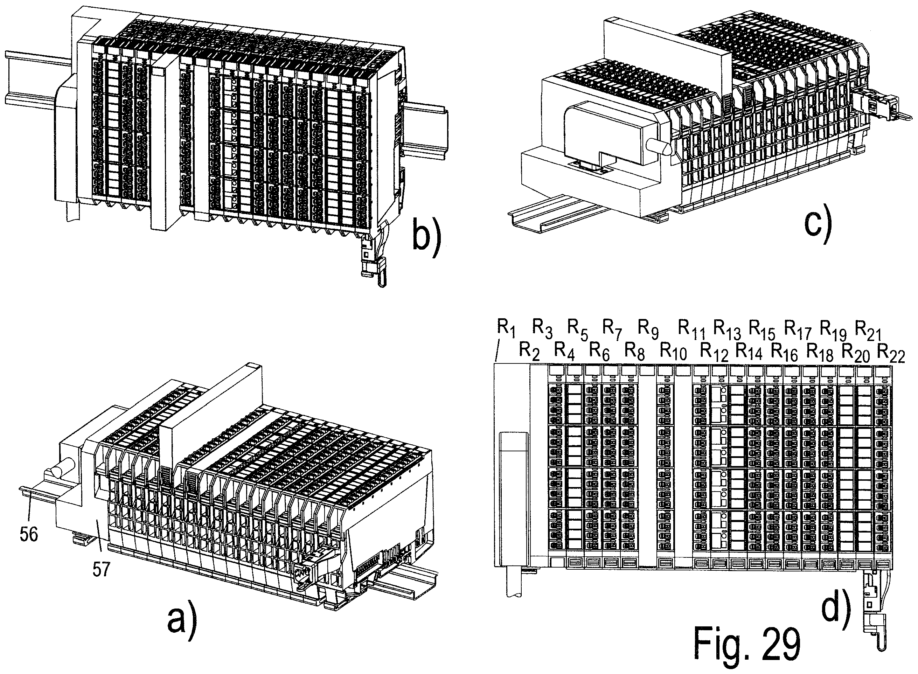

Fig. 1a, b und Fig. 2 a bis e zeigen vereinfachte Darstellungen von auf eine Tragschiene aufsetzbaren - insbesondere aufrastbaren - und auf der Tragschiene aneinander reihbaren elektrischen Anschluss- und/oder Funktionsmodulen 1, die beispielsweise als Teil von Steuerungssystemen der Automatisierungstechnik verwendet werden können, wo sie an ein Gateway angereiht werden (siehe hierzu Fig. 29).

(Applikationsspezifische) Kombinationen aus Gateway und/oder Anschluss- und/oder Funktionsmodulen ermöglichen die Überwachung und/oder Steuerung externer elektrischer Geräte (Feldgeräte, Initiatoren, Aktoren usw.), welche an die Anschluss- und/oder Funktionsmodule 1 des erfindungsgemäßen Anschlusssystems anschließbar sind.

Nachfolgend sei zunächst der Aufbau verschiedener Anschluss- und/oder Funktionsmodule erläutert, bevor an Beispielen deutlich gemacht wird, wie es möglich ist, mit diesen Anschluss- und/oder Funktionsmodulen ein besonders vorteilhaftes, leicht für verschiedenste komplexe Aufgabe der Fabrik- oder Gebäudeautomatisierung nutzbares Anschlusssystem zu bilden.

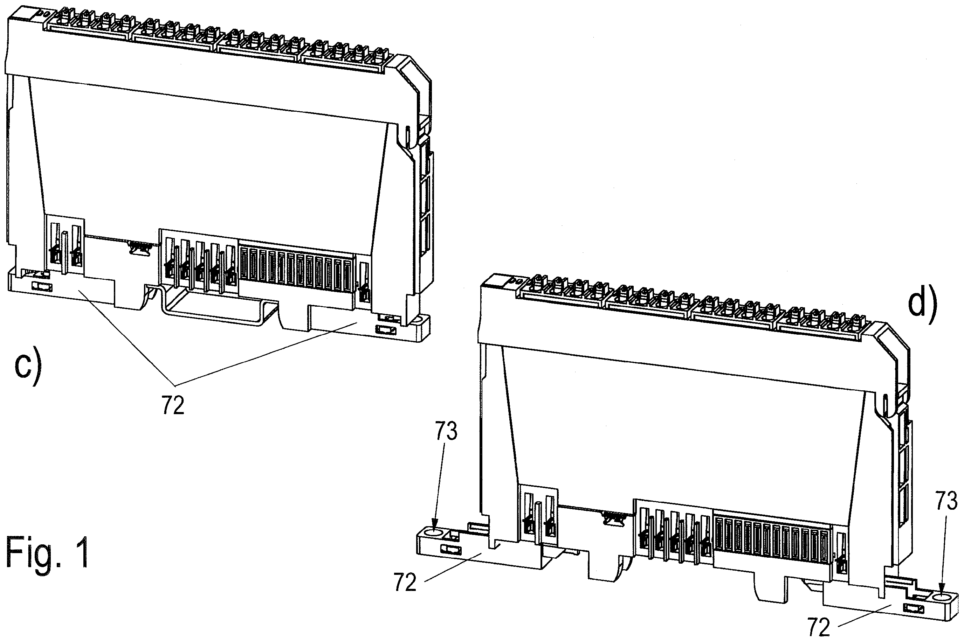

Das in Fig. 1 und 2 dargestellte Anschluss- und Funktionsmodul 1 weist einen Basisklemmenträger 2 auf, der mit Fixiermitteln, hier mit Rastmitteln 3, 4, zum Aufrasten auf eine Tragschiene (hier nicht dargestellt) versehen ist.

Auf eine derartige Ausgestaltung ist die Erfindung aber nicht beschränkt. Sie eignet sich weiter auch für anreihbare Anschluss- und/oder Funktionsmodule 1, welche auf einer anderen Montagebasis als einer Tragschiene, beispielsweise eine Wand oder dgl. montierbar sind. Zur Realisierung dieser Funktionalität ist es denkbar, nach Art der Fig. 1c und 1d Verrastungsschieber 72 von Hand oder mit einem Werkzeug in eine Offenstellung zu bringen, wobei die Verrastungsschieber Öffnungen 73 für Schrauben oder dgl. aufweisen und die Verrastungsschieber bzw. in diesem Zustand allgemeiner "Befestigungsschieber" an diesen Öffnungen auf einer Montagebasis festzuschrauben.

Auf den Basisklemmenträger 2 ist ein Elektronikgehäuse 5 (Fig. 1a) mit wenigstens einer oder mehreren Leiterplatte(n) 6 (Fig. 1b und 2d) aufgesetzt bzw. aufsetzbar, die wiederum mit elektrischen Bauelementen bestückt sein kann/können.

Auf den Basisklemmenträger 2 und das Elektronikgehäuse 5 ist wiederum eine Anschluss- und/oder Funktionseinheit 7 - hier mit einer Reihe von Anschlussvorrichtungen bzw. Anschlüssen zum Anschluss externer Leiter (in Fig. 1a nicht dargestellt) aufgesetzt (siehe aber Fig. 1b, Bezugszeichen 10).

Diese Anschlussvorrichtungen 10 sind vorzugsweise - aber nicht zwingend - als Anschlüsse in Direktstecktechnik (Push-In) ausgelegt, die werkzeugfrei rein durch Einstecken eines Leiters in einen Klemmstellenbereich des Anschlusses kontaktierbar sind.

Im kontaktierten Zustand klemmt dabei ein Klemmschenkel des Push-In-Anschlusses den Leiter in einem Klemmkäfig gegen eine Stromschiene. Je Push-In-Anschluss dient je ein Betätigungselement 9 zum Öffnen der Klemmstelle, welche unterhalb einer Öffnung 8 eines Gehäuses eines Anschlussbausteins 20 der Anschluss- und/oder Funktionseinheit 7 liegt.

Da nach Fig. 1 lediglich eine einzige Reihe der Anschlussvorrichtungen 10 (unter den Öffnungen 8 bzw. hier zu erkennen durch die Betätigungselemente 9, siehe auch Fig. 1b) vorgesehen ist, kann ein Anschluss- und/oder Funktionsmodul 1 mit einem in Anreihrichtung besonders schmalen Aufbau kostengünstig realisiert werden.

Die Erfindung ist hierauf aber nicht beschränkt. Sie eignet sich auch für Anschluss- und/oder Funktionseinheiten mit mehreren Reihen von Anschlussvorrichtungen.

Die Anschlussvorrichtungen 10 können nicht nur als Push-In-Anschlüsse sondern insbesondere auch als IDC-Anschlüsse, Zugfederanschlüsse oder Schraubanschlüsse ausgebildet sein.

Zudem kann die wenigstens eine Anschlußvorrichtung auch als wenigstens eine Steckverbindervorrichtung bzw. ein Steckverbinder ausgelegt sein, an welche eine korrespondierende Steckverbindervorrichtung bzw. ein Steckverbinder angekuppelt werden kann.

Sowohl der Basisklemmenträger 2 als auch das Elektronikgehäuse 5 als auch die Anschluss- und/oder Funktionseinheit weisen einen scheibenartigen Aufbau auf und sind senkrecht zur Ebene der Fig. 2a aneinander anreihbar.

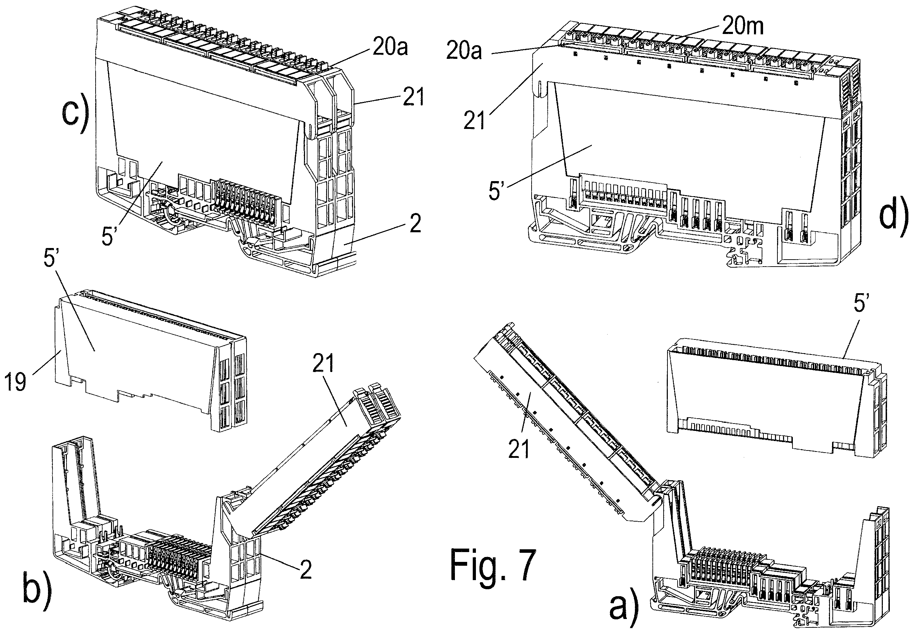

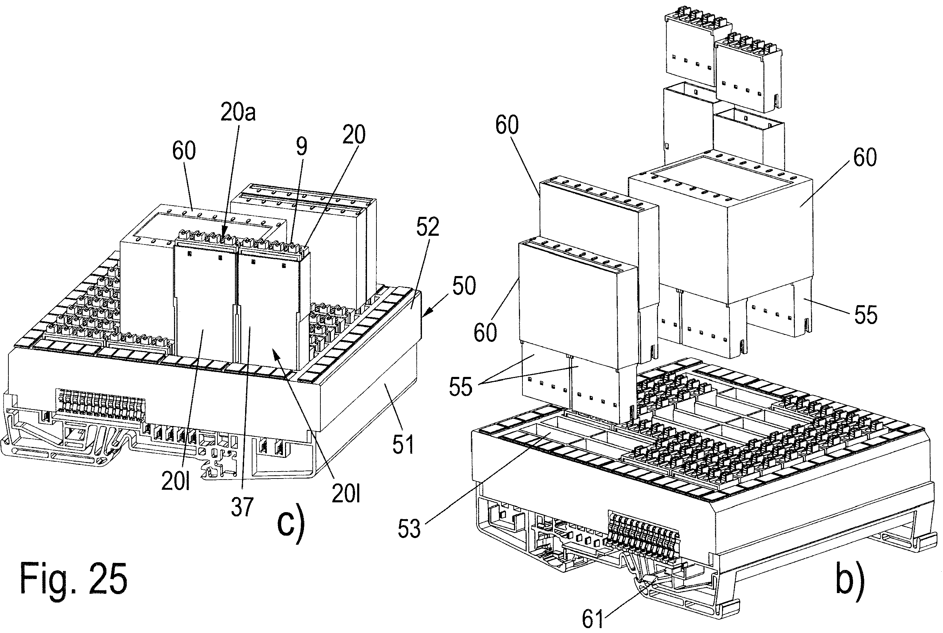

Hierzu sind sie vorzugsweise miteinander koppelbar, beispielsweise mit Rasthaken 61 (siehe beispielsweise Fig. 7b oder Fig. 25b) oder mit Nuten-/Federsystemen, die im zusammengesetzten Zustand ineinander greifen. Nach den beiliegenden Figuren weisen einige der Module Rasthaken auf, andere nicht. Dieses dient zur Veranschaulichung verschiedenen Optionen. Innerhalb eines Anschlusssystems sind die aneinander reihbaren Seiten der Module vorzugsweise miteinander koppelbar, insbesondere im Bereich der Basisklemmenträger, so dass ein stabiler Verbund entsteht.

Neben den Anschlussvorrichtungen 10-z.B. Push-In-Anschlüssen - der Anschluss- und/oder Funktionseinheit 7 zum Anschluss externer Leiter von Feldgeräten wie Aktoren, Sensoren und dgl. weist jedes Anschluss- und/oder Funktionsmodul nach Fig. 1 oder 2 vorzugsweise mehrere Bus-Kontaktelemente 11 einer ersten Bauart zur Realisierung eines über mehrere Anschluss- und/oder Funktionsmodule in Anreihrichtung X verlaufenden ersten internen Busses (hier zur Datenübertragung) und mehrere Bus-Kontaktelemente 12 einer zweiten Bauart zur Realisierung eines über mehrere Anschluss- und/oder Funktionsmodule in Anreihrichtung X hinweg verlaufenden zweiten internen Busses (hier zur Energieübertragung) auf.

Hierzu sind die Bus-Kontaktelemente 11, 12 derart ausgebildet, dass an jedem der Anschluss- und/oder Funktionsmodule 1 jeweils an jeder der beiden Seitenflächen in Hauptanreihrichtung korrespondierende, im angereihten Zustand zusammenwirkende Funktionsbereiche wie korrespondierende Buchsen oder Stecker (Gabel/Messer) oder Druckkontaktbereiche ausgebildet sind.

Die Bus-Kontaktelemente 11, 12 sind vorzugsweise über eine leitende Verbindung wie Leiterplattenrandverbinder oder Steckverbinder mit der Elektronikleiterplatte 6 verbunden. Diese ist in den meisten Fällen mit einer Elektronik verbunden, die auch mit den Anschlussvorrichtungen bzw. Leiteranschlüssen - der Anschlussebene - verbunden ist, an beispielsweise Feldgeräte wie Sensoren, Aktoren, Initiatoren oder dgl. anschließbar sind.

Der erste interne Bus - Bus- Kontaktelemente 11 - wird vorzugsweise dazu genutzt, Energie zu übertragen, um beispielsweise an die Anschlussvorrichtungen 10 angeschlossene Feldgeräte mit Energie zu versorgen. Der zweite interne Bus - Buskontaktelemente 12 - dient vorzugsweise zur Übertragung von Daten und ggf. zur internen Energieversorgung der Anschluss- und/oder Funktionsmodule.

Die Bus-Kontaktelemente 11, 12 können beispielsweise Druckkontakte oder Gabel-/Messerkontakte sein. Sie können noch einen dritten Kontakt (nach oben) zur Kontaktierung der Leiterplatte 6 aufweisen.

Besonders vorteilhaft ist, dass die Basisklemmenträger 2 in einer Seitenansicht in Anreihrichtung - siehe beispielsweise Fig. 1a und Fig. 2a. eine Art U-Form aufweisen mit einem Grundschenkel 13, an welchem die Montagemittel - Rastmittel 3, 4 - zur Montage an der Tragschiene ausgebildet sind und der die Tragschiene vorzugsweise zu beiden Seiten senkrecht zur Anreihrichtung übergreift. Dabei sind an die voneinander abgewandten Enden des Grundschenkels 13 zur von der Tragschiene abgewandten Seite hin zwei senkrechte Seitenschenkel 14, 15 angeformt, so dass zwischen dem Grundschenkel und den Seitenschenkeln ein Aufnahmeraum 16 ausgebildet wird (siehe hierzu Fig. 2a).

Dieser Aufnahmeraum 16 kann beispielsweise rechtwinklig ausgebildet sein. Vorzugsweise ist er trapezförmig, da die Seitenschenkel 14, 15 an ihren zueinander weisenden Seiten winklig zueinander ausgerichtet sind, was das Einsetzen der Elektronik erleichtert und die Stabilität der Anordnung optimiert.

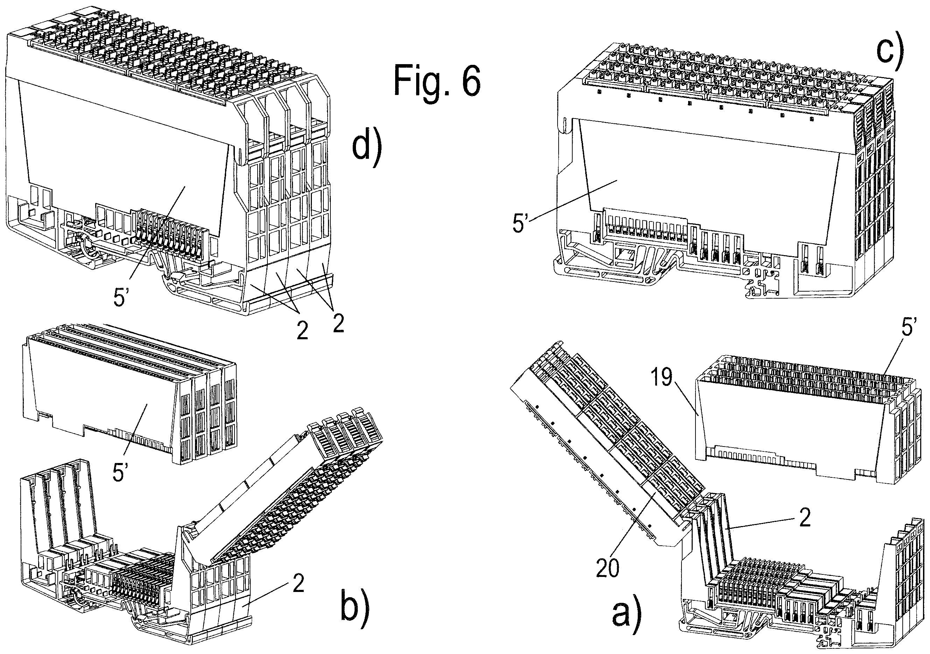

In den Aufnahmeraum 16 ist das Elektronikgehäuse 5 einsetzbar, welches eine an die Geometrie des Aufnahmeraums 16 angepasste Geometrie aufweist. Vorzugsweise sind die Ränder 19 (siehe hierzu beispielhaft das blockartige Elektronikgehäuses 5' der Fig. 6a) abschnittsweise derart ausgestaltet, dass sie zwischen Abschnitte einer Rückwand 17 und einer Frontwand 18 der Seitenschenkel 14, 15 (Fig. 2) des Basisklemmenträgers 2 geschoben werden können.

In das Elektronikgehäuse 5 ist vorzugsweise die Leiterplatte 6 eingesetzt, welche beim Aufsetzen auf den Basisklemmenträger 2 dessen Kontakte kontaktiert, beispielsweise dadurch, dass ihre Randbereiche mit Kontaktbereichen in entsprechende Kontaktbereiche im Basisklemmenträger 2 eingreifen.

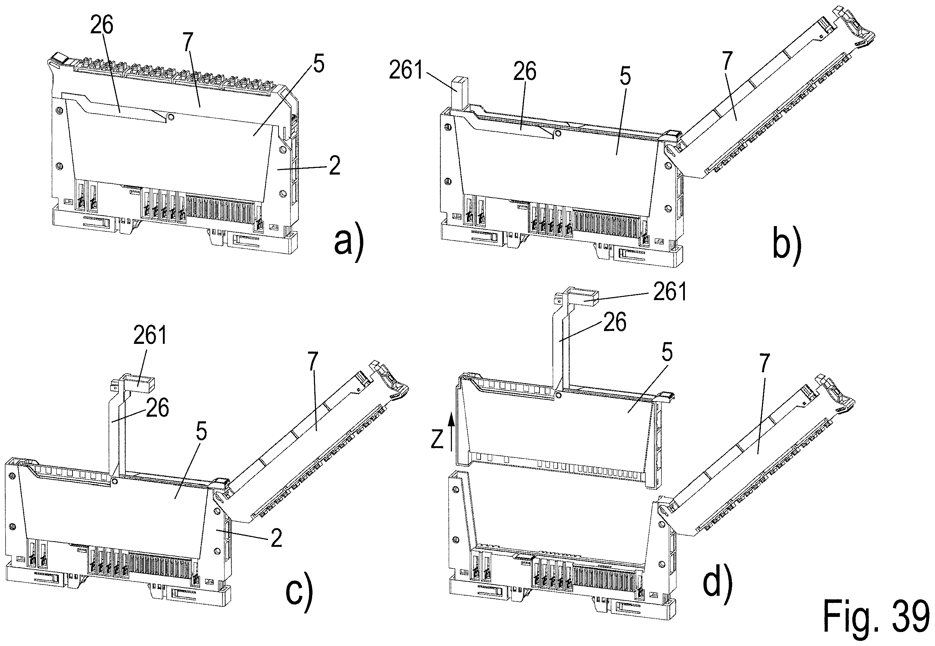

Die Fig. 39a-d veranschaulichen, dass es mit Hilfe einer Handhabungsvorrichtung wie einem Schwenkbügel 26 auf einfache Weise möglich ist, das Elektronikgehäuse nebst Leiterplatte aus dem Basisklemmenträger 2 herauszunehmen. Der gezeigte Schwenkbügel 26 weist einen Griff 261 auf. In einer bevorzugten Ausführungsform ist am Schwenkbügel 26, insbesondere am Griff 261, außerdem ein Anzeigemittel (hier nicht gezeigt), beispielsweise eine LED, vorgesehen, die als Statusanzeige dient. Das Anzeigemittel ist bevorzugt so angeordnet, dass es in der Verschlussstellung der Anschluss- und Funktionseinheit 7 sichtbar ist.

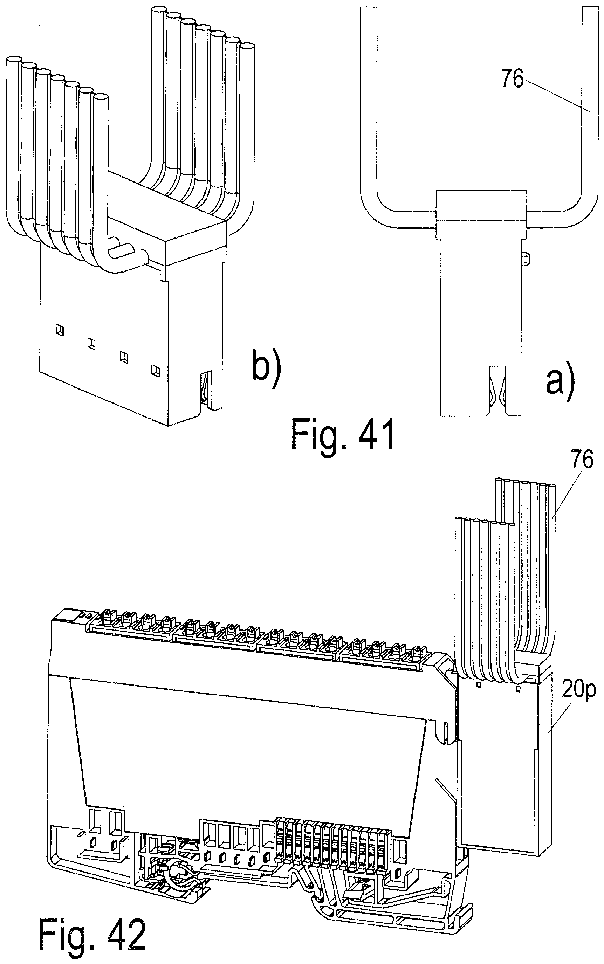

Vorzugsweise ist der Schwenkbügel 26 an dem Elektronikgehäuse 5 schwenkbar angebracht. Der Schwenkbügel 26 ist vorzugsweise in eine Handhabungsstellung (Fig. 41c und d) schwenkbar, welche es ermöglicht, das Elektronikgehäuse in Z-Richtung senkrecht zur Tragschiene vom Basisklemmenträger 2 abzuziehen, und in eine Nichtgebrauchsstellung (Fig. 41a, b) beispielsweise unterhalb der abnehmbaren und/oder ebenfalls schwenkbaren Anschlusseinheit.

Es ist auch denkbar, dass anstelle wenigstens einer Leiterplatte eine oder mehrere flachliegende, ggf. auch teilweise kunststoffumspritzte Stromschiene(n) oder Stanzgitter - anstelle der Leiterplatte eingesetzt wird/werden. An die wenigstens eine Stromschiene könnten dann bedrahtete elektrische oder elektronische Bauelemente - z.B. Relais, Dioden, Widerstände, ... - angelötet sein.

Es ist vorteilhaft, dass die Seitenschenkel 14, 15 des Basisklemmenträgers das Elektronikgehäuse 5 und die wenigstens eine Elektronikleiterplatte 6 zusätzlich schützend seitlich einfassen.

Nachfolgend sei nunmehr näher der Aufbau der Anschluss- und/oder Funktionseinheit 7 betrachtet.

Die Anschluss- und/oder Funktionseinheit 7 weist nach einer besonders bevorzugten Variante, die auch als selbstständige Erfindung betrachtet werden, einen Aufbau mit oder aus mehreren einzelnen Funktionsbausteinen 20 auf.

Nach Fig. 1 sind sämtliche dieser Funktionsbausteine 20 als Anschlussbausteine 20a ausgebildet, welche jeweils vier der bereits erörterten Anschlussvorrichtungen 10 für Leiter aufweisen (siehe die Betätigungselemente 9).

Nach Fig. 1 sind damit beispielsweise 16 Leiter an die Anschluss- und/oder Funktionseinheit 7 anschließbar.

Es ist aber auch denkbar, je Anschlussbaustein 20a nur einen oder mehr als zwei Anschlüsse für Leiter oder Kabel vorzusehen (z.B. einen Flachkabelstecker nach Art eines Funktionsbausteins 20.

Es ist z.B. derart auch denkbar, eine oder mehrere der Anschlusseinheiten 7 zum Anschluss einer Steckvorrichtung als Funktionsbaustein vorzusehen bzw. auszulegen.

Zudem kann der Funktionsbaustein 20 auch andere Funktionen übernehmen. Er kann beispielsweise zum Markieren genutzt werden oder an entsprechenden Anschlüssen zum Einstecken von Quer- oder Vertikalverbindern. Er kann aber auch derart erweitert werden, dass beispielsweise in ihn eine aktive Elektronikschaltung oder passive Bauelemente integriert werden.

Nach Fig.1 sind vier der Funktionsbausteine 20 zu einer einzigen Anschluss- und/oder Funktionseinheit 7 zusammengefasst. Dieses Zusammenfassen wird durch ein Halteelement realisiert, welches zur Aufnahme der Funktionsbausteine 20 ausgelegt ist.

Besonders vorteilhaft ist eine Auslegung des Halteelementes als Rahmen 21, welcher einfach zu fertigen und zu handhaben ist. Alternativ ist auch eine Schiene bevorzugt, an die die Funktionsbausteine 20 anordbar sind, insbesondere verrastbar oder anclippbar.

Der Rahmen 21 ist vorzugsweise abnehmbar an dem Basisklemmenträger 2 oder einem sonstigen Teil, das mit diesem verbunden ist, angeordnet.

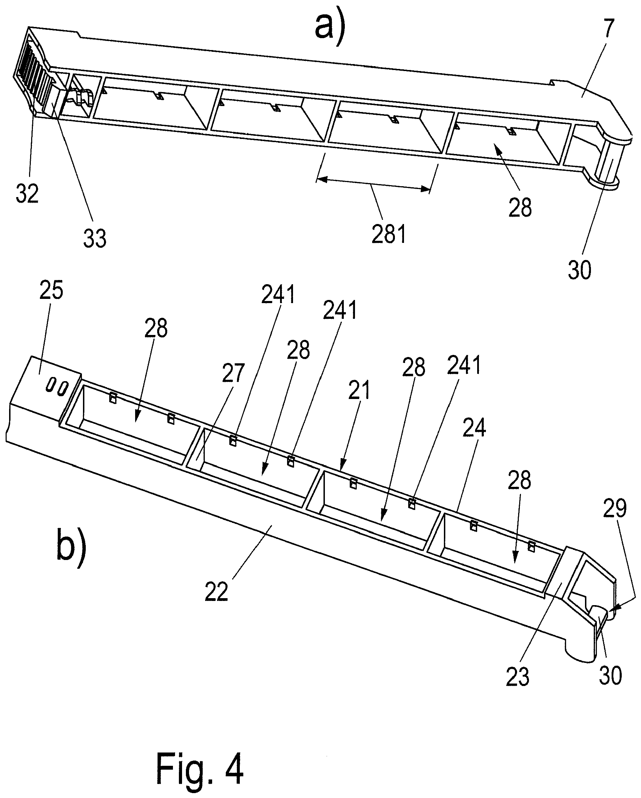

Der Rahmen 21 - siehe hierzu auch Fig. 4 - weist vorzugsweise umlaufende Seitenwände 22 bis 25 auf, und ist weiter vorzugsweise durch Trennwände 27 in Aufnahmekammern bzw. Steckplätze 28 unterteilt, welche zur vorzugsweise rastenden Aufnahme der Funktionsbausteine ausgelegt sind.

Die Unterteilung in Steckplätze 28 gleichen Aufnahmerasters, hier gebildet durch Kammern im Rahmen 21, wirkt sich vorteilhaft auf die Stabilität der Anordnung aus. Es lässt sich auf einfache Weise eine Anschluss- und/oder Funktionseinheit 7 erstellen, die sehr stabil ist.

Rastelemente 221, 241 (s. Fig. 43) am Rahmen und Rastgegenelemente 221 (s. Fig. 43) an den Funktionsbausteinen 20 tragen vorzugsweise dazu bei, einen guten Sitz der Rastgegenelemente 221, und somit der Funktionsbausteine 20, in den Steckplätzen 28 zu gewährleisten.

Es ist sowohl bevorzugt, dass der Rahmen 21 lediglich eine Reihe der Steckplätze 28 senkrecht zur Anreihrichtung aufweist, als auch, dass der Rahmen 21 mehrere Reihen der Steckplätze 28 senkrecht zur Anreihrichtung aufweist. Dabei sind die Steckplätze der Rahmen bevorzugt in einem vorgegeben matrixartigen Raster angeordnet sind. Weiterhin ist es bevorzugt, dass an dem Anschlusssystem Markierungen vorgesehen sind, mit welchen die Steckplätze identifizierbar gekennzeichnet sind.

Wenn die Funktionsbausteine 20 als Anschlussbausteine 20a ausgebildet sind, weisen sie wenigstens einen Anschluss für Leiter, vorzugsweise eine "Klemme" auf, der leitend vorzugsweise mit einem Leiterplattenrandverbinder verbunden ist, welcher zur Kontaktierung der Leiterplatte dient. Hier könnte alternativ auch ein Steckverbinder oder dgl. vorgesehen sein.

Es ist denkbar, den Rahmen derart auszubilden, dass er ein separates Element bildet - Fig. 4 - welches mit oder ohne eingesetzte Funktionsbausteine 20 - an den Basisklemmenträger 2 ansetzbar ist.

Die Anschluss- und/oder Funktionseinheit 7 - hier der Rahmen 21 mit Funktionsbausteinen 20 - ist vorzugsweise unabhängig von der Frage auf den Basisklemmenträger 2 aufsetzbar, ob auf den Basisklemmenträger 2 bereits das Elektronikgehäuse 5 aufgesetzt ist oder nicht.

So kann die Anschluss- und/oder Funktionseinheit 7 sogar vorverdrahtet werden und wird in dem Fall, dass die Elektronikeinheit bzw. das Elektronikgehäuse 5 mit der Leiterplatte 6 montiert oder ausgetauscht werden muss, einfach nur geöffnet.

Dieses Öffnen - und ein entsprechendes Schließen - kann auf verschiedene Weise realisiert werden.

Nach einer Variante ist die Anschluss- und/oder Funktionseinheit 7 beweglich, insbesondere schwenkbar, an dem Basisklemmenträger 2 gelagert.

So ist die Anschluss- und/oder Funktionseinheit 7 zum Realisieren der Schwenkbarkeit der Anschluss- und/oder Funktionseinheit 7 an dem Basisklemmenträger 2 nach Fig. 1 bis 6 mit einem der Seitenschenkel 14 über ein Schwenklager 29 verbunden.

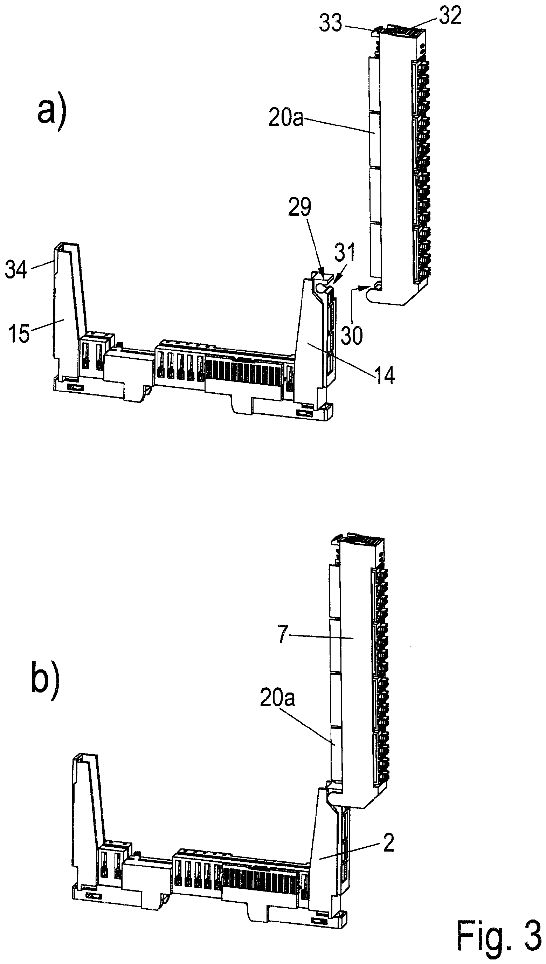

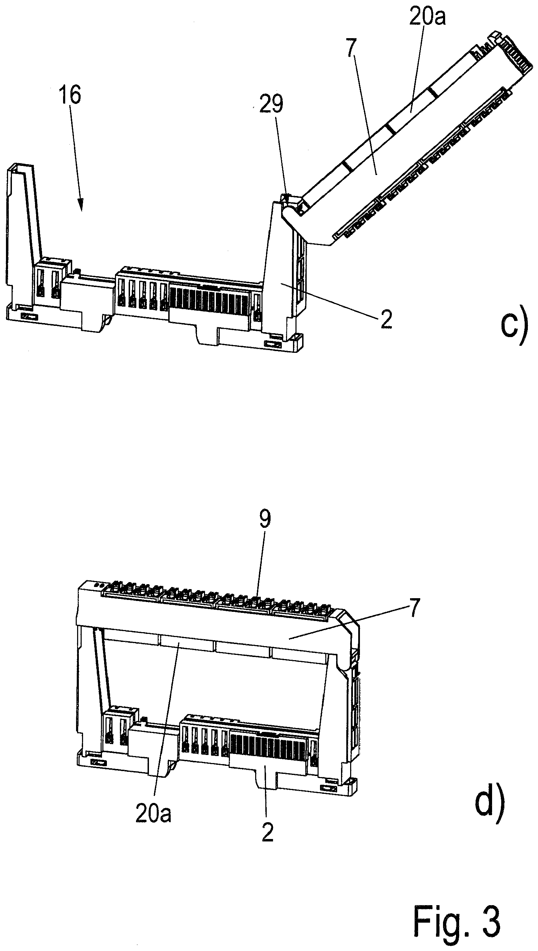

Hier weist das Schwenklager 29 eine Achse/Zapfen 30 an dem Rahmen 21 der Anschluss- und/oder Funktionseinheit 7 und einen Aufnahmeraum 31 als Lagerauge in dem einen Seitenschenkel 14 des Basisklemmenträgers 2 auf (siehe Fig. 3 und 4). Der Aufnahmeraum 31 ist seitlich offen und derart bemessen, dass die beispielsweise abgeflachte Achse 30 in ihn einsteckbar und wieder aus ihm herausnehmbar ist (siehe insbesondere die Fig. 3).

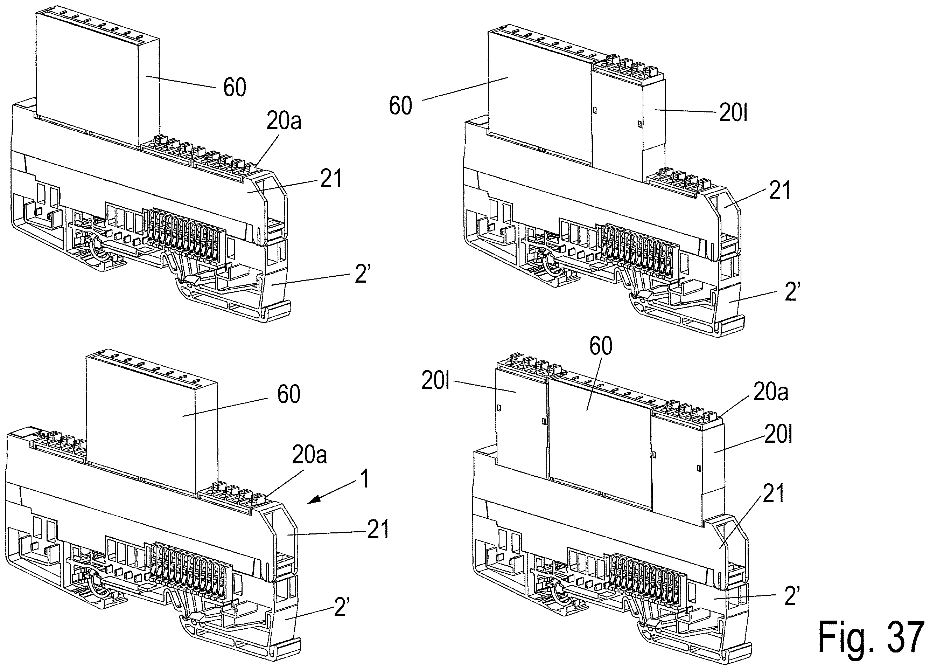

Eine analoge Anbringung des Rahmens 21 an einem flacher ausgestalteten Basisklemmenträger 2' ohne die Seitenschenkel und dann auch vorzugsweise ohne ein aufsetzbares Elektronikgehäuse zeigt Fig. 37. Fig. 37 offenbart insofern ein flach bauendes scheibenartiges Anschluss- und/oder Funktionsmodul 1, dass aber mit den "höher" bauenden Modulen der Fig. 3 koppelbar ist.

Zum Lösen kann vorzugsweise im Bereich des anderen Seitenschenkels 15 (Fig. 3) oder an einem sonstigen Teil des Basisklemmenträgers 2' (siehe Fig. 37) ein lösbarer Verschluss ausgebildet sein.

Dieser Verschluss wird hier durch eine beispielsweise durch Fingerdruck oder dgl. betätigbare Rasttaste 32 mit Rasthaken 33 und eine Rastausnehmung 34 im Seitenschenkel 15 gebildet (Fig. 3a und 4). Vorzugsweise erstreckt sich der Rahmen - wie in Fig. 1 ersichtlich - senkrecht zur Tragschiene über die gesamte Erstreckung des Basisklemmenträgers senkrecht zur Tragschiene und übergreift derart das Elektronikgehäuse 5 und den Basisklemmenträger 2 vorzugsweise vollständig.

Derart kann mit der Anschluss- und/oder Funktionseinheit 7- hier mit den Funktionsbausteinen 20 und dem Rahmen 21 - eine sogenannte stehende Verdrahtung erzeugt werden; dies bedeutet, dass ein Anschluss- und/oder Funktionsmodul 7 ohne gesteckte Elektronik mit Einzeladern oder SA-Steckern 20d verdrahtet werden kann und dass ein Elektronikgehäuse bzw. ein Elektronikmodul 5 ausgetauscht werden kann, ohne die Adern aus den Anschlüssen lösen zu müssen. Deutlich wird dies insbesondere aus Fig. 1, 2 und 3.

Wie dargestellt kann der Anschluss-Funktionsbaustein auch durch einen oder mehrere, insbesondere zwei, Steckverbinder, insbesondere Sensor-Aktorstecker 20d gebildet werden.

Der Rahmen 21 oder dgl. kann alternativ auch direkt in das Elektronikgehäuse integriert werden. In diesem Fall befinden sich die Steckplätze direkt in der Gehäusewand bzw. im Gehäusedeckel der Elektronik; dann jedoch muss die Elektronik zur Verdrahtung gesteckt sein (nicht dargestellt).

Vorzugsweise weist der Rahmen 21 eine Anzahl n von 1, 2, 4, 8, 16, 32, ... Steckplätzen 28 auf.

Vorteilhaft daran ist, dass ein einziger der Rahmen 21 mehrere Steckelemente in Form von Funktionsbausteinen 20 aufnehmen kann, wobei die Steckplätze 28 weiter bevorzugt vorteilhaft nach Art einer Matrix in einem festen Raster angeordnet sind, was die Zuordnung und Markierung der Funktionsbausteine 20 und ggf. von deren Teilen wie Anschlussvorrichtungen 10 für Leiter erleichtert.

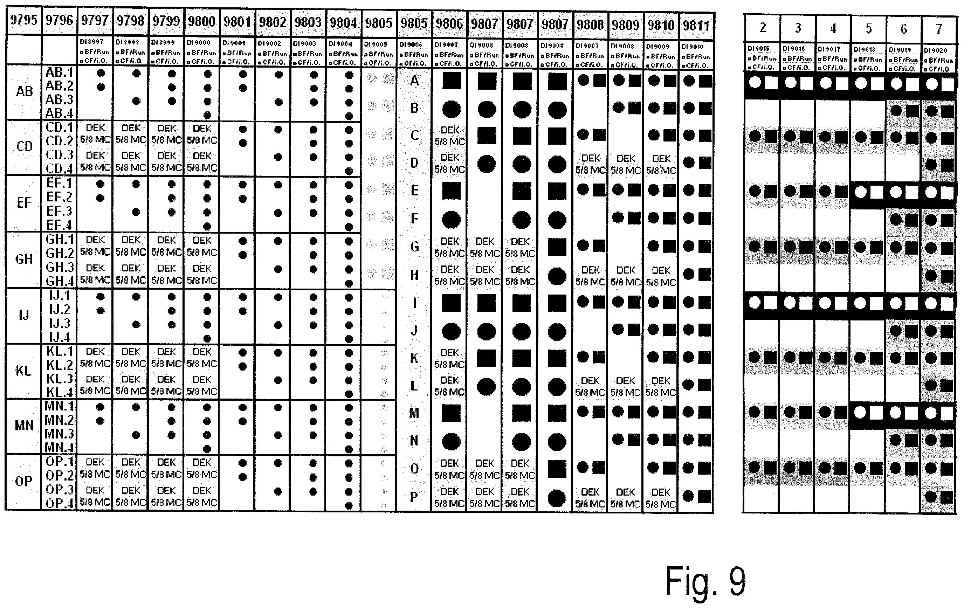

Dies erschließt sich insbesondere aus Fig. 9, welche nach Art einer schematischen Darstellung veranschaulicht, welch klare matrixartige Zuordnung von Anschlüssen, Markierungen und Funktionen das erfindungsgemäße Anschlusssystem realisiert.

Dabei weist jede Spalte von Anschlüssen eine Nummer bzw. ein Betriebsmittelkennzeichen auf (hier 9795, 9796 usw.) und jede Reihe eine Buchstaben- oder Buchstaben-/Zahlenbezeichnung (AB, CD, AB1, usw....).

Als besonders vorteilhaft erscheint als Anzahl bzw. Zusammenstellung der Steckplätze bzw. Anschlüsse am Rahmen eine Potenz der Zahl 4, also 4, 8, 16, 32, ... Anschlüsse.

In Verbindung mit der entsprechenden Leitertechnik (1L, 2L, 4L) ergibt sich ein übersichtlicher sowie datenverarbeitungsgerechter Aufbau (Byte- / wortweise). Darüber hinaus kann vorteilhaft eine Symmetrie des Moduls mit einheitlicher Klemmenlänge und hoher Übersichtlichkeit gewährleistet werden.

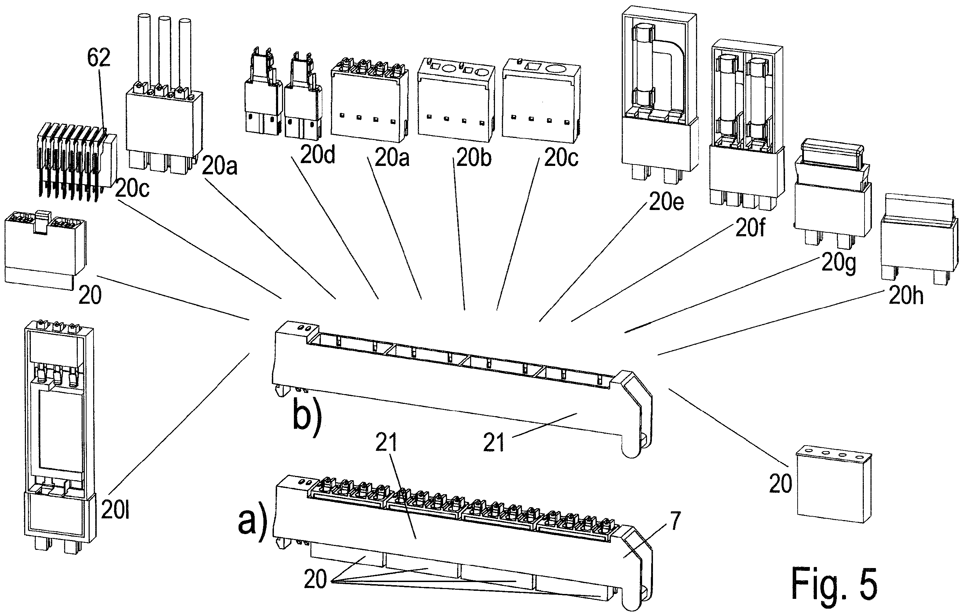

Es ist auch denkbar, dass ein Rahmensteckplatz bzw. eine Kammer bzw. ein Steckplatz 28 wiederum mehrere Funktionsbausteine 20 als Steckelemente aufnimmt; z.B. 2 SA-Stecker 20d (Fig. 5) im 11,25mm Raster in einem 22,5mm großen Steckplatz 28.

Ein Steckelement/Funktionsbaustein 20 kann andererseits auch mehrere Steckplätze übergreifen; z.B. eine 45mm lange Elektronik mehrere, beispielsweise 2 x 22,5mm-Steckplätze 28.

Eine nicht als abgeschlossen zu betrachtende beispielhafte Mehrzahl an Varianten verschiedener Funktionsbausteine 20 als in den Rahmen 21 einsteckbarer Steckelemente zeigt Fig. 5.

Vorzugsweise weisen die Funktionsbausteine 20 eine leitende Verbindung (elektrisch oder optisch) zur Elektronik-Leiterplatte 6 auf, die Elektronikschaltung aufweist, wobei die Leiterplatte wiederum vorzugsweise leitend mit dem Basisklemmenträger 2 verbunden ist, vorzugsweise mit den Buselementen 11 und/oder 12 an Buchsenkontakten oder Leiterplattenrandverbindern oder dgl..

Es sind reine Anschluss-Funktionsbausteine vorgesehen (20a, b, c), die zum Anschluss von Leitern dienen, welche sie mit der Elektronik 5 verbinden, wenn sie die Leiterplatte 6 kontaktieren) sowie Steckverbinder 20d, aber auch Elektronikfunktionsbausteine wie Sicherungsfunktionsbausteine (20e, f; ggf. auch 20g, h). Denkbar ist es auch, weitere Funktionalitäten zu realisieren. Zu erwähnen sind insofern Querverbinderfunktionsbausteine 20i, vorzugsweise mit steckbarer Querverbindung 62 zum benachbarten Anschlussmodul, und ein Funktionsbaustein mit aktiver Elektronik 20l.

In die Rahmen 21 bzw. deren Steckplätze 28 können damit verschiedenste Funktionsbaustein-Steckelemente eingesetzt werden, insbesondere einer oder mehrere folgender Funktionsbausteine mit beispielsweise folgender Funktionalität:
- Leiteranschlüsse für Power (große Querschnitte wie 1,5 - 6mm²) Funktionsbaustein 20a, b);
- Leiteranschlüsse für Signale (kleine Querschnitte wie 0,5 - 1,5mm²) (20a, d);
- Einsätze für Standard-Datenschnittstellen wie USB, Firewire, Klinkenbuchse, 8x0,5mm², RJ45 oder dergleichen);
- Teile von Reihenklemmen-Funktionalitäten wie TR, QV, SI, Prüfbuchsen, ...,
- I/O-Elektronik (schwerpunktmäßig in niedrigen Scheiben und Blöcken;
- Elektronikfunktionalitäten überwiegend der Signalanpassung (im Zwischenstecker auf insbesondere niedrigen Scheiben / Blöcken aufsteckbar).

Es ergeben sich dabei insbesondere folgende Vorteile:
- Einsetzbar sind unterschiedliche Anschlussquerschnitte;
- Einsetzbar unterschiedliche Anschlusstechniken (Hybridklemmen); Der Rahmen 21 ist aufsteckbar auf
- eine Leiterplatte oder ein Stanzgitter oder auf eine Kombination von Stanzgitter (unten oder unten/oben) und Leiterplatte (oben, mittig);
- eine Reihenklemme mit fest integrierter Elektronik oder aufsteckbarer Elektronik.

Optional sind auch realisierbar:
zusätzliche I/O-Kanäle (1 - 4 Zusatzkanäle) im Vorsatzstecker (22,5mm lang) unten ansteckbar (im Steckplatz nach unten;
   1 Kanal z.B. 1 x 4 x 1,5mm² für "S, -, +, FE"
   2 Kanäle z.B. 2 x 4 x 0,5mm² für "S, -, +, FE"
   4 Kanäle z.B. 2 x 4 x 0,5mm² für "S, -, +, FE"
das Aufrasten von 45mm langen I/O-Gehäusen hinten und / oder mittig auf einer niedrigen Scheibe oder einem niedrigen Block mit Rahmen oder Deckeln (z.B. L-Profil).

Fig. 6 zeigt eine Reihung aus vier Basisklemmenträgern 2 und vier Anschluss- und/oder Funktionseinheiten 7, welche - wie in Fig. 6 a und b zu erkennen - in eine Offenstellung verschwenkbar sind.

In den u-förmigen Aufnahmeraum 16 wird hier ein blockartiges Elektronikgehäuse 5' gesetzt, das sich hier ferner über sämtliche der vier Basisklemmenträger 2 erstreckt.

Damit wird die Montage weiter vereinfacht, wenn es die Funktionalität zulässt oder gar erfordert, ein einziges Elektronikgehäuse mit dann vorzugsweise auch nur einer Elektronikschaltung oder aber mehreren Leiterplatten oder dgl. für mehrere der Anschluss- und/oder Funktionsmodule 1 zu verwenden.

In die Rahmen 20β können auch hier je nach Applikationserfordernis unterschiedliche Funktionsbausteine 20 gesteckt sein.

Fig. 7 zeigt eine analoge Auslegung als blockartiges Elektronikgehäuse 5', das sich über zwei der Basisklemmenträger 2 erstreckt. Einer der Rahmen weist Anschlussbausteine 20a auf und einer der Rahmen Markiererbausteine 20m, welche das Anbringen einer Markierung oder eines Markierers mit einer Markierung/Beschriftung erlauben.

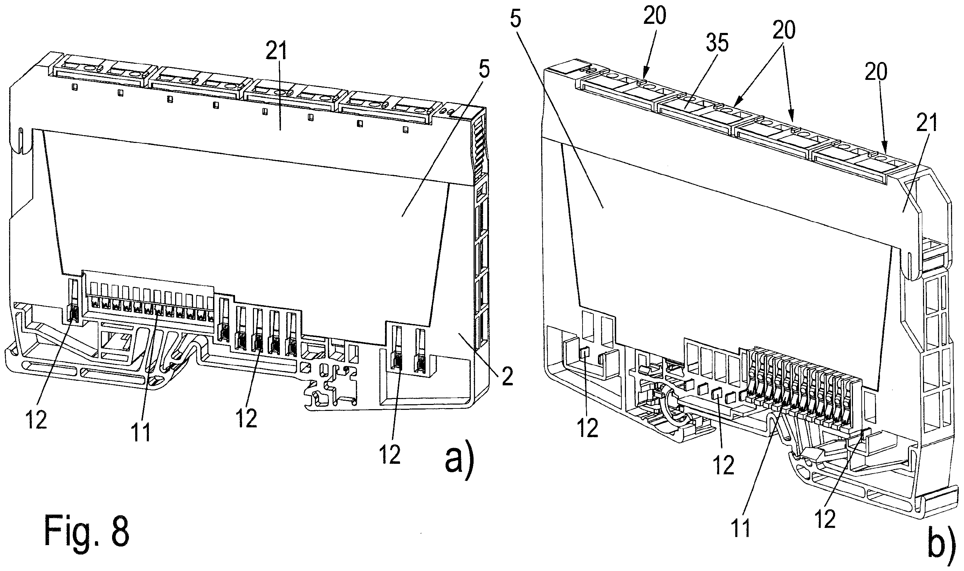

Fig. 8 zeigt ein Anschluss- und/oder Funktionsmodul, ausgebildet als " Einspeisescheibe" zur Einspeisung von Energie. Diese lässt sich einfach dadurch bilden, dass der Rahmen mit für die jeweilige Einspeiseaufgabe ausgelegten Funktionsbausteinen 20 versehen wird, die die jeweils geeignete vorzugsweise elektrische oder lichtleitende Anschlüsse aufweisen.

Nach Fig. 8 sind neben den Einzelanschlüssen mit den Öffnungen 8 für Leiter jeweils Markierflächen/-felder 35 ausgebildet, welche eine Markierung nach Art der Fig. 9 aufweisen können. Bei dieser gibt es vorzugsweise eine übergeordnete Bezeichnung nach Art einer Hauptmatrix sowie je Matrixfeld ggf. auch weitere Untermarkierungen, d.h., jeder durch eine Zeilennummer und eine Spaltennummer definierte Matrixplatz kann auch in weitere Unter- bzw. Teilplätze unterteilt sein, die definiert sind, so in weitere Unterspalten. Dies ermöglicht es in einfacher Weise, an einem Matrixplatz beispielsweise nur eine Anschlußvorrichtung 10 für einen Leiter (mit einem ersten Querschnitt) oder mehrere Anschlussvorrichtungen 10 für mehrere Leiter (z.B. mit relativ zum ersten Querschnitt geringerem Querschnitt) vorzusehen. Fig. 8 zeigt auch gut die korrespondierende Ausbildung der Messer- und Buchsenkontakte 12 an den beiden voneinander abgewandten Anreihseiten der Basisklemmenträger 2.

Es wäre alternativ auch denkbar, die Anschluss- und/oder Funktionseinheit 7 auf andere Weise lösbar an dem Basisklemmenträger 2 zu befestigen, so mittels Bajonettverschluss oder dgl. (hier nicht dargestellt).

Der Rahmen 21 kann aus Kunststoff bestehen, denkbar ist aber auch eine Auslegung aus Metall, um ggf. eine Schirmfunktion zu realisieren.

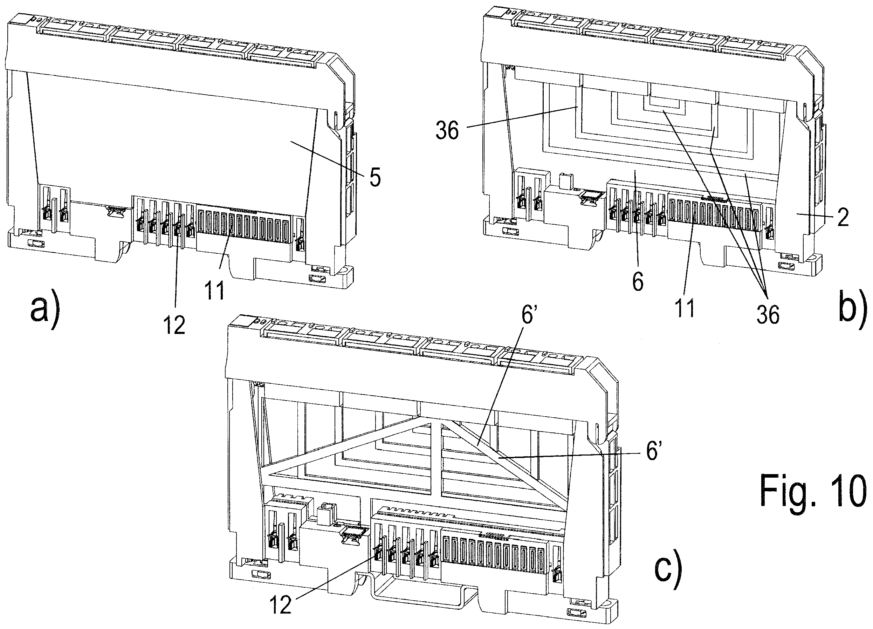

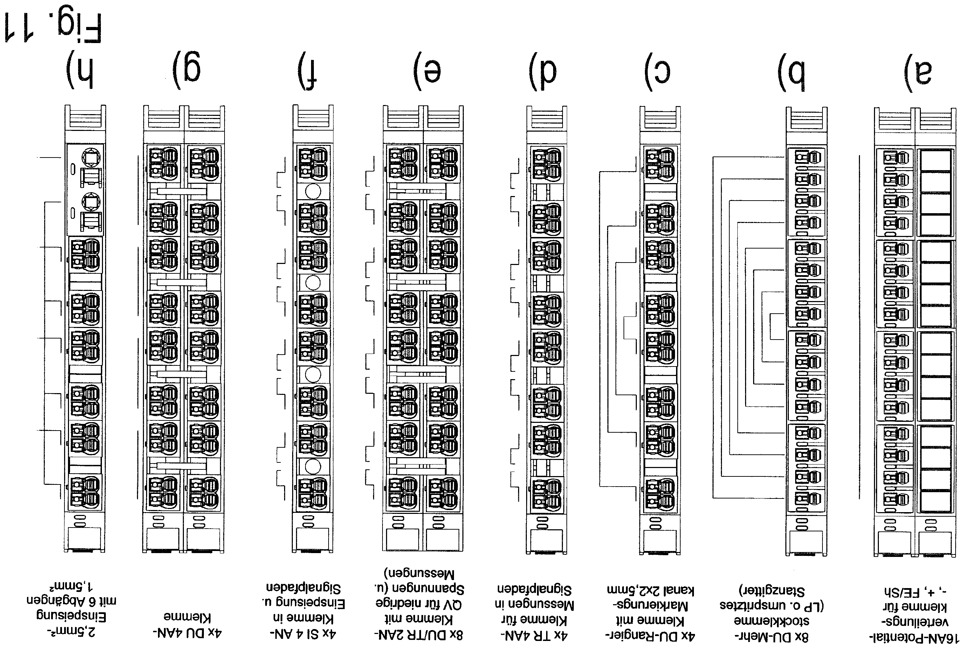

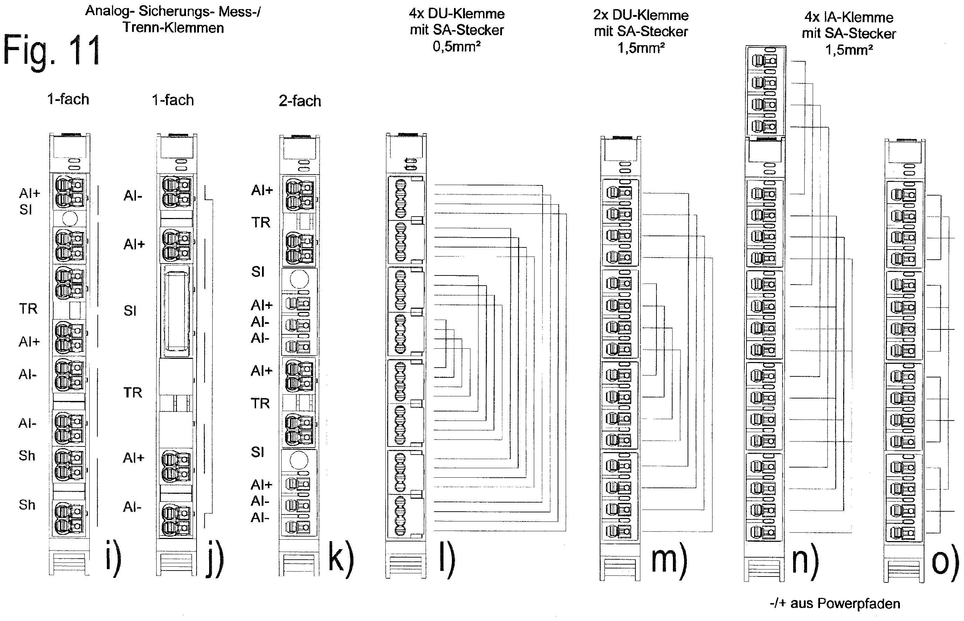

Die Fig. 10 und 11 veranschaulichen, dass es auf einfache Weise realisierbar ist, in das Anschlusssystem eines oder mehrere Anschluss- und/oder Funktionsmodule zu integrieren, die neben der Aufgabe der Busweiterleitung des wenigstens einen Busses oder der mehreren Busse mit den Bus-Kontaktelementen 11, 12 ganz andere Aufgabe übernehmen, die bisher nicht mit Hilfe ein- und desselben Anschlusssystems verwirklicht werden konnten.

So werden nach Fig. 10 und 11 Anschluss- und/oder Funktionsmodule 1 realisiert, welche neben der Busweiterleitung mit den Bus-Kontaktelementen 11, 12 eine Reihenklemmenfunktionalität aufweisen, vorzugsweise eine passive Reihenfunktionalität.

Der Basisklemmenträger 2 und die Anschluss- und/oder Funktionseinheit 7 werden hierzu nicht geändert. Sie werden entsprechend konfiguriert, so wird der Rahmen mit geeigneten Anschlussbausteinen als Funktionsbausteinen versehen. Es ist lediglich notwendig, in das Elektronikgehäuse 5 beispielsweise eine Leiterplatte 6 einzusetzen oder ein Stanzgitter 6' oder Stromschienen, wobei die Leiterplatte Leiterbahnen aufweist bzw. ausbildet, welche der gewünschten Reihenklemmenfunktionalität entsprechend einen oder mehrere der Leiteranschlüsse bzw. Anschlussvorrichtungen 10 untereinander leitend verbindet, nicht aber direkt oder über eine Elektronik eine Verbindung zu einem der Buskontaktelemente 12 herstellt.

Ggf. sorgt eine Verbindung mit den Power-Bus-Kontakten 11, die als integrierte Querverbindung wirken, für eine gezielte Verteilung der eingespeisten Potentiale.

So werden nach Fig. 10b die Leiteranschlüsse, welche in nicht dargestellter Weise den Leiterplattenrand kontaktieren können, paarweise durch Leiterbahnen 36 der Leiterplatte 6 leitend miteinander verbunden, während das umspritzte leitende Stanzgitter 6' die Vorteile einer höheren Stromtragfähigkeit und einer kostengünstigen Herstellung bietet..

Fig. 11a bis o veranschaulichen schematisch durch je eine Reihen Anschlüsse und eine schematisierte Leiterbahnendarstellung, wie durch eine geeignete Wahl der Leiterbahnen oder Stanzgitter verschiedenste Reihenklemmen realisierbar sind, so Potentialverteilungsklemmen, Mehrstockklemmen, Rangierklemmen, Mess-/Trennklemmen, Analog-Sicherungs-Mess-/Trennklemmen usw..... Die Bezeichnungen der Fig. 11 sind als Teil dieser Beschreibung zu werten.

Durch die Reihenklemmenfunktionalitäten können damit in das Anschlusssystem Funktionalitäten integriert werden, die bisher durch separate Reihenklemmenanordnungen realisiert werden mussten, was insbesondere den platzsparenden Aufbau und die Übersichtlichkeit erhöht.

Dabei bleibt die Anreihbarkeit zu Anschlussmodulen nach Art der Fig. 1 und weiteren der bereits erläuterten und noch zu erläuternden Anschluss- und/oder Funktionsmodulen 7 gewahrt. Zudem erfolgt eine Busweiterleitung im Bereich der Bus-Kontaktelemente 11 und/oder 12.

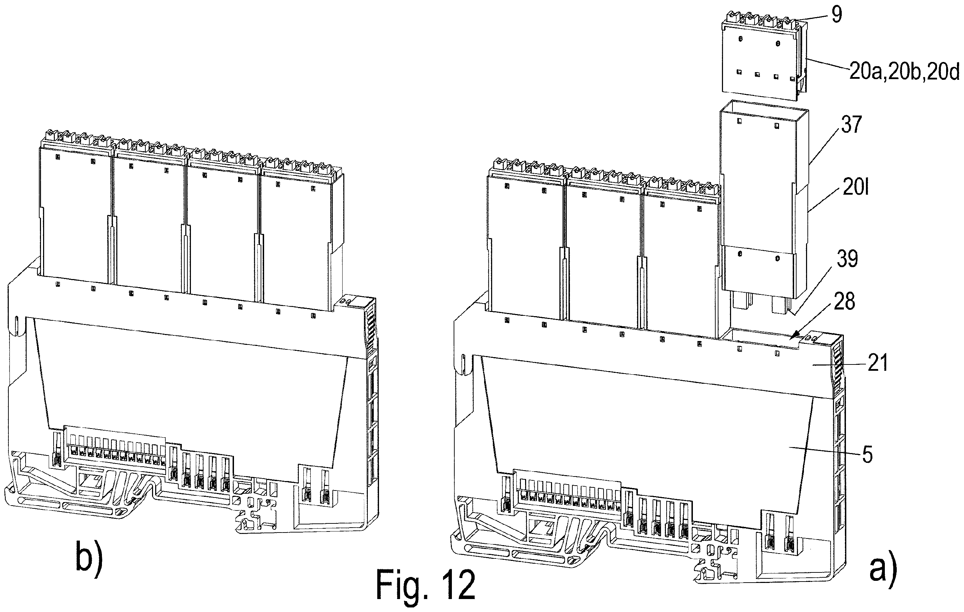

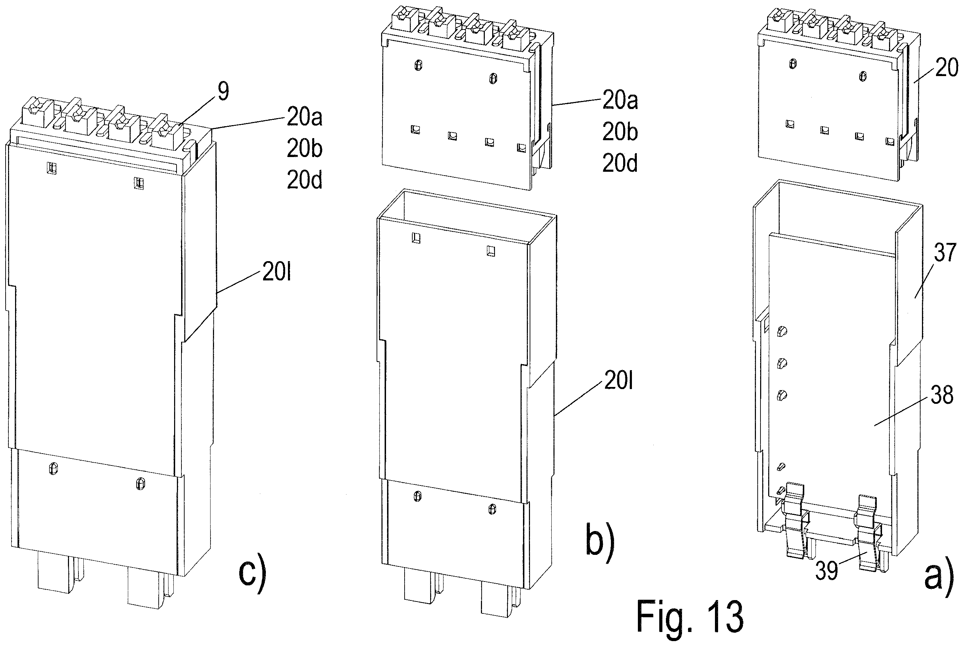

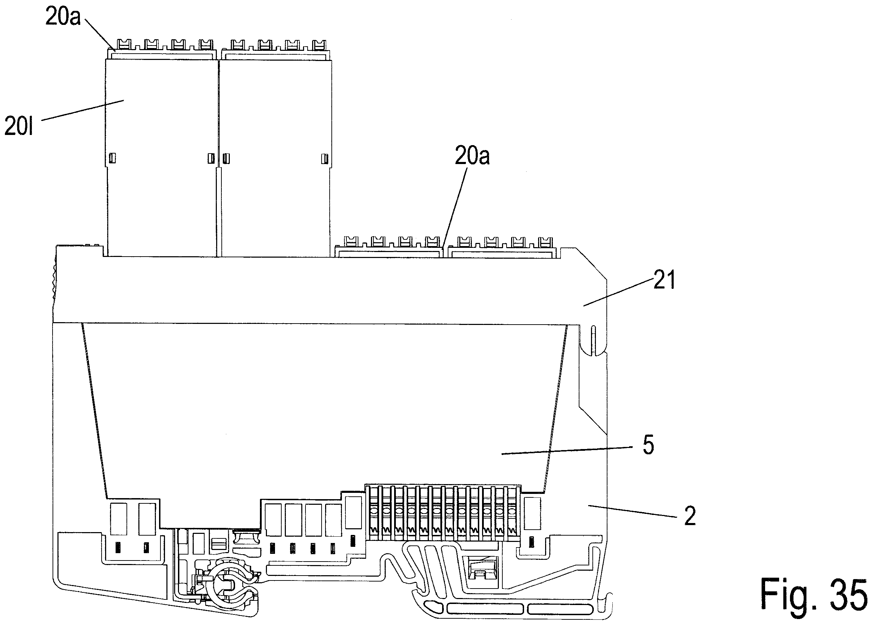

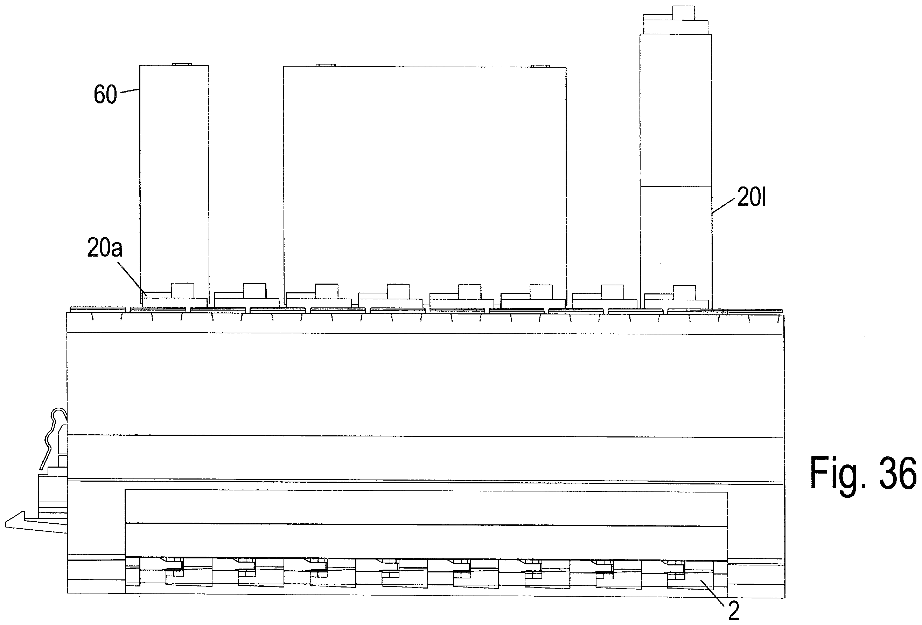

Nach Fig. 12 und 13 wird in besonders vorteilhafter Weise noch eine weitere Funktionalität in das Anschlusssystem integriert (siehe auch Fig. 35 und 36).

So wird nach Fig. 12 ein Anschluss- und/oder Funktionsmodul realisiert, bei welchem der Rahmen 21 mit Funktionsbausteinen 20 I bestückt ist, die Anschlussbausteine 20a, 20b und 20d (Steckverbinder) für Leiter aufweisen sowie ein Elektronikgehäuse 37 mit einer Elektronikleiterplatte 38, insbesondere mit einer Signalanpassungselektronik versehen, die beispielsweise dazu ausgelegt sein kann, ein Ausgangssignal zu verstärken und galvanisch zu trennen oder um beispielsweise ein analoges Spannungssignal in ein digitales Stromsignal umzuwandeln. Derartige Signalanpassungselektroniken sind dem Fachmann allgemein bekannt und von daher an dieser Stelle nicht näher zu erläutern.

Auf diese Weise ist es mit konstruktiv einfachen Mitteln möglich, optional eine Signalanpassungebene mit in das Anschluss- und/oder Funktionsmodul zu integrieren, vorzugsweise aufzusetzen und so Platz und Verdrahtungsaufwand zu sparen.

Der oder die Leiteranschlüsse bzw. Anschlussvorrichtungen 10 an dem Anschlussbaustein 20a, b, d bilden hier beispielhaft eine Übergabeebene für Signale oder Energie aus dem Feld oder in das Feld, beispielsweise für Feldgeräte wie Aktoren oder Sensoren oder dgl.

Mit den Funktionsbausteinen 201, welche hier die weiteren Elektronikgehäuse 37 mit der Leiterplatte 38 mit einer Schaltung sowie die Anschlussbausteine 20a, b und Steckverbinder 20d aufweisen, welche in Aussparungen eingreifen, welche den Rastplätzen des Rahmens 21 nachgebildet sind, kann zwischen die "Übergabeebene" aus den Leiteranschlüssen und die Elektronik 5 als "I/O-Ebene" direkt eine "Signalanpassungsebene" gesetzt und geschaltet werden, was wiederum eine separate Installation derartiger Signalanpassungselektroniken im Schaltschrank gespart.

Mögliche Signalanpassungselektroniken können sein bzw. können beinhalten:
- ein Schaltelement (Relais, Optokoppler) mit Anschlussebene:
- Schutzelement (1 Sicherung) ohne oder mit Anschlussebene
- Schutzelement (2 Sicherung) ohne oder mit Anschlussebene
- Standard-I/O-Beschaltungen mit Anschlussebene (optionaler Y-Anschluss)
- Schaltverstärker von 0,5A auf 2,0A
- Zeitrelais
- Impulsverlängerung / Zeitglieder
- Überspannungsschutz
- Trennverstärker: Signale wandeln, galvanisch trennen, verstärken u. filtern
- Pegelinvertierung von pnp / npn oder Bereitstellung von beidem
- Schaltschwellenänderung
- 10-Link-Beschaltungen mit Anschlussebene (optional Y-Anschluss
- Entstörelemente / Filter mit Anschlussebene
- Potentiometer als Handbedienebene
- Schalter als Handbedienebene
- Y-Zwischenstecker und Doppelstecker (1 x 1,5mm² => 2 x 0,5mm²)
- Display (LCD / OLED) mit oder ohne Taste.

Insbesondere 2, 4 oder 8 Leiterplattenrandverbinder 39 (Fig. 13) an der Leiterplatte 38 ermöglichen vorzugsweise wiederum in einfacher Weise eine Kontaktierung der Leiterplatte 6 in dem Elektronikgehäuse 5.

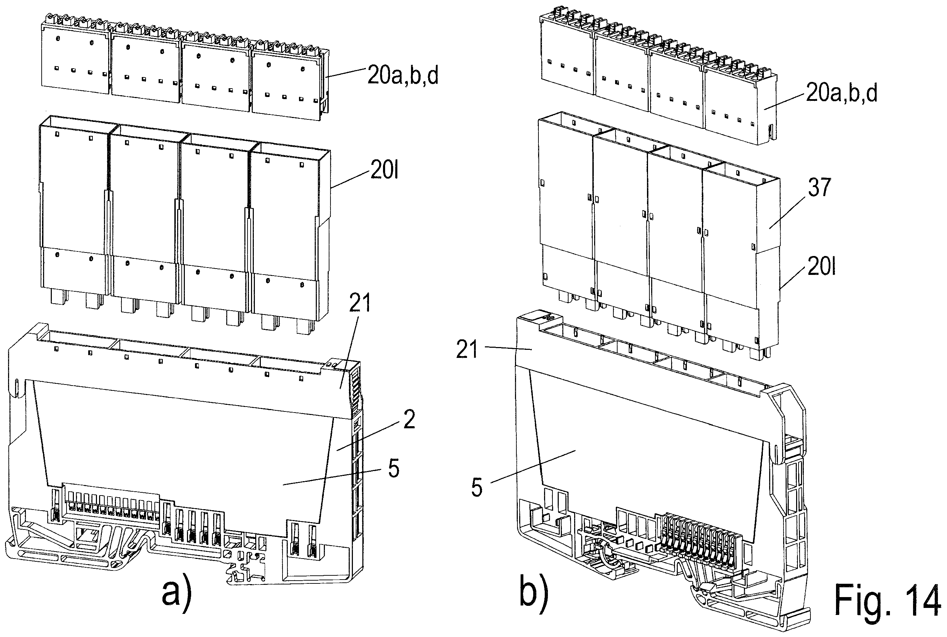

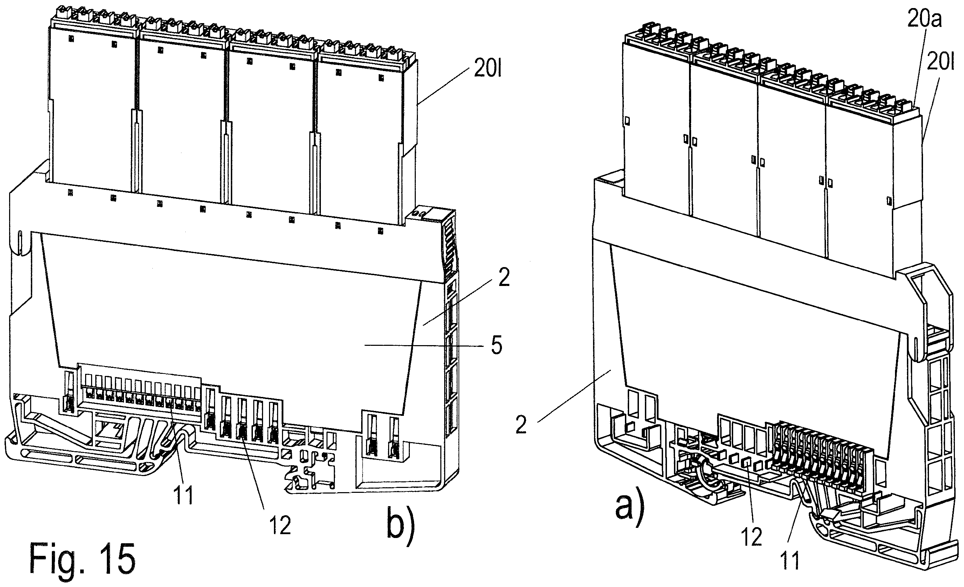

Fig. 14 zeigt das Anschluss- und/oder Funktionsmodul 1 als I/O-Scheibe mit den steckbaren Funktionsbausteinen 20 und Fig. 15 zeigt das Anschluss- und/oder Funktionsmodul als I/O-Scheibe mit den eingesteckten Funktionsbausteinen 20 im zusammengebauten Zustand.

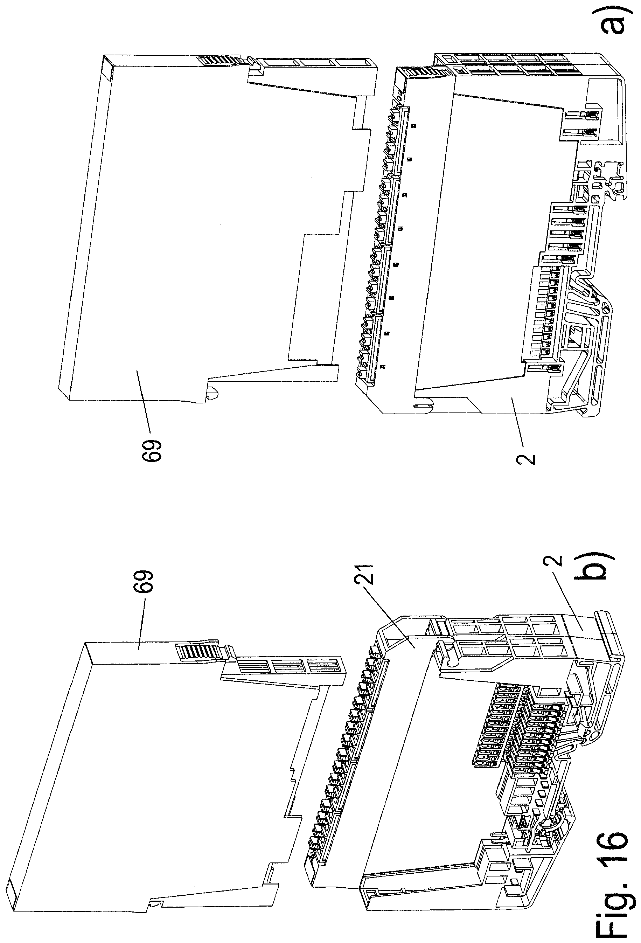

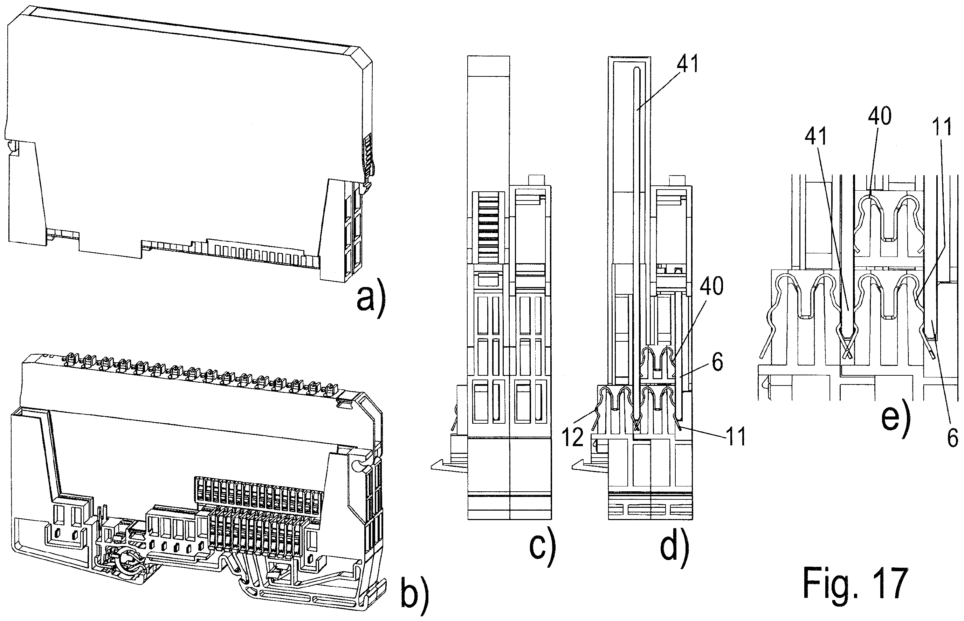

Die Fig. 16 und 17 zeigen noch eine weitere erfindungsgemäße Anschluss- und/oder Funktionsmodulanordnung. Dabei sind zwei Basisklemmenträger 2 direkt aneinander gesetzt, wobei die beiden Elektronikleiterplatten 6 und 41 der beiden nebeneinander angeordneten Basisklemmenträger 1 auch direkt über weitere Bus-Kontaktelemente 40 direkt leitend miteinander verbunden sind.

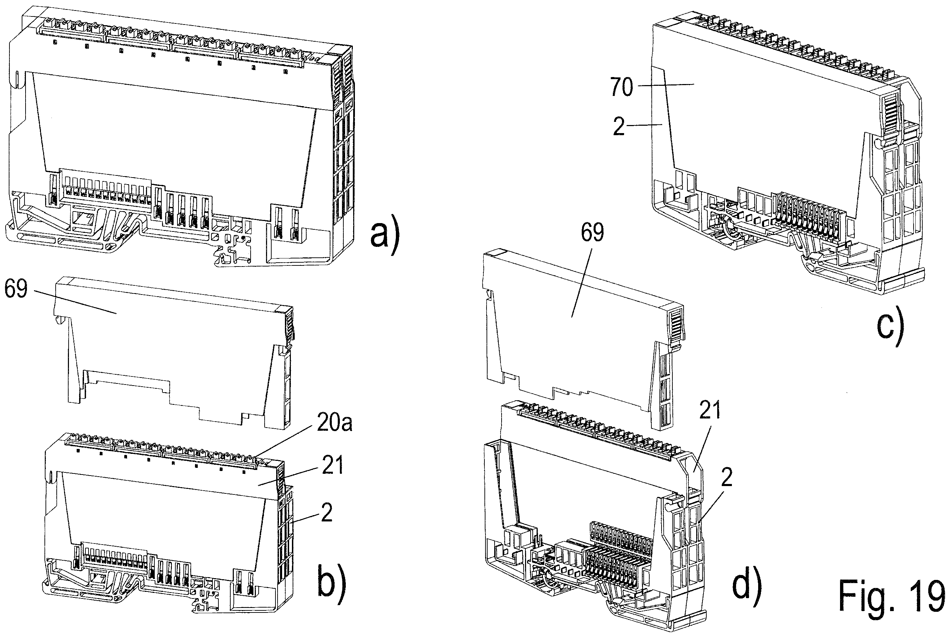

Dabei ist die eine der Leiterplatten 41 besonders großflächig ausgelegt, so dass darauf verzichtet wird, auf diese große Leiterplatte 41 noch eine Anschluss- und/oder Funktionseinheit 7 aufzusetzen. Stattdessen wird nur an dem einem der beiden zusammengehörigen Anschluss- und/oder Funktionsmodule 1 der Fig. 16 eine Anschluss- und/oder Funktionseinheit 7 vorgesehen und die Kontaktierung der weiteren Leiterplatte 41 erfolgt nur oder ergänzend über die weiteren Buskontakte 40 eines quasi dritten "Busses" zwischen den aneinander gereihten Modulen. Auf die Leiterplatte kann ein Gehäuse 69 aufgesetzt werden. Derart kann mit einfachen Mitteln auch eine sehr große (Fig. 16, 17) oder mittelgroße Leiterplatte 41 (Fig. 19) mit in das Anschlusssystem integriert werden, ohne dass das Anschlusssystem sehr hoch baut. Insbesondere wird dadurch ferner (durch die Aufteilung der Elektronik- und Anschlussfunktion auf zwei Basisklemmenträger) sehr kostengünstig eine stehende Verdrahtung realisiert, so dass das Modul ohne Elektronik verdrahtet werden kann bzw. die Elektronik ohne Lösen der Anschlussebene getauscht werden kann.

Fig. 17 veranschaulicht, dass die Leiterplatten 6 und 41 mit ihrem Rand hier zwischen die aneinander drückenden Schenkel der als Druckkontakte ausgelegten Bus-Kontaktelemente 11 setzbar ist. Wird die Elektronikleiterplatte 41 gezogen, bleibt dennoch der Kontakt zwischen der Bus-Kontaktelemente 11 geschlossen. Wird sie gesteckt, erfolgt ihre Kontaktierung.

Beispielhaft sind hier die Buskontakte 40 zwischen der Leiterplatte 6 und der hohen Leiterplatte 41 Druckkontakte.

Auf diese Weise wird die Integration sehr großer Elektroniken mit stehender Verdrahtung auch direkt in das 10-System möglich.

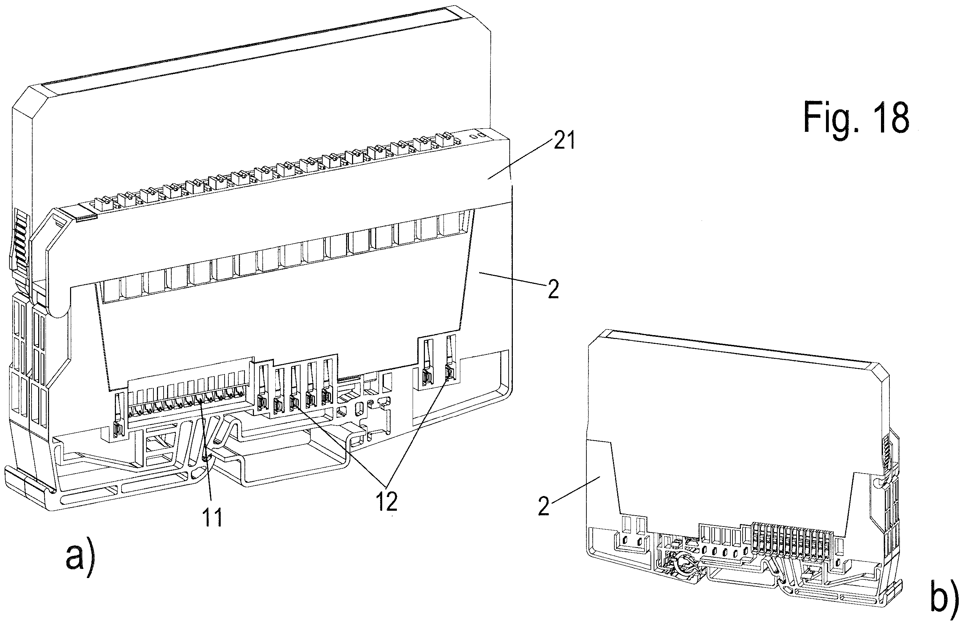

Eine analoge Auslegung zeigt Fig. 19, wobei die Elektronikleiterplatte der Fig. 19 etwas kleiner ist als die der Fig. 18.

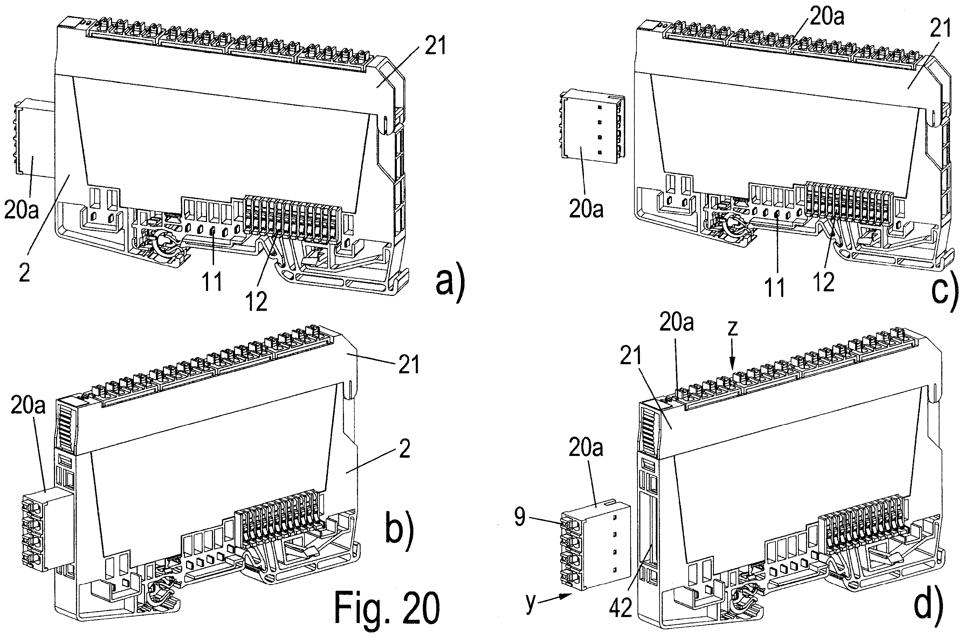

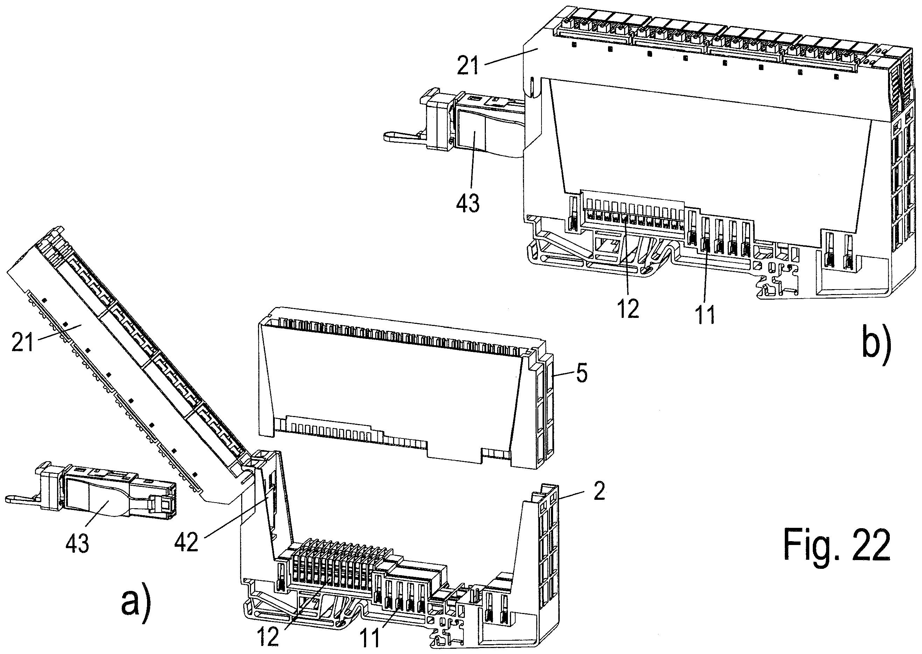

Nach Fig. 20 wird vorgeschlagen, an den Basisklemmenträger 2 direkt an einem oder beiden der Seitenschenkel 14, 15 seitlich wenigstens eines Steckplatzes 42 für wenigstens einen der Funktionsbausteine, beispielsweise eines der Anschlussmodule 20a (Fig. 20) oder eine Steckvorrichtung 43 (Fig. 22) vorzusehen. Nach Fig. 20 ist die Anschlussrichtung Y dieses Funktionsbausteins seitlich um 90° zur Anschlussrichtung Z der Leiter für die Anschlussbaustein 20a im "oberen" Rahmen 21 gedreht.

Im letzteren Fall (der Steckvorrichtung 43) kann auch an einem Verbund aus beispielsweise zwei Basisklemmenträgern ein derartiger Steckplatz ausgebildet sein (Fig. 22).

Durch diesen wenigstens einen weiteren seitlichen Steckplatz wird es möglich, auf einfache Weise an einem einzelnen Anschluss- und/oder Funktionsmodul noch mehr der Leiteranschlüsse z.B. zur Einspeisung oder Versorgungsweiterleitung vorzusehen.

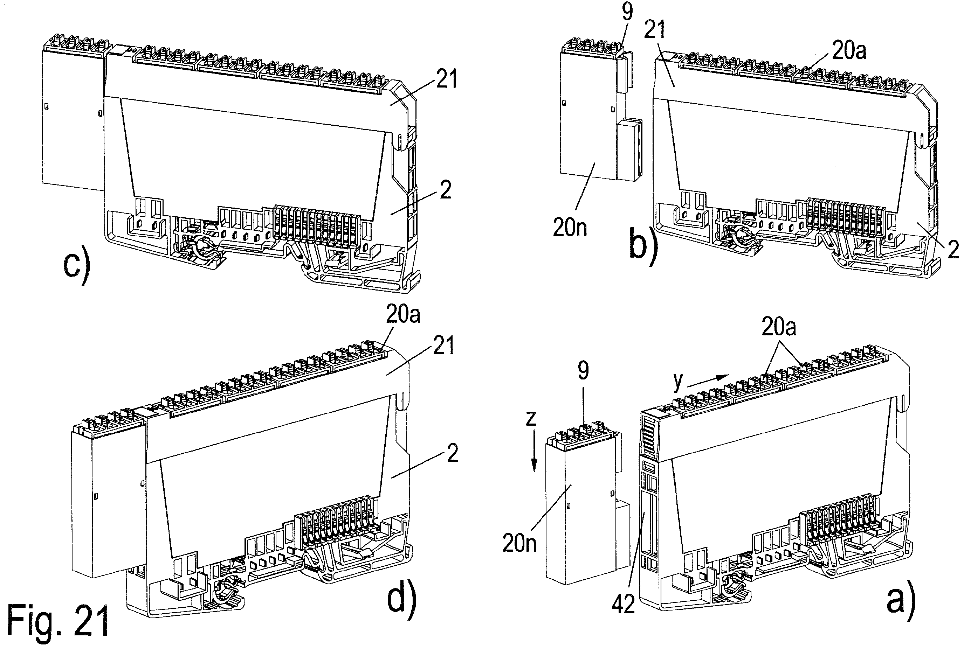

Nach Fig. 21a-d kann dieser weitere Steckplatz auch für einen Funktionsbaustein genutzt werden, der beispielsweise sowohl eine Anschlussebene bzw. einen Anschlussbaustein 20n als auch ein Elektronikgehäuse 44 mit einer Elektronik, insbesondere eine 10-Elektronik, aufweist.

Somit kann die Kanalzahl eines Anschluss- und/oder Funktionsmoduls 1 erhöht werden, um z.B. Erweiterungen einfach vornehmen zu können, ohne die Stationslänge verändern zu müssen.

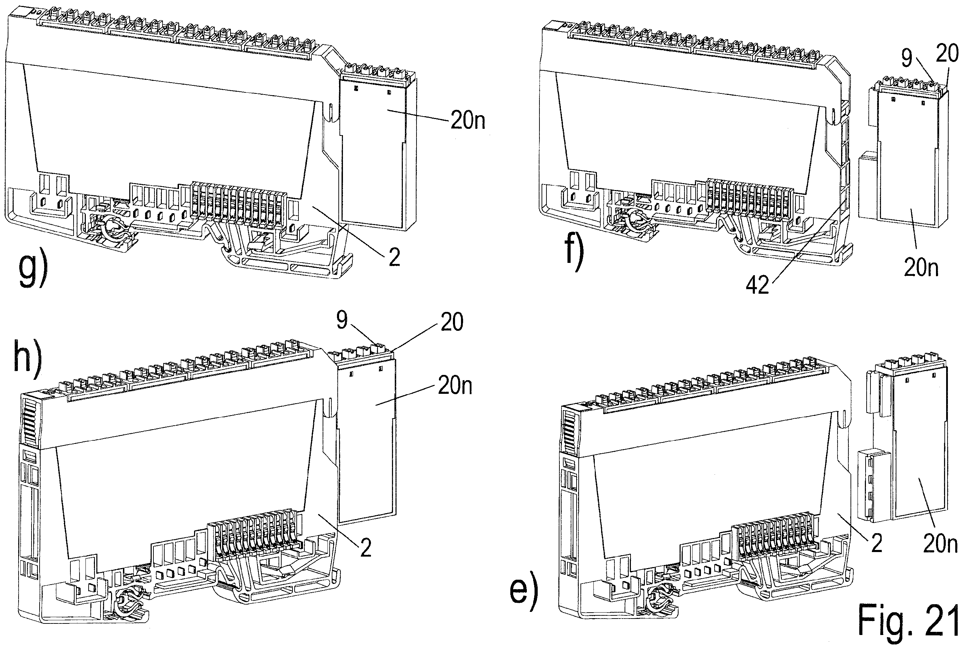

Fig. 21e-h veranschaulichen eine Auslegung, bei welcher an zwei voneinander abgewandten nicht aneinander gereihten Außenflächen bzw. -Seiten des Basisklemmenträgers 2 jeweils einer der Steckplätze 42 für einen der Funktionsbausteine vorgesehen ist, so dass die Kanalzahl auch nachträglich auf einfache Weise noch weiter erhöht werden kann.

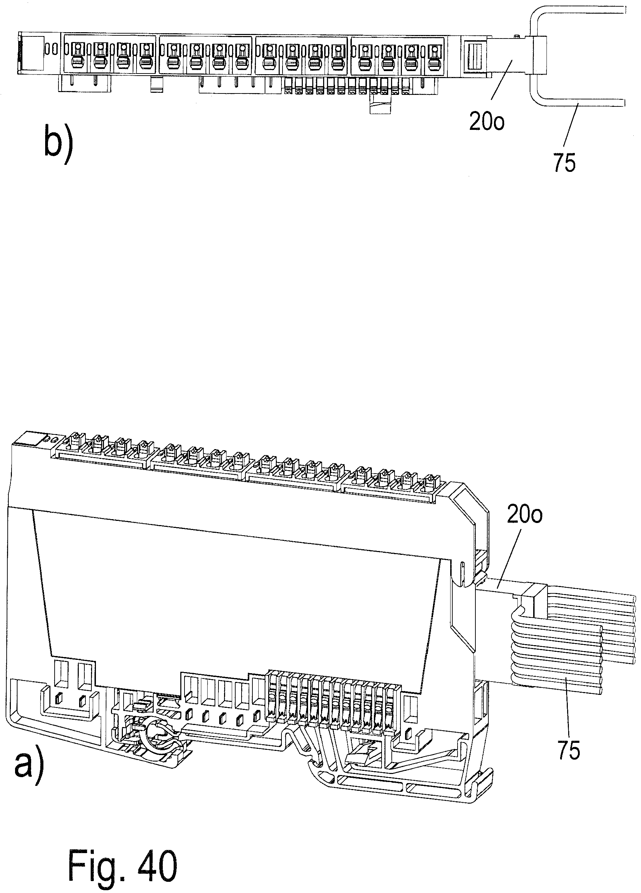

Nach den Fig. 40 und 41 ist es ferner denkbar, an den wenigstens einen weiteren Steckplatz 42 jeweils einen Funktionsbaustein 20o (Fig. 40) bzw. 20p (Fig. 41) anzustecken. Diese Funktionsbausteine 20o und 20p sind als T-stückartige Abzweigung an mehreren parallel zueinander angeordneten - nicht in den Anschluss- und Funktionsmodulen verlaufenden - Busleitungen 75, 76 ausgebildet sind, wobei über die Funktionsbausteine eine Verbindung zur Elektronik des Anschluss- und Funktionsbausteins realisiert wird.

Dies ermöglicht es, auf einfache Weise seitlich an den Anschluss- und Funktionsmodulen einen Subbus anzuordnen und auszubilden, der sich beispielsweise über mehrere der Anschlussmodule hinweg erstrecken kann und/oder an den direkt andere Geräte (hier nicht dargestellt) im Feld anschließbar sind.

Die Ausrichtung der mehreren parallel zueinander verlaufenden Busleiter, die gemeinsam einen flachen Verbund bilden, kann auf einfache Weise den jeweiligen Einbauräumen und -bedingungen vor Ort angepasst werden. So kann der Verbund U-förmig ausgebildet sein, wobei am Grunde des U die Funktionsbausteine 20o und 20p an die Leiter angeschlossen sind (z.B. mit hier nicht zu erkennenden isolationsdurchdringenden Kontakten). Der Verbund kann ferner in verschiedener Richtung ausgerichtet sein, so parallel zur Tragschiene (76, Fig. 41) oder senkrecht zu deren Haupterstreckungsrichtung (Busleiter 75, Fig. 42, auch hier wäre alternativ wiederum eine Ausrichtung parallel zur Tragschiene denkbar).

Es ist aber auch denkbar, einfach einen Anschlussbaustein 20a zu schaffen, dessen Anschlussrichtung die gleiche ist wie die der Anschlussbausteine 20a im Rahmen 21 (Richtung Z) und dessen Steckrichtung y an das Modul sich um 90° von der Steckrichtung unterscheidet. Nach Fig. 20 und 21 werden auf einfache Weise weitere Leiteranschlüsse realisiert, welche aus verschiedener Richtung beschaltbar sind. Denkbar sind auch Querverbinderelemente, Datenkontakte, evtl. Flachkabel

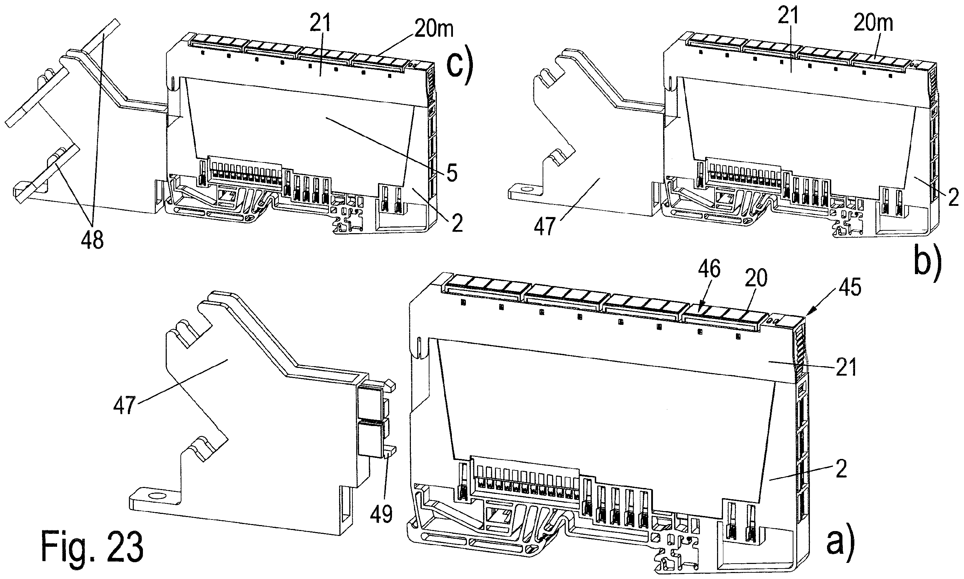

Nach Fig. 23 wird eine weitere Option vorgeschlagen, eine Markierungsscheibe 45. Diese Markierungsscheibe 45 weist einen Aufbau auf, welcher dem der Anschluss- und/oder Funktionsmodule weitgehend entspricht, allerdings ist der Rahmen 21 hier mit Funktionsbausteinen versehen, welche lediglich Markierflächen 35 aufweisen. Die Scheibe dient damit an ihrer Oberseite rein zur Markierung und erhöht derart deutlich die Übersichtlichkeit und die Orientierung im Koordinatensystem. Die Anschluss- und/oder Funktionseinheit wird hier somit zu einer "Markiereinheit" umfunktioniert, welche dem Anwender entscheidend die Orientierung an der von der Tragschiene abgewandten Seite des Anschlusssystems erleichtert.

Das Elektronikgehäuse 5 kann hier "leer" sein oder für andere Funktionen genutzt werden.

Da keine Signaleinspeisung erfolgt, kann Fig. 23 a) bis c) seitlich ein Halter, beispielsweise ein Schirmschienenhalter 47, an den Basisklemmenträger angeformt oder angesetzt sein, um eine oder mehrere Stromschienen 48 nach Art von Schirmschienen oder Sammelschienen oder Energieversorgungsschienen seitlich am Modulsystem bzw. am Anschlussscheibensystem anzuordnen, was es ermöglicht, einen Kabelschirm zu erden oder beispielsweise eine Spannungsversorgung für höhere Energien (z.B. 400 V) am Anschlusssystem bereit zu stellen, um beispielsweise Elektromotoren und dgl. zu versorgen. Zur Befestigung des Schirmschienenhalters 47 können korrespondierende Rastmittel 66 am Schirmschienenhalter 47 und an dem Basisklemmenträger 2 der Markierungsscheibe 45 verwendet werden.

Die Stromschienen 48 können derart beabstandet zu dem eigentlichen Anschlussscheiben seitlich schräg oder parallel zueinander verlaufen und sich zwischen im Abstand in der Reihung verteilten Markierungsscheiben erstrecken.

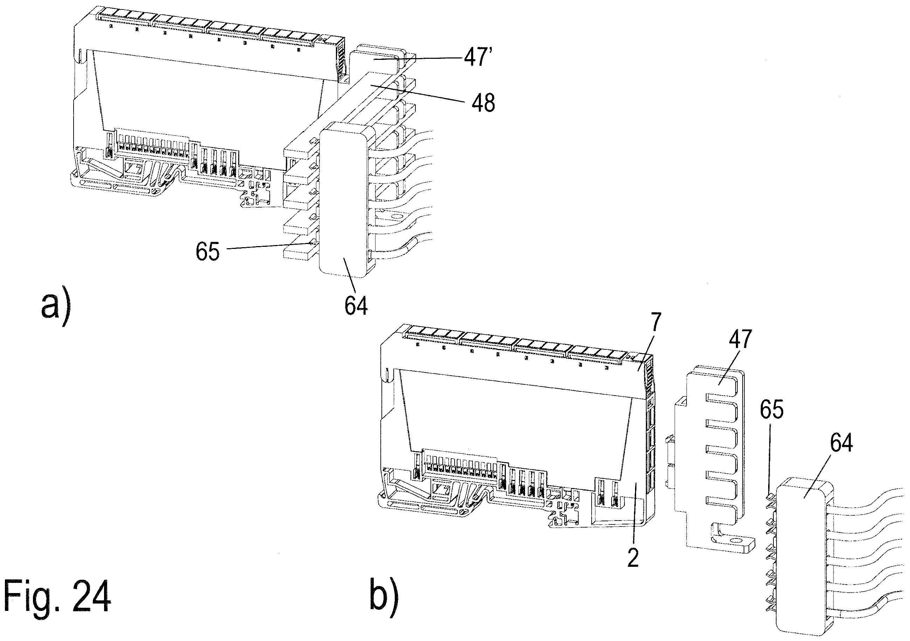

Auch nach Fig. 24 a) bis b) ist ein Schirmschienenhalter 47' an den Basisklemmenträger angeformt oder angesetzt, um eine oder mehrere Stromschienen 48 seitlich am Modulsystem bzw. am Anschlussscheibensystem anzuordnen. Zusätzlich ist hier mit einem Stecker 64 ein Abgang realisiert, beispielsweise für PE, N, L1, L2 und L3 eines 400V-Drehstromsystems. Am Stecker 64 sind Kontakte 65 zur Kontaktierung der Stromschienen 48 vorgesehen. Am Sammelschienenhalter 47 ist eine Rastkontur 60 zum Einstecken in eine Aufnahme 66 des Basisklemmenträgers vorgesehen. Die Potentialzuleitung kann anderer, hier nicht dargestellter Stelle z.B. an den Enden der Stromschienen erfolgen.

Die Stromschienen 48 können derart beabstandet zu dem eigentlichen Anschlussscheiben seitlich parallel verlaufen und sich zwischen im Abstand in der Reihung verteilten Markierungsscheiben erstrecken.

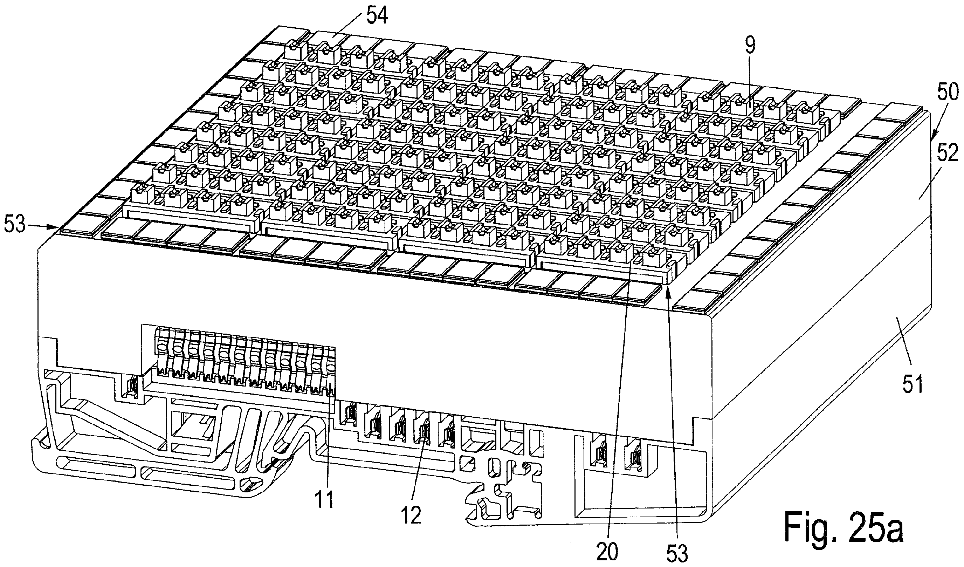

Nach Fig. 25 wird als weitere Option des Anschlusssystems ein "flacher" Anschlussblock 50 realisiert, vorzugsweise versehen mit einer IO-Elektronik.

Der Anschlussblock weist einen Basisklemmenträger auf, der hier mit 51 bezeichnet ist. Dieser Basisklemmenträger 51 weist in Tragschienenrichtung seitlich vorzugsweise die gleiche Kontur und die gleichen Kontakte auf wie die Anschlussscheibe 1. Insbesondere sind also die Bus-Kontaktelemente 11, 12 für Daten, Signale und/oder Power/Energieversorgung vorgesehen.

Der Basisklemmenträger 51 des Anschlussblockes 50 ist aber in Tragschienenrichtung breiter als eine einzelne Anschlussscheibe 1.

Vorzugsweise beträgt die Breite ein Vielfaches der Breite einer Anschlussscheibe 1 in Rasterbreite R. So kann die Breite beispielsweise die vierfache Breite 4R oder die zehnfache Breite 10 * R sein, ohne dass die Erfindung hierauf beschränkt wäre.

Im dargestellten Ausführungsbeispiel wird auf den Basisklemmenträger 51 wenigstens ein Rahmen 52 aufgesetzt der Kammern bzw. Steckplätze 53 aufweist, welche dazu ausgelegt sind, die Funktionsbausteine 20 aufzunehmen, z.B. Anschlussbausteine mit Push-In-Anschlüssen. Theoretisch wäre ein solcher Block auch aus Einzelklemmenträger mit einer geringeren Breite zusammenstellbar. Der Rahmen 52 kann aufsteckbar sein oder aber auch aufschwenkbar am Basisklemmenträger 51 befestigt sein. Der Basisklemmenträger 51 wird derart ausgestaltet, dass er in Anreihrichtung mit den Anschlussscheiben 1 seines Systems koppelbar ist (siehe auch Fig. 29 ff.).

Derart kann - siehe wiederum Fig. 25a - auf einfache Weise eine sehr übersichtliche Matrix, hier ein 8*16-Feld, aus Leiteranschlüssen realisiert werden (zu erkennen an den Pushern 9).

Im vorliegenden Fall sind die Bus-Kontaktelemente 11 zwar anders ausgestaltet als in Fig. 1, sie sollen aber kompatibel sein oder werden vorzugsweise im ganzen Anschlusssystem gleich ausgestaltet. An den beiden Seiten in Anreihrichtung sind jeweils komplementäre Bus-Kontaktelemente 11, 12 ausgebildet, die im Anschlussblock vorzugsweise leitend miteinander z.B. über Stromschienen oder eine Leiterplatte oder eine Schaltung oder dgl. verbunden sind.

Vorzugsweise sind an wenigstens einen Rand, insbesondere an allen Rändern des Rahmens 52 Markierflächen 35 ausgebildet, um eine übersichtliche Markierung nach Art eine Matrixmarkierung ("Schachbrett") zu ermöglichen.

Da die Steckplätze 53 im Rahmen 52 ausgebildet sind, können theoretisch einerseits sämtliche Funktionsbausteine verwendet werden, die bereits erörtert worden sind, so auch Sicherungsfunktionsbausteine.

Es ist aber auch möglich (Fig. 25), Funktionsbausteine 60 beispielsweise mit IO-Elektronik zu verwenden, die sich in Anreihrichtung über mehr als eine Rasterbreite eines Steckplatzes 53 erstrecken und welche zwei oder mehr Ansätze 55 ausweisen können, welche in entsprechend zwei oder mehr Steckplätze 53 einsteckbar sind, um mechanisch und ggf. anschlusstechnisch in das Anschlusssystem integriert zu werden. Zudem können wieder sämtliche Funktionsbausteine, insbesondere auch die Funktionsbausteine 20l mit einer Elektronik, beispielsweise einer Signalanpassungselektronik gesetzt werden (Fig. 25b, 25c).

In Hinsicht auf die flachen Blöcke können derart verschiedenste Varianten realisiert werden. Eine Elektronikleiterplatte einer I/O-Elektronik kann insbesondere flach oder stehend vorgesehen sein.

So ist eine aufsteckbare I/O-Elektronik (schwerpunktmäßig in niedrigen Scheiben und Blöcken) denkbar, wobei die I/O-Elektroniken ohne Anschlusstechnik in z.B. 45mm langen Gehäusen hinten und/oder mittig (u/o vorn) auf eine Basisleiterplatte steckbar sind.

Vorzugsweise ist die Anschlusstechnik nicht nur einseitig sondern beidseitig positioniert (Verdrahtung nach oben und unten; im Schaltschrank mit senkrechter Montageplatte). Leiterplatten können sind insbesondere längs im schmalen Gehäuse oder quer im breiten Gehäuse positionierbar. I(nput)/O(utput)-Elektroniken ohne Anschlusstechnik oder mit Anschlusstechnik (so in einem beispielsweise 22,5mm langen Zwischenstecker 20l) sind ebenso realisierbar.

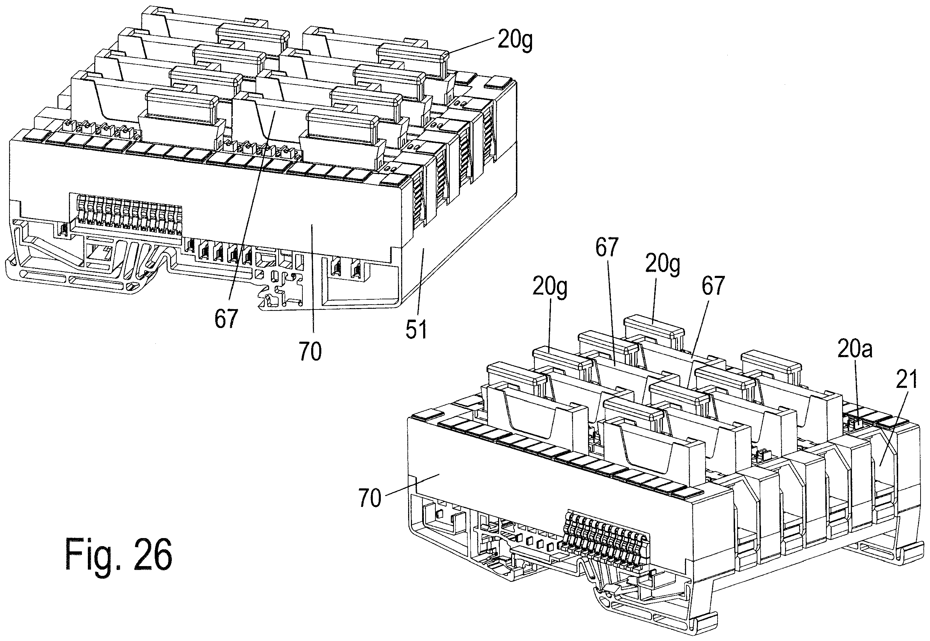

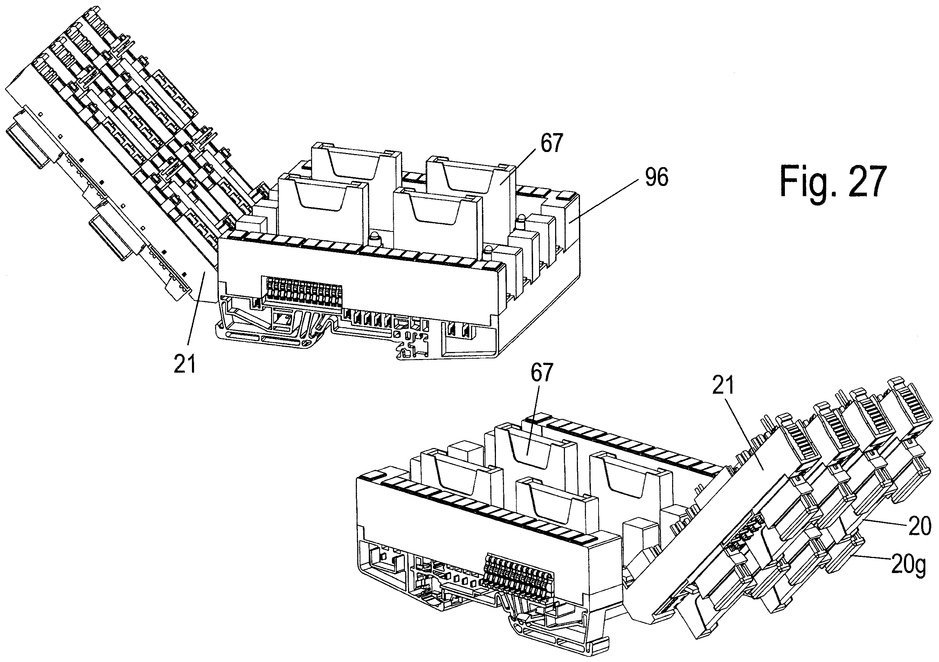

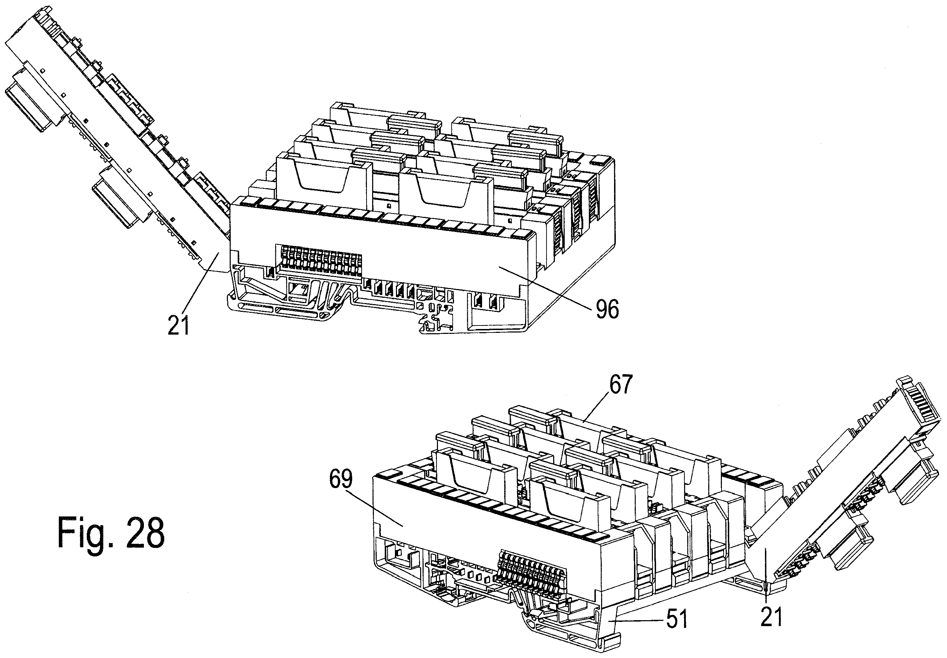

Die Fig. 26 bis 28 zeigen Blockmodule mit Relais und Sicherungen. Dabei sind jeweils an einem Aufsatz 70 auf den Basisklemmenträger 51 des Blocks Rahmen 21 aufschwenkbar befestigt, welche Anschlussbausteine 20a und Sicherungsbausteine 20g aufweisen. Zwischen diesen Rahmen 21 sind Reihen von Relais 67 vorgesehen, die hier direkt ohne Rahmen in dem Aufsatz 69 des Basisklemmenträgers einsteckbar sind (z.B. Relais über Relaisadapter).

Fig. 35 und 36 veranschaulichen den erweiterten Aufbau nach Art eines Schichtenmodells (bezogen auf die Tragschiene als untere Basis von oben nach unten):
Übergabeebene -> Signalanpassungebene -> Übergabeebene -> I/O-Ebene.

Nachfolgend sind mehrere Anschlussstationen betrachtet, welche mit Hilfe von erfindungsgemäßen Anschluss- und Funktionsmodulen zusammengestellt worden sind, die zu einem Anschluss- und Funktionssystem gehören, also anreihbar und vorzugsweise in Anreihrichtung mechanisch und ggf. elektrisch oder über Lichtleiter oder dgl. koppelbar sind.

Eine erste Station zeigt Fig. 29.

Dargestellt sind folgende beispielhafte Anschlusssystemreihungen bzw. -stationen (bezogen jeweils auf ein Einscheibenraster mit der Rasterbreite "R" in Tragschienenrichtung):
Fig. 29: R1 Gateway, R2 Gateway, R3 Gateway, R4 Gateway, R5 Markierungsscheibe, R6 Standardscheibe, R7 Standardscheibe, R8 Standardscheibe, R9, R10 Große Elektronik mit stehender Verdrahtung 115 hoch, R11, R12 Große Elektronik mit stehender Verdrahtung 75 mm hoch, R13 Einspeisescheibe, R14 Markierer, R15 bis R19 Standardscheibe (Anschlussscheibe), R20 Markierungsscheibe, R21, R22 Scheibe mit Markierer und Anschlüssen zur Busweiterleitung mit Stecker.

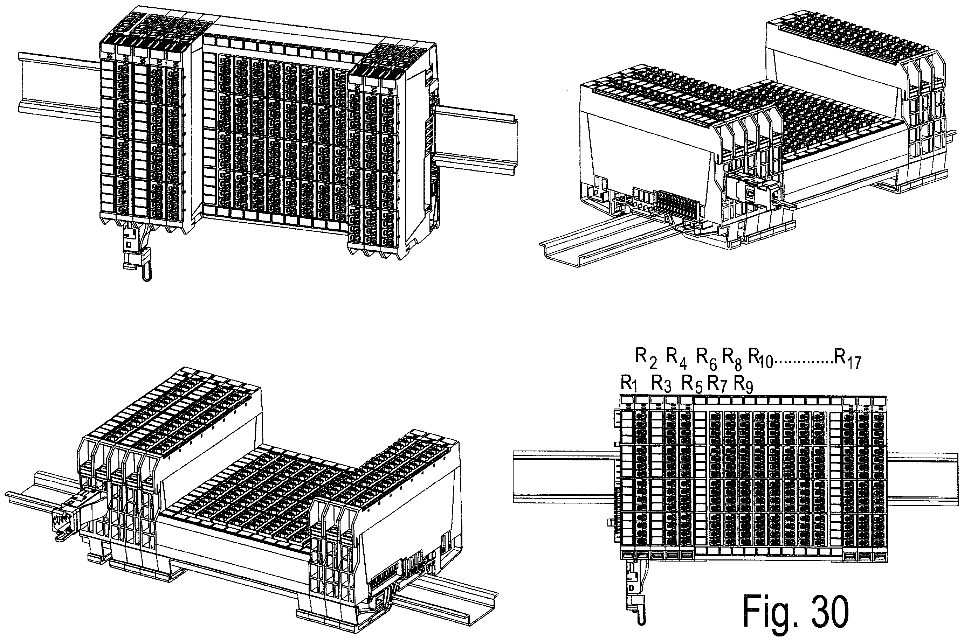

Fig. 30 zeigt eine Station mit folgendem Aufbau: R1 Standardscheibe Buseinleitung (Markierer), R2 Standardscheibe Buseinleitung (AN), R3 Markierungsscheibe, R4 Standardscheibe, R5 Standardscheibe, R6 - R17 flacher Block, R18 - R20 Standardscheiben.

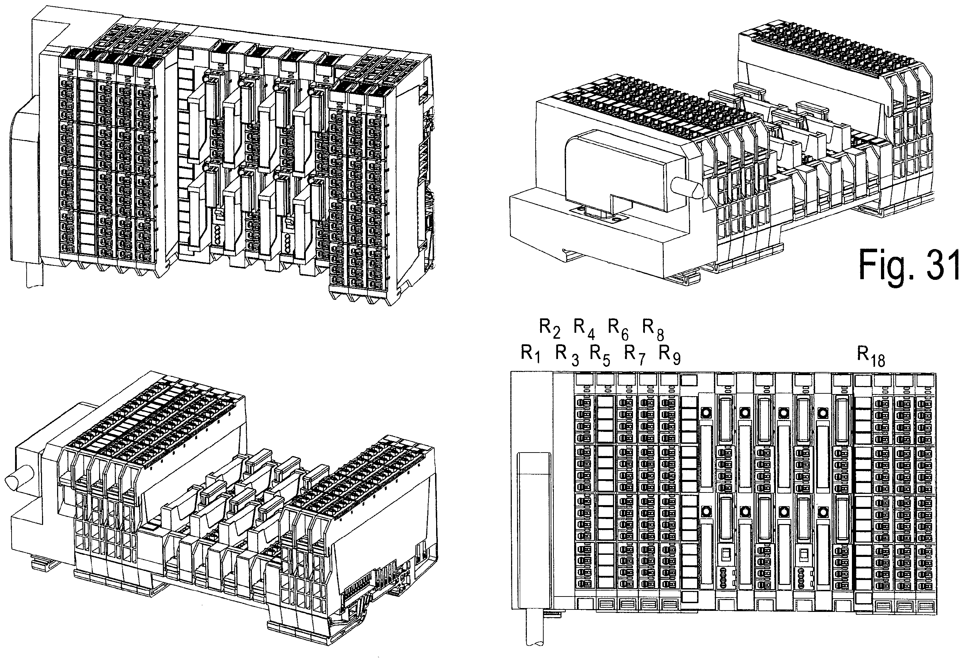

Fig. 31 zeigt eine Station mit folgendem Aufbau: R1 - R4 Gateway, R5 Markierungsscheibe, R6 - R8 Standardscheibe, R9 - R18 Block mit 8 Relais, R19 - R21 Standardscheibe

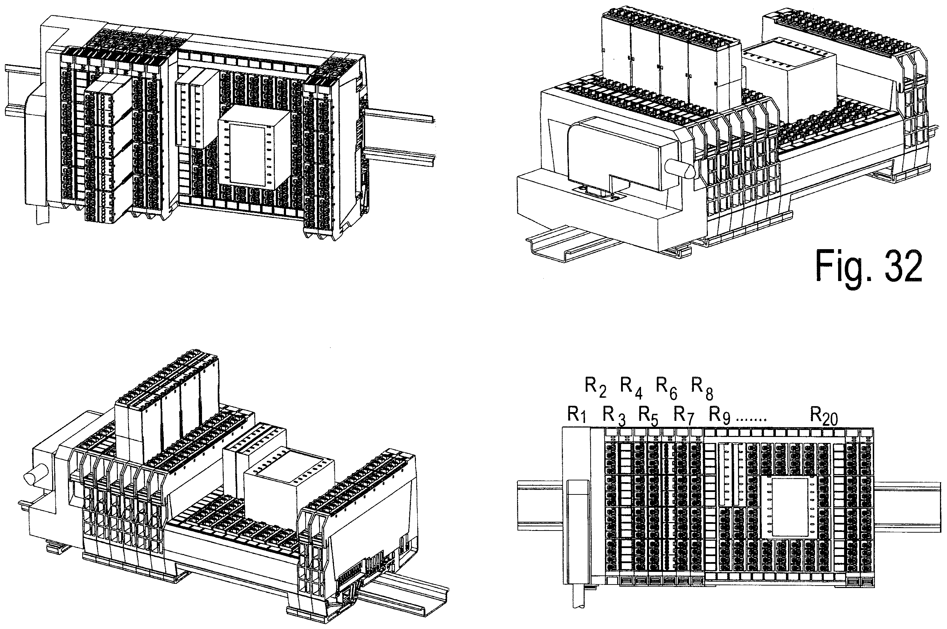

Fig. 32 zeigt eine Station mit folgendem Aufbau: R1 bis R4 Gateway, R5 Markierungsscheibe, R6 Standardscheibe, R7, R8 Scheibe mit steckbaren Funktionsbausteinen 201, R9 - R10 Standardscheibe, R11 - R21 Block mit steckbaren Funktionsbausteinen, R22, R23 Standardscheibe.

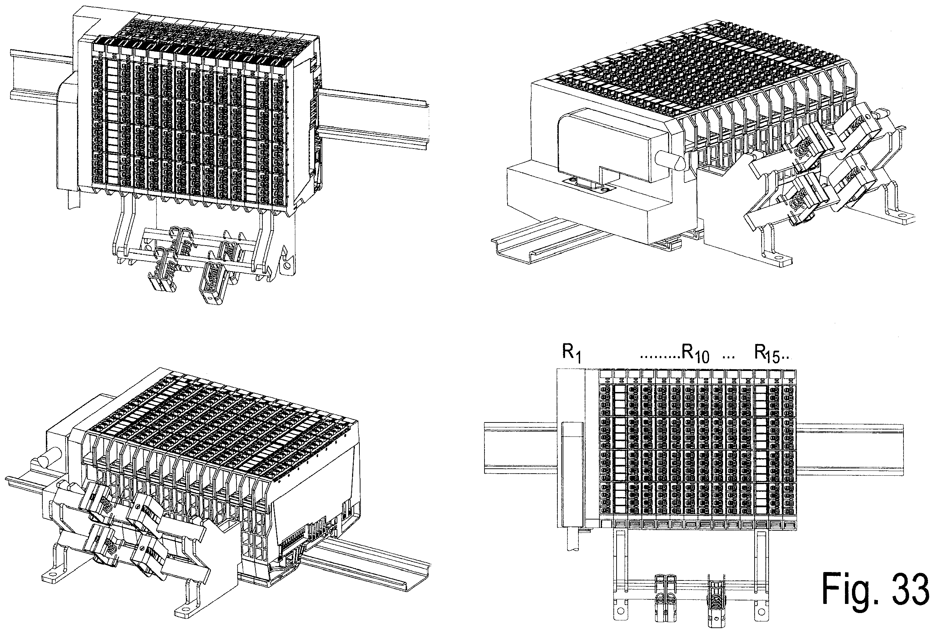

Fig. 33 zeigt eine Station mit folgendem Aufbau (bezogen auf ein Rastermaß mit der Rasterbreite "R"): R1 - R4 Gateway, R5 Markierungsscheibe mit Halter für Schirmschienen, R6 - R14 Standarscheiben, R15 Markierungsscheibe mit Schirmschienen, R16, R17 Standardscheibe.

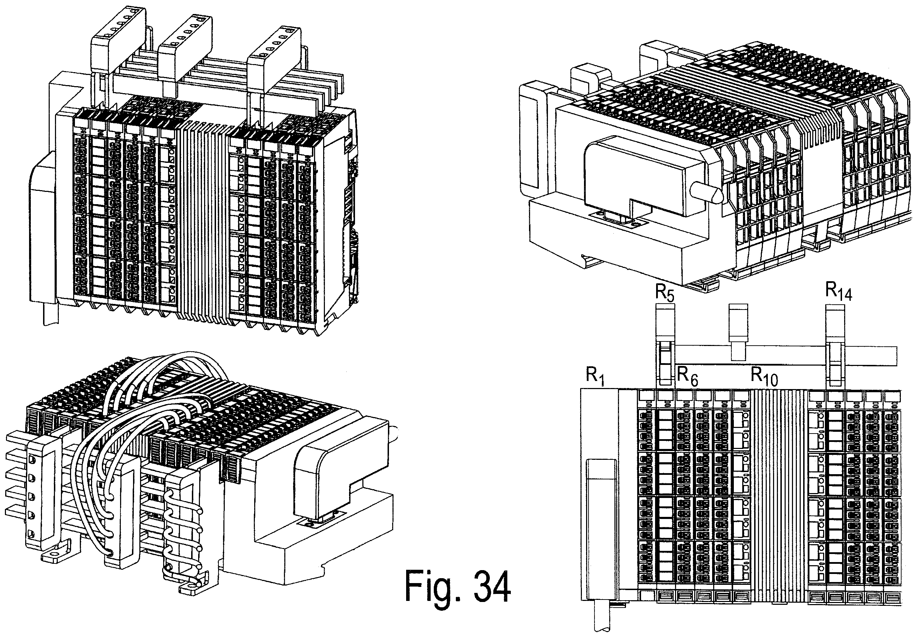

Fig. 34 zeigt eine Station mit folgendem Aufbau: R1 - R4 Gateway, R5 Markierungsscheibe mit 400V Verteilung mit Stecker, R6 - R8 Standardscheibe, R9 Einspeisescheibe mit 4x 2,5², R10 - R12 Motorstarter/Frequenzumrichter/Servoregler mit Kühlkörper 75mm hoch, R13 Verbraucherabzweig mit 4x 2,5², R14 Markierungsscheibe mit 400V Verteilung, R15 Einspeisescheibe, R16, R17 Standardscheibe.

Die vorstehenden Stationen machen die enorme Vielseitigkeit des Systems und den sehr übersichtlichen und nachvollziehbaren Aufbau deutlich.

So ist es möglich, über den seitlichen Stecker und Kabel eine Verbindung (Busweiterleitung) zu einer weiteren Reihung bzw. Station gebildet wird (Fig. 30), die dann kein weiteres Gateway aufweisen muss, aber vorzugsweise wieder eine Einspeisescheibe für Energie und/oder Daten aufweist. Es kann auch wenigstens ein Anschlussblock 50 in die Station integriert sein, dass nach Fig. 30 nur mit Leiteranschlüssen oder nach Fig. 31 auch mit Elektronikbausteinen bestückt sein kann, so mit den erwähnten Relais oder dgl.

Die Fig. 32 bis 34 veranschaulichen rein beispielhaft, dass sich mit Hilfe der vorstehend erläuterten Komponenten ein besonders übersichtliches und klar strukturiertes Anschlusssystem auf einer Montagebasis wie der Tragschiene realisieren lässt.

Fig. 32 veranschaulicht dabei wiederum die einfache Integration der Signalanpassungsebene in das System.

Fig. 33 und 34 zeigen besonders gut die Integration der Markierungsscheiben 50 mit Sammelschienenhalter und Sammelschienen.

Gut zu erkennen sind aus den Figuren 29 bis 34 die einfachen Möglichkeiten zur Busweiterleitung zwischen Stationen auf einer oder mehreren Tragschienen und die hohe Funktionalität.

Insgesamt wird der Schaltschrankaufbau deutlich vereinfacht, wobei auch die Integration der Signalanpassungsebene eine besondere Rolle spielt.

Insgesamt ergeben sich aus den Fig. 29 bis 34 folgende Vorteile:
- klares optisches Erscheinungsbild;
- keine überstehenden Konturen /
   guter Kontaktschutz /
   wenig Luft in der Verpackung
- flexible Befestigungsmöglichkeit
- hohe Stabilität von Basis-, Elektronik und
   Anschluss- und/oder Funktionsmodul
- hohe Langzeitstabilität im laufenden Betrieb
- einfach aus dem Verbund entnehmbar
- keine Daten- und Powerunterbrechung beim Elektroniktausch
- Übereinstimmung von Hardware und Software (byteweise / wortweise)
- alle SA-Versorgungsanschlüsse auf dem Modul (oder dem Nachbarmodul
- hohe Signaldichte / niedriger Platzbedarf
- plausible Ordnung von Anschlussbelegungen
- plausible LED-Trichter- / und Betätigungsdrücker-Anordnung
- einfaches Handling der Anschlüsse
- freie Einsicht der Kanal-LED und Anschlussnummerierung

Durch die Kombinationsmöglichkeiten innerhalb des erfindungsgemäßen Anschlusssystems kann die Funktionalität flexibel an die Applikation angepasst zusammengestellt werden; z.B. kann es neben einem Standard-I/O-Modul mit 8 -kanäliger Al (Al+ / Al- bzw. S / Gnd) auch 2 kanälige Analog-Sicherungs-Mess-Trenn-Klemmen geben, deren Funktionalität sich in Ergänzung zum I/O-Modul auf 4 weiteren Passivklemmen oder alternativ direkt auf der Anschlussebene von 4 Analog-I/O-Modulen befindet.

Realisierbar sind auch Verbraucher-Abzweigklemmen mit T-Funktionalität => mit großen Querschnitt weiterleiten, mit kleinem Querschnitt abgehen.

Die Anschlussbausteine 20, welche für einen Steckplatz vorgesehen sind, können auch unterschiedliche Querschnitte aufnehmen; z.B. 8 x 0,5mm² oder 4 x 0,5mm² x 2 oder 4 x 1,5mm² oder 2 x 1,5mm² und 4 x 0,5mm² oder 2 x 2,5mm² oder 1 x 4,0mm² oder 1 x 6,0mm². Damit kann die Anschlussebene der Applikation individuell angepasst werden (Verteiler-Einspeiseklemmen, Leistungs-/Verbraucher-Abzweigklemmen, Einspeiseklemmen, Aktorklemmen, Sensorklemmen, Potentialverteilerklemmen, ...).

Der Querschnittsbereich von 0,5 - 6mm²-Anschlüsse wird in einem Raster von z.B. 10mm abgedeckt; zur optimalen Platzausnutzung sind deshalb die Anschlüsse im unteren Querschnittsbereich um 90°gedreht (und öfter integriert), ab 2,5mm² sind die Anschlüsse beispielsweise einseitig (rechts) so positioniert, dass entweder ein Markierungsschild links, eine 2. Anschlussreihe oder eine Längs-/Querverbindung im Raster untergebracht werden kann, die sich links befindende Markierungsfläche kann mit einem Streifen großzügig und schnell markiert werden. Innerhalb eines Rasters befinden sich 2 Führungen für Leiterplatte bzw. Stanzgitter; die linke Führung ist insbesondere für die Verwendung des Moduls als Reihenklemme oder bei 90°-Drehung als Anschluss von Relais mit QV-Möglichkeit in den Wurzeln vorgesehen.

Es ist auch denkbar, Schwenkmarkierer an der Oberseite in Höhe der niedrigen Scheibe bzw. des niedrigen Blockes zu befestigen. Dann kann nach vorn eine Kanalbeschriftung erfolgen und nach hinten zur Anschlussebene / TS: eine Modultypbeschriftung der Zwischenstecker.

Vorzugsweise wird über den gesamten Querschnittsbereich von 0,5 - 6mm² eine einheitliche Klemmenlänge realisiert (eine mögliche Ausnahme bilden solche mit Vorsatzstecker).

Die Kontaktierungsflächen am Leiterplattenrand der Leiterplatte 6 sind weiter vorzugsweise in einem festen Raster standardisiert; zur Sicherstellung der Stromtragfähigkeit. Bei größeren Querschnitten als 1,5mm² werden 2 (2,5mm²), 3 (4,0mm²) oder 4 (6,0mm²) Kontakttulpen pro Anschluss realisiert, Bzgl. der Anschlusstechnik in Steckelementen (SA-Steckern) können Einzelanschlüsse oder Doppelanschlüsse zur Signalrangierung oder z.B. auch für Messtrenn-Aufgaben Verwendung finden.

Die Steckelemente sind für einzelne Sensoren / Aktoren ausgelegt und je nach benötigter Anschlusstechnik (Einzelanschlüsse in 1 L-, 2L-, 3L-, 4L-Technik) und benötigtem Potential voll- oder teilbestückt (niedrige Kosten). Die Klemmenträger der SA-Stecker sind zur Elektronik fest bzgl. der Unterscheidung von z.B. 24V u. 230V kodiert und farblich unterschieden (Steckschutz).

Die Potential-Positionen sind standardisiert, sodass der Anwender intuitiv verdrahten kann => feste Reihenfolge von z.B. S / - / + / FE. Die Anschlüsse eines Steckers für einzelne Sensoren / Aktoren sind in Reihe längs oder quer angeordnet. Die Kontakttulpen der Anschlüsse können direkt auf einen LP-Rand od. eine Stift-/Messerleiste bzw. Einzelstifte/-Kontaktmesser greifen.

Nicht benötigte Anschlüsse werden zur Anbringung einer individuellen Markierung genutzt (z.B. Beschriftung direkt am Kanal) oder für die Integration steckbarer Querverbinder, Trenner oder Bauelementestecker (Sicherung, Dioden und dergleichen). Die Steckelemente enthalten pro Signalpfad integrierte Lichtleitstifte zur Anzeige des Signalzustandes direkt am Anschluss. Vorteilhaft ist ein 2-teiliges Gehäuse, wobei das Unterteil transparent ist und gleichzeitig den Lichtleitstift bildet. Die Steckelemente und die Steckplätze des Rahmens besitzen vorzugsweise einen Verdrehschutz, z.B. eine Einengung und/oder einen Steckschutz (Kodierung). Denkbar sind z.B. 4 Positionen, d.h. 16 Unterscheidungen. Vorteilhaft sind auch Verrastungselemente und/oder Markierungen.

Optional wird eine Schirmgeflechtkontaktierung ermöglicht, wobei der Steckschutz zwischen Steckelement und Elektronikgehäuse wirkt. Die Verrastungselemente der Steckelemente sind nur bei abgeschwenktem Rahmen außer Angriff zu bringen, sodass extrem hohe Vibrations- und Schockwerte erreicht werden können. Der Rahmen besitzt vorzugsweise eine oder zwei Drehachsen.

Denkbar sind ein Elektronikgehäuse oder ein Basisgehäuse. Denkbar sind ferner ein oder zwei Rahmenverrastungen: Elektronik- oder Basisgehäuse, Lichtleitstifte, Sammel-LED der Elektronik; (Modul- Funktionsfehler, Busfehler, ...). Optional denkbar ist eine Freimachung zur Erkennbarkeit der Elektronikfunktion und des Modulbezeichnung. Markierungsmöglichkeiten sind: Schild, aufgedruckt, ... Vorteilhaft ist damit eine leichte Identifizierung der Steckplätze.

Querstege der Rahmen 21 und oder anderer Gehäuse dienen vorzugsweise zur Bildung der Steckplätze und zur Erhöhung der Stabilität.

Vorteilhaft sind am Steckelement 20 Rastkonturen sowie ggf. am Rahmen 21 eine Zugentlastungsöse vorgesehen.

Es ist denkbar, dass der Rahmen in unterschiedlichen Signalfarben ausgeführt wird, z.B....
- Einspeiseklemmen (neue Versorgungsgruppe z.B. bzgl. 24V, 110Vdc, 230Vac in grau; Standard-I/O-Klemmen in schwarz;
- Passivklemmen (Potentialverteilerklemmen, Applikationsklemmen, ...) in Beige;
- Safety-Klemmen in gelb; EX i - Klemmen in blau leicht unterscheiden zu können.

Der Rahmen kann aus Metall zur Auflage und Ableitung von Schirmpotentialen sein; dazu wird eine Verbindung des Metallrahmens zur Leiterplatte hergestellt.

Vorteilhaft sind auch federnde Elemente auf der Leiterplatte, die den Rahmen zur Erdung und Wärmeableitung kontaktieren. Die Rahmen mit ihren Steckelementen sind in hohen und niedrigen Scheiben und Blöcken mit aufrecht stehenden Leiterplatten und niedrigen Blöcken mit flachen Leiterplatten gleichermaßen einsetzbar.

Beim niedrigen Block mit flach liegender Leiterplatte sind 2 Ausführungsformen von Relaisanordnungen besonders vorteilhaft:
- 2 Relais längs untereinander und Verwendung von Standardrahmen mit Anschlusstechnik u. Reihenklemmen-Funktionen rechts daneben
- 1 Relais längs im oberen Modulbereich und Anschlusstechnik und Reihenklemmen-Funktionen im unteren Modulbereich bei Verwendung eines Blockdeckels.

Bei aufgelöteten oder auf Sockeln befestigten, austauschbaren, sperrigen Bauelementen wie z.B. großen Relais, PCB-montierbaren Schützen und Sicherungsautomaten wird der Rahmen zur Steckelementaufnahme durch einen Blockdeckel ersetzt, der identische innere Konturen des Rahmes aufweist; ggf. bei abweichendem (größeren) Raster. Der Blockdeckel für busfähige Remote I/O mit Relais und als aktives Signalanpassungsmodul (nicht busfähig) kann leicht im Umbau realisiert werden.

Ein möglicher Standardaufbau sieht von oben nach unten im Raster folgende Belegung vor:
- 1. Raster R:
   Markierung für Betriebsmittelkennzeichen und ggf. Flachkabelstecker für aktives Signalanpassungsmodul
- 2. - 5. Raster R:
   Feld für 8 Relaissockel in 13mm Breite (alternativ 16 Relais in 6,2mm Breite bzgl. 2 Relais in 41,5mm Breite)
      => die 4 Raster erlauben das Unterbringen des Relaissockels mit Haltebügeln und oberhalb der Relais
      die zugehörigen LED' s
- 6. - 7. Raster:
   Feld für 2 Sicherungen, Hand-0-Automatik-Kippschalter, Trenner oder Anschlusstechnik
- 8. - 9. Raster:
   Feld für Anschlusstechnik
- 10. Raster:
   Markierung für Relaiskanal

Sperrige Bauelemente (z.B. Relais und Schütze) können durch eine Haube abgedeckt werden, welche im Ausschnitt des Blockdeckels verrastet (die Haube kann Lichtleitstifte enthalten, ein großflächiges Etikett aufnehmen oder auch als steckbares Elektronikgehäuse mit LEITERPLATTE wirken).

Auf die Zwischenstecker der Power-/Signalanpassung lassen sich die passiven Steckelemente direkt zwischen die Gehäusewände (ohne Rahmen) integrieren; dabei bildet der Einsteckschacht einen Steckplatz des Rahmens nach.

Steckelemente mit Anschlusstechnik und Reihenklemmenfunktionen (QV, TR, Bauelementestecker, ..).

Zur Entwärmung können neben den üblichen Maßnahmen zur Wärmevermeidung auch Kühlkörper, (z.B. bei Servoreglern) und Lüfter eingesetzt werden.

In einer Ausprägungsformen kann der Kühlkörper mit in das aufrecht stehende oder flach liegende Modul integriert werden, kontaktiert direkt die LP und ist Bestandteil des Gehäusekonzeptes (Seitenwand beim Scheibenaufbau bzw. aufrecht stehenden LP und Gehäusevorderseite beim niedrigem Blockaufbau mit flach liegenden Leiterplatten). In einer weiteren Ausprägungsform wird der Kühlkörper als passives Entwärmungsmodul in Form einer aufrecht stehenden Scheibe realisiert, unter der der Daten- und Powerbus durchläuft und optional eine indirekte Kontaktierung zur Leiterplatte über Heatpipes hergestellt wird. Auch kann ein zusätzlicher Lüfter außen im unteren Bereich vor einer leistungsstarken Rechnerbaugruppe oder einem Servoregler positioniert und angebracht werden

Durch das flexible Versorgungskonzept im Basismodul, der Konturgleichheit der busfähigen, aktiven und passiven Module und dem standardisierten Anschluss-/Steckfeld lassen sich die unterschiedlichsten Produktkategorien beliebig in der Station mischen und zu einer Objekt-Automatisierungsinsel zusammenfassen.

Dabei bildet die I/O-Ebene die untere Plattform, auf die i.d.R. direkt die Übergabe-/Rangierebene mit den Reihenklemmenfunktionalitäten aufsteckbar ist. Optional bzw. alternativ kann die Power-/Signalanpassungsebene direkt auf die I/O-Ebene aufgesteckt werden, wobei diese wiederum oben die Übergabe-/Rangierebene aufnimmt.

Die Steckelemente der Signalanpassungs- und Übergabeebene stellen Bausteine dar, die auf die Plattform der I/O-Ebene aufgesetzt werden. Die Plattformen (I/O-Module) stellen ihrerseits wiederum Bausteine des Gesamt-Bausteinesystems "Objekt- Automatisierungsinseln" dar. Eine Modulbus-Weiterleitung verbindet über ein Kabel die verschiedenen Objekt-Automatisierungsinseln (objektorientierte HW-Zusammenstellungen) => eine oder mehrere Objektinseln befinden sich "hinter" / an einem Gateway Modulbusweiterleitung / -einspeisung und Modulbusabzweig für räumlich verteilte Teilnehmer als Standard-Modulbus oder Subbus.

Eine Modulbusweiterleitung und -einspeisung wird durch Kabelabschnitte möglich. Ein Modulbusabzweig erfolgt mit einem teilweise ungeschnittenen Kabel, T-Stücken und Zwischensteckern mit Busanschaltung und I/O-Funktion. Die Modulbusweiterleitung / -einspeisung erfolgt über ein 8-poliges Datenkabel mit RJ45. Auch können über einen Hybrid-/Datenbus-Stecker in Kombination mit einem I/O-Zwischenstecker einzelne, bisher nicht busfähige Geräte wie z.B. einfache Schaltgeräte in die Kommunikation eingebunden werden.

Dieser Modulbusabzweig wird als LP-Randverbinder mit einem aufsteckbaren Hybrid-/Datenbus-Stecker in 22,5mm und IDC-Anschlüssen mit kombinierten Querschnitten ausgeführt. Hybrid-/Datenbus-Stecker: 2 x 1,5mm² (Versorgung) und 4 x 0,5mm² (Daten) mit z.B. 5-poligem Devicenetkabel (1 Ader bleibt ungenutzt); Besonders vorteilhaft ist ein 4-poliges Profilkabel, bei welchem die Adern eine definierte Position besitzen und dessen Mantel nicht entfernt werden muss.

Die nach vorn hin abgehenden Schneidklemm-Kontakte (Gabeln) erlauben das Einlegen eines partiell abgemantelten Rundkabels oder eines Profilkabels (ggf. 1 x 0,5mm² ungenutzt und) 2 x 1,5mm² bleiben ungeschnitten / durchgehend => T-Funktion. 2 x 0,5mm² werden durchgeschnitten, um als Daisy-Chain zu wirken; Durch Verdrehen der IDC-Kontakte eines Kontaktpaares um jeweils 180° liegen jeweils 2 IDC-Gabeln hintereinander und die Kontakte des LP-Randverbinders nebeneinander, wobei die 4 Gabeln sich nicht unterscheiden.

Der Stecker ist abgestimmt auf einen Low-Cost-Bus (G-Bus) mit 2 Datenleitungen als Daisy-Chain, 2 Versorgungsleitungen, einem Hybridkabel mit 2 x 2 Adernpaaren und modifizierte SA-Stecker.

Durch diese Produktstruktur und Automatisierungsarchitektur lassen sich der Platzbedarf im Schaltschrank und der notwendige Verdrahtungsaufwand enorm durch die Steckbarkeit reduzieren und durch die objektorientierte Zusammenstellung die Übersichtlichkeit enorm im Schaltschrank steigern.

Bei weiterer Dezentralisierung und gleichzeitiger Modularisierung der Maschinen u. Anlagen können die Vorteile einer objektorientierten Programmierung, HW-Zusammenstellung und Verdrahtung voll zur Geltung kommen.

Vom zentralen Schaltschrank, über Maschinenausschnitte hin zu dezentralen Busgehäuse / Klemmenkasten auf Maschinenmodulen mit verteilter Signalverarbeitung / Intelligenz.

Durch die Flexibilität des Konzeptes kann das System in der heute verwendeten Schaltschrankstruktur genutzt werden, andererseits kann aber auch der Schaltschrankaufbau (je nach Kundenwunsch) schrittweise in Richtung Objektorientierung optimiert werden.

Denkbar ist auch eine Auslegung in höherer Schutzart: IP67, anreihbar wie Reihenklemmen im 120mm Klemmenlänge, 25mm breite Gehäuse mit 4 x M12 und 8 x M8, 50mm breite Gehäuse mit 8 x M12 und 16 x M8, Anschlussebenen mit aufrecht stehenden LPs in einem HDC-Gehäuse => Remote I/O bzw. bRK in der Wanddurchführung, alleinstehende IP67-I/O-Module.

Aus der Figurenbeschreibung ergibt sich, dass es bei der I/O-Ebene im Wesentlichen zwei Ausprägungsformen, insbesondere mit Zwischenstecker (oder Steckelektronik) auf einem niedrigen Block (mit flach liegender Leiterplatte) oder niedrigen Scheiben / Blöcken (mit aufrecht stehenden Leiterplatten):
A: Funktionenaufteilung eines Remote I/O in Basis-Leiterplatte (Plattform) und Spezial-Leiterplatte (Funktionsausprägung) => ähnlich ET 200L (MK)
A: mechanisch konfigurierbare Low Cost-I/O-Elektronik durch immer zu steckende "eklektisch robuste" Signalanpassungsmodule (vorzugsweise nicht softwaremäßig konfigurierbar).

Dabei wird die Elektronikfunktion in Grundfunktion und spezifische Funktion aufgeteilt, wobei sich die Grundfunktion in der Plattform und die spezifische Funktion im 1-kanaligen Zwischenstecker befindet; z.B.: DI in der Plattform u. Pegelumsetzung mit Eingangszeitverzögerung im Zwischenstecker (24Vdc 3ms; 24Vdc 0,2ms; 110Vdc; 230Vac; ...); DO-Treiberansteuerung in der Plattform und Ausgangstreiber im Zwischenstecker: 0,5A pnp; 2A npn; 6A RO; ..; Al-Messwerterfassung (digital) in der Plattform und beliebig unterschiedliche 1-Kanal-Wandlerbausteine im Zwischenstecker (0-10V; 4-20mA; PT100; Thermo); AO ....
B: Funktionenintegration der Signalanpassung in das Remote I/O
B: softwaremäßig konfigurierbare Standard-I/O-Elektronik (oder IO-Link-Elektronik) und optional steckbare Signalanpassungsmodule im Zwischenstecker (nur bei IO-Link ist der Zwischenstecker softwaremäßig konfigurierbar.

Die Anordnung von Schnittstellen / Funktionen zu Bauräumen innerhalb des Systems sind vorzugsweise: 400Vac-Verteilersystem; u.a. 230Vac-Abgriff; Direkteinspeisung von Plus- bzw. Minus-Potentialvervielfachungsklemmen für DI oder DO; DI/DO-Versorgungs-Auswahlschalter; nach vorn: Feldgeräte-(Verbraucher-/SA-)Anschlüsse; Einspeisung von z.B. 5Vdc, 24Vdc, 110Vdc, 230Vac, 400Vac; nach unten: FE-Verteilersystem für KLBÜ-Schirmanschlüsse; Datenanschlüsse; Modulbusweiterleitung; abgehende Subbusse.

Alternativ sind die Bauräume in Ergänzung auch anders nutzbar, z.B. bei Kombination von Remote I/O und HMI:
- mehrere flach liegende Leiterplatten übereinander; zu oberst: HMI-LP; von oben: Feldgeräte-(Verbraucher-/SA-)Anschlüsse; nach vorn: Display / HMI; Kühlkörper;
nach unten:
- Feldgeräte-(Verbraucher-/SA-)Anschlüsse;

Die Anschlussleisten am LP-Rand nach oben und unten besitzen das gleiche Raster wie der Rahmen längs. Die Anschlussleiste ist der Standardrahmen und kann auch quer am LP-Rand aufgesetzt werden.

Vorteilhaft ist auch das multifunktionale 10x3-Schienenhalterbefestigungs- / Markierungs-Modul (Koordinatensystem) mit Befestigung nach unten (n x für KLBÜ) und - oben (5 x für L1, N, L2, PE, L3) => Reihenfolge mit geringsten LuK-Strecken

Vorn wird vorzugsweise eine Markierungsebene als Bestandteil eines Koordinaten- / Ordnungssystems realisiert.

Denkbar ist die Anbringung von 16 Markierungsschildern bzw. alternativ 8 Schilder in doppelter Größe: unten Schirmerdungs-Potentialausgleich- und -ableitsystem mit Schirmklemmen (KLBÜ) für geschirmte (Analog-)Kabel.

Vorzugsweise sind die 10x3-Schienen sind so schräg gestellt und positioniert, dass min. 2 KLBÜ aufgenommen u. jeweils 2 Kabel eingelegt werden können. Denkbar ist es auch, das 4 KLBÜ unterbringbar sind: 400Vac-Verteilersystem für Schütze, Motorstarter / Wendestarter, Sanftanlaufgeräte, Frequenzumrichter, ....

Denkbar sind zudem Schienenhalter nach oben für 5 x 10x3-Schiene und 2,5mm²-Abgriffen zum Einstecken in das Schienenhalterbefestigungs-Modul und Schraubbefestigungsmöglichkeit auf die Montageplatte. Ein Kunststoffprofil ist optional mit Schraubbefestigungsmöglichkeit auf Montageplatte für 5 x 10x3-Schienen (Schütze, Motorstarter, FU...), insbesondere aufrecht stehend

Denkbar sind eine Abdeckung d. Schienen/Anschlüsse mit Schlitzen für die Leiteraustritte und/oder als Berührungsschutz

Die Raster in x- und y-Richtung können auch Teile oder ein Mehrfaches von dem ausgewählten Raster betragen; x-Richtung 10,0mm: 5,00mm... 20mm, 40mm, 80mm, 160mm, ...; y-Richtung 22,5mm: 11,25mm... 45mm, 90mm, ....

In dem Koordinatensystem werden immer gleiche Bauräume "aufgespannt", die Steckplätze für Steckelemente darstellen.

Der Rahmen erzeugt mit den Steckplätzen eine stehende Verdrahtung; dies bedeutet, dass ein Modul ohne gesteckter Elektronik mit Einzeladern oder SA-Steckern verdrahtet werden kann und ein Elektronikmodul ausgetauscht werden kann, ohne die Adern aus den Anschlüssen lösen zu müssen. Alternativ befinden sich die Steckplätze direkt in die Gehäusewand bzw. im Gehäusedeckel der Elektronik; dann jedoch muss die Elektronik zur Verdrahtung gesteckt sein.

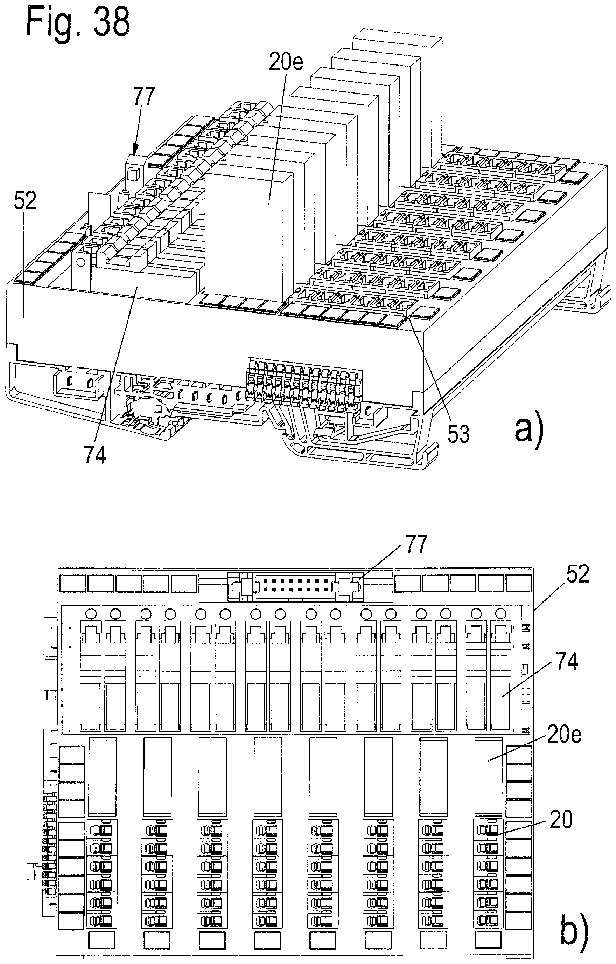

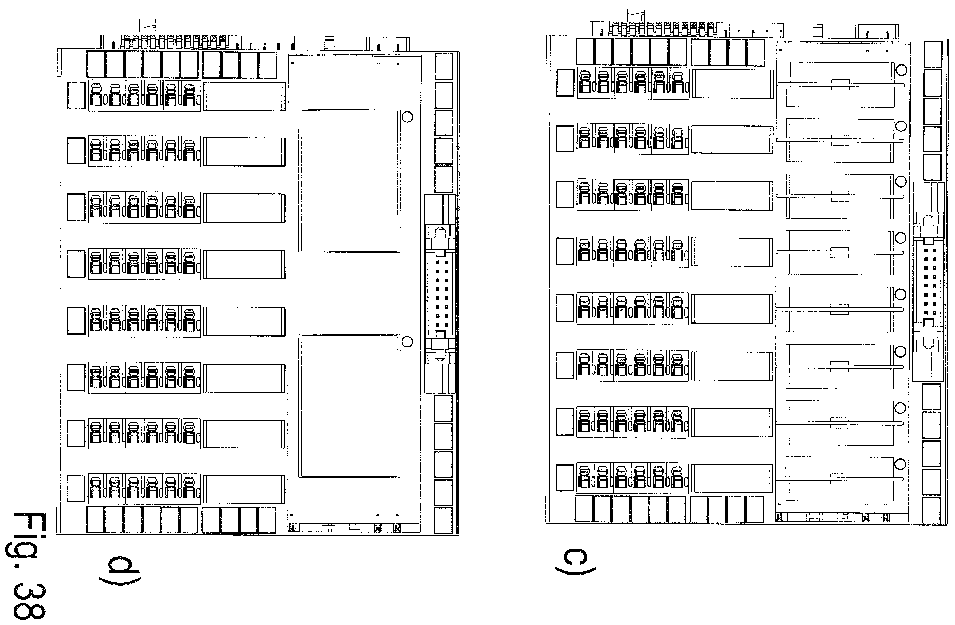

In einer weiteren Ausprägungsform (Fig. 38) der niedrigen Blockmodule mit Relais wird vorgeschlagen die Belegungsfläche unterschiedlicher Relais (Fig. 38b-d) mit ihren Relaissockeln flächenmäßig zu standardisieren.

Dabei orientiert sich das Raster nicht mehr an dem des Scheibenaufbaus 1, sondern an der gemeinsamen übersichtlichen Zuordnung der Reihenklemmenfunktionen wie z.B. Sicherungen und Anschlusstechnik zu den Relais.

Es wird ein einteiliger Rahmendeckel 71 realisiert, in den all die bekannten Funktionsbausteine 20 in die normierten Steckplätze 53 einsetzbar sind.

Die niedrigen Blockmodule mit Relais 74 und steckbaren Sicherungen als Funktionsbausteine 20h gibt es als busfähige Variante mit Buskontakten 11, 12 und alternativ als nicht busfähige Variante, wobei dann die Buskontakte 11, 12 durch einen Flachkabelstecker 77 und ggf. Klemmen zur Bezugspotentialeinspeisung (Minus) ersetzt werden können. Der Einfachheit halber sind in Fig. 39 beide Varianten in einer Ausführung dargestellt.

Die dargestellten Anschlussbausteine 20a sind als Alternative zu dem Flachkabelstecker zu verstehen.

Die in Fig. 43a-c gezeigte Anschluss- und/oder Funktionseinheit 7 eignet sich zum Aufsetzen auf den Basisklemmenträger 2 einer der vorgenannten Anschluss- und/oder Funktionsmodule 1.

Die Anschluss- und/oder Funktionseinheit 7 ist, analog der Anschluss- und/oder Funktionseinheit 7 der Fig. 4, als ein separates Element ausgebildet, mit einem Rahmen 21', der an den Basisklemmenträger 2 ansetzbar ist, und der umlaufende Seitenwände 22 bis 25 und Trennwände 27 aufweist, wobei die Trennwände 27 den Rahmen 21' ebenfalls in Aufnahmekammern bzw. Steckplätze 28 unterteilt. In die Aufnahmekammern sind ebenfalls Anschlussbausteine als Funktionsbausteine 20 einsetzbar.

Weiterhin ist die Anschluss- und/oder Funktionseinheit 7 der Fig. 43 ebenfalls schwenkbar an dem Basisklemmenträger 2 anordbar. Dafür weist sie ebenfalls eine Achse/Zapfen 30 an dem Rahmen 21' auf, die in dem Aufnahmeraum 31 des Schwenklagers 29 des einen Seitenschenkels 14 des Basisklemmenträgers 2 (s. beispielsweise Fig. 3) anordbar ist.

Zum Lösen ist auch hier eine durch Fingerdruck oder dgl. betätigbare Rasttaste 32 mit Rasthaken 33 am Rahmen 21' der Anschluss- und/oder Funktionseinheit 7 angeordnet, wobei der Rasthaken 33 mit der am anderen Seitenschenkel 15 des Basisklemmenträgers 2 ausgebildeten Rastausnehmung 34 (s. Fig. 3) zusammenwirkt.

Weiterhin zeigt die Fig. 43 vor allem Rastelemente 241, 221 am Rahmen 21', die mit Rastgegenelementen 222 an den in die Steckplätze 28 eingesetzten Anschluss- und/oder Funktionsbausteinen 20 zusammenwirken. Die Rastelemente 241 sind hier entweder als Einbuchtungen ausgebildet, in die die hier als Steckelemente, insbesondere als Schnappelemente, ausgebildeten Rastgegenelemente (nicht gezeigt) einsteckbar sind, oder sie sind umgekehrt als Steckelemente 221, nämlich hier als Schnappelemente, ausgebildet, die in als Einbuchtungen oder Nuten ausgebildete Rastgegenelemente 222 der Anschluss- und/oder Funktionsbausteine 20 eingreifen.

Im Gegensatz zur Ausführungsform der Anschluss- und/oder Funktionseinheit 7 der Fig. 4 sind an der in Fig. 43 gezeigten Anschluss- und/oder Funktionseinheit 7 an den Trennwänden 27 zusätzlich Führungsmittel 271, die hier als Stege ausgebildet sind, angeordnet, welche mit Nuten (nicht gezeigt) der Anschluss- und/oder Funktionsbausteine 20 zusammenwirken, so dass die Anschluss- und/oder Funktionsbausteine 20 in eine durch die Führungsmittel 271 vorgegebene Richtung in den Rahmen 21' einführbar sind..

Die Anschluss- und/oder Funktionsbausteine 20 sind hier in dieselbe Anschlussrichtung Z, die auch für die Leiter vorgesehen ist, in die Steckplätze 28 einsteckbar. Dabei sind als Anschluss- und/oder Funktionsbausteine 20 hier beispielhaft verschiedene Anschluss- und Funktionsbausteine 20a, 20a', 20a" vorgesehen, wobei einer der Anschluss- und Funktionsbausteine 20a eine Schaltung 20l umfasst.

Die übrigen Anschluss- und Funktionsbausteine 20a' und 20a" der Fig. 43 unterscheiden sich von den oben vorgestellten Anschluss- und/oder Funktionsbausteinen 20a durch ein Entnahmemittel 201, welches hier als ein vom Bediener betätigbares Betätigungsfeld ausgebildet ist, welches zum Lösen der Verrastung der Anschluss- und/oder Funktionsbausteine 20 vom Rahmen, und somit zu ihrer Entnahme aus dem Rahmen 21', vorgesehen ist. Es ist bevorzugt, dass die Anschluss- und/oder Funktionsbausteine 20 aus dem Rahmen lösbar vorgesehen sind, so dass sie bevorzugt ein solches Entnahmemittel 201 aufweisen. Es sind auch andere Entnahmemittel 201 bevorzugt, die ein Lösen der Verrastung und somit die Entnahme der Anschluss- und/oder Funktionsbausteine 20 aus dem Rahmen 21' ermöglichen, beispielsweise auch solche, die mittels eines Werkzeugs (nicht gezeigt) betätigbar sind.

Im Folgenden werden die Begriffe Entnahmemittel 201 und Betätigungsfeld synonym verwendet. Das Betätigungsfeld 201 ist hier bei im Rahmen 21' angeordnetem Anschluss- und/oder Funktionsbaustein 20 in einem dem Rahmen 21' überstehenden Bereich 202 eines Gehäuses 200 des Anschluss- und/oder Funktionsbausteins 20 angeordnet, so dass es für einen Bediener leicht zugänglich ist. Durch Drücken des Betätigungsfeldes 201 in eine Entnahmerichtung E (s. Fig. 43 (d)) wird das Gehäuse 200 des Anschluss- und/oder Funktionsbausteins 20 so verbogen, dass die am Anschluss- und/oder Funktionsbaustein 20 angeordneten Rastgegenelemente 222 außer Eingriff mit den Rastelementen 221 des Rahmens 21' geraten, und der Anschluss- und/oder Funktionsbaustein 20 dem Steckplatz 28 gegen die Anschlussrichtung Z der Leiter entnehmbar ist.

Fig. 43 (a) und (b) zeigen außerdem zwei Anschluss- und/oder Funktionsbausteine 20a", die gemeinsam in einen Steckplatz 28 des Rahmens 21' eingesteckt sind. Die Breite 203 der Anschluss- und/oder Funktionsbausteine 20 entspricht daher einem Bruchteil, hier der Hälfte, einer Breite 281 der Steckplätze 28. Im vorliegenden Ausführungsbeispiel sind dieselben Anschluss- und Funktionsbausteine 20a" in den gemeinsamen Steckplatz 28 eingesteckt. Grundsätzlich sind aber auch verschiedene Anschluss- und/oder Funktionsbausteine 20, deren gemeinsame Breite 203 der Breite 281 des Steckplatzes 28 entspricht, im selben Steckplatz 28 platzierbar.

In den Schnittbildern der Fig. 43 (d) - (f) sind jeweils die elektrischen Kontakte 65 sichtbar, mit denen an die Anschluss- und/oder Funktionsbausteine 20a, 20a', 20a" angeschlossene elektrische Leiter mit dem Elektronikgehäuse 5 verbunden sind. Als elektrische Kontakte 65 sind hier beispielhaft IDC- Kontakte, Push In- Kontakte und/oder eine Kontakttulpe gezeigt.

Und zwar sind im Fall des Anschluss- und/oder Funktionsbausteins 20a" der Fig. 43(d) zur Aufnahme eines elektrischen Leiters zwei IDC- Kontakte 65 vorgesehen. Zum Anschließen an das Elektronikgehäuse 5 sind diese so geformt, dass sie einen Push In- Kontakt 62 bilden. Um den elektrischen Leiter an die IDC- Kontakte 65 anzuschließen, ist im Anschluss- und/oder Funktionsbaustein 20a" ein Schieber 204 angeordnet, der, solange der Anschluss- und/oder Funktionsbaustein 20a" nicht in der Anschluss- und Funktionseinheit 7 angeordnet ist, so verschoben werden kann, dass der elektrische Leiter in den Anschluss- und/oder Funktionsbaustein 20a" eingeschoben werden kann. Beim Zurückschieben des Schiebers 204 wird der elektrische Leiter in die IDC- Kontakte 65 geführt.

Im Fall des Anschluss- und/oder Funktionsbausteins 20a der Fig. 43 (f) kontaktiert der Push In- Kontakt 65 eine Leiterplatte 41 mit einem elektrischen Bus und/oder einer elektrischen Schaltung. Der elektrische Kontakt mit dem Elektronikgehäuse 5 wird hier durch eine Kontakttulpe 65 hergestellt.

**Bezugszeichen**

| | |
|---|---|
| Anschluss- und/oder Funktionsmodule | 1 |
| Basisklemmenträger | 2 |
| Rastmitteln | 3,4 |
| Elektronikgehäuse | 5 |
| Leiterplatte | 6 |
| Stanzgitter | 6' |
| Anschluss- und/oder Funktionseinheit | 7 |
| Öffnung | 8 |
| Betätigungselement | 9 |
| Anschlußvorrichtung | 10 |
| Bus-Kontaktelemente | 11 |
| Bus-Kontaktelemente | 12 |
| Grundschenkel | 13 |
| Seitenschenkel | 14, 15 |
| Aufnahmeraum | 16 |
| Rückwand | 17 |
| Frontwand | 18 |
| Ränder | 19 |
| Funktionsbausteine | 20 |
| Anschluss-Funktionsbausteine | 20a, 20a', 20a", b, c |
| Steckverbinder (SA.-Stecker) | 20d |
| Elektronikfunktionsbausteine wie Sicherungsfunktionsbausteine | 20e, f, g, h |
| Querverbinderbausteine | 20i |
| Funktionsbaustein mit Schaltung | 20l, 20l' |
| Markiererbaustein | 20m |
| Anschlussbaustein | 20n |
| Funktionsbausteine | 20o, p |
| Gehäuse des Funktionsbausteins | 200 |
| Entnahmemittel, Betätigungsfeld | 201 |
| überstehenden Bereich | 202 |
| Breite des Funktionsbausteins | 203 |
| Schieber | 204 |
| Rahmen | 21, 21' |
| Seitenwände | 22 bis 25 |
| Rastelement am Rahmen | 241, 221 |
| Rastgegenelement am Funktionsbaustein | 222 |
| Anschlussrichtung der Leiter | Z |
| Entnahmerichtung | E |
| Schwenkbügel | 26 |
| Trennwände | 27 |
| Führungsmittel, Steg | 271 |
| Aufnahmekammern/Steckplätze | 28 |
| Breite der Steckplätze | 281 |
| Schwenklager | 29 |
| Achse/Zapfen | 30 |
| Aufnahmeraum | 31 |
| Rasttaste | 32 |
| Rasthaken | 33 |
| Rastausnehmung | 34 |
| Markierflächen | 35 |
| Leiterbahnen | 36 |
| Elektronikgehäuse | 37 |
| Elektronikleiterplatte | 38 |
| Leiterplattenrandverbinder | 39 |
| Buskontakte | 40 |
| Leiterplatte | 41 |
| Steckplatz | 42 |
| Steckvorrichtung | 43 |
| Elektronikgehäuse | 44 |
| Markierungsscheibe | 45 |
| Markierflächen | 46 |
| Schirmschienenhalter | 47 |
| Stromschienen | 48 |
| Rastmittel | 49 |
| Anschlussblock | 50 |
| Basisklemmenträger | 51 |
| Rahmen | 52 |
| Steckplätze | 53 |
| Markierflächen | 54 |
| Funktionsbausteine | 54 |
| Ansätze | 55 |
| Tragschiene | 56 |
| Kabel | 58 |
| Stecker | 59 |
| Funktionsbausteine | 60 |
| Rasthaken | 61 |
| Querverbindung | 62 |
| Stecker | 64 |
| Elektrische Kontakte | 65 |
| Steckkontur | 66 |
| Relais | 67 |
| Steckplätze | 68 |
| Gehäuse | 69 |
| Aufsatz | 70 |
| Deckel | 71 |
| Verrastungsschieber | 72 |
| Öffnungen | 73 |
| Relais | 74 |
| Busleitungen | 75, 76 |
| Flachkabelstecker | 77 |

## Patentansprüche

1. Busfähiges, anreihbares Anschluss- und/oder Funktionsmodul (1) zur Steuerung und/oder Überwachung technischer Prozesse und/oder zur Industrie- und/oder Gebäudeautomatisierung mit einem scheiben- und/oder blockartigen Aufbau, welches dazu ausgelegt ist, mit weiteren Anschluss- und/oder Funktionsmodulen (1) zu einem Anschlusssystem zusammengestellt zu werden, mit folgenden Merkmalen:
a. wenigstens einem Basisklemmenträger (2) zum Befestigen an einer Montagebasis, vorzugsweise mit Rastmitteln (3, 4) zum Aufrasten auf eine Tragschiene (27) versehen,
b. wenigstens einem auf den Basisklemmenträger (2) aufsetzbaren Elektronikgehäuse, welches wenigstens eine Leiterplatte (6) und/oder ein Stanzgitter und/oder eine Stromschienenanordnung aufweist,
c. wenigstens einem oder mehreren Busleiterkontakten (11, 12) zur Weiterleitung wenigstens eines Energie- und/oder Datenbusses in Anreihrichtung an benachbarte, angereihte Anschluss- und/oder Funktionsmodule (1),
d. wobei wenigstens eine direkt am Basisklemmenträger (2) oder am Elektronikgehäuse (5) befestigbare Anschluss- und/oder Funktionseinheit (7) vorgesehen ist, welche wenigstens einen, zwei oder mehr separat anbringbare Funktionsbausteine (20) aufweist,
**dadurch gekennzeichnet**,
e. dass die Anschluss- und/oder Funktionseinheit (7) als Halteelement für wenigstens einen, zwei oder mehrere der Funktionsbausteine (20) einen Rahmen aufweist, der wenigstens einen, zwei oder mehr Steckplätze (28) zur Befestigung und vorzugsweise Aufnahme von wenigstens einem, zwei oder mehreren der Funktionsbausteine (20) aufweist,
f. wobei in den wenigstens einen oder die zwei oder mehr Steckplätze (28) jeweils einer oder mehrere Anschlussbausteine als die Funktionsbausteine (20) einsetzbar sind, welche am Rahmen (21, 21') reversibel verrastbar ist/sind, insbesondere indem der Rahmen (21, 21') ein Ras-telement (241, 221) und der Funktionsbaustein (20) ein Rastgegenelement (222) aufweist, die zusammenwirken.

2. Anschluss- und/oder Funktionsmodul nach einem der vorstehenden Ansprüche, **dadurch gekennzeichnet, dass** am Funktionsbaustein (20) ein Entnahmemittel (201) zum Lösen der Verrastung des Funktionsbausteins (20) mit dem Rahmen (21') vorgesehen ist.

3. Anschluss- und/oder Funktionsmodul nach einem der vorstehenden Ansprüche, **dadurch gekennzeichnet, dass** am Rahmen (21') ein Führungsmittel (271), insbesondere eine Nut oder ein Steg, vorgesehen ist, mit dem der Anschlussbaustein (20) in eine definierte Richtung führbar ist.

4. Anschluss- und/oder Funktionsmodul nach einem der vorstehenden Ansprüche, **dadurch gekennzeichnet, dass** die Funktionsbausteine (20) eine Breite (203) aufweisen, die einem Bruchteil einer Breite (281) der Steckplätze (28) entspricht, insbesondere ein Halbes oder ein Ganzes.

5. Anschluss- und/oder Funktionsmodul (1) nach Anspruch 2, 3 oder 4, **dadurch gekennzeichnet, dass** der wenigstens eine Funktionsbaustein (20) eine Elektronikschaltung aufweist.

6. Anschluss- und/oder Funktionsmodul (1) nach einem der vorstehenden Ansprüche, dass jeder der Anschlussbausteine jeweils wenigstens einen oder mehrere Leiteranschlüsse für externe Leiter in einem Isoliergehäuse aufweist, so dass die Anschlussbausteine gemeinsam eine Anschlussebene zum Anschluss externer Leiter ausbilden.

7. Anschluss- und/oder Funktionsmodul (1) nach einem der vorstehenden Ansprüche, **dadurch gekennzeichnet, dass** die Anschluss- und/oder Funktionseinheit (7) lösbar an dem Basisklemmenträger (2) befestigt ist, insbesondere verrastet ist.

8. Anschluss- und/oder Funktionsmodul (1) nach einem der vorstehenden Ansprüche, **dadurch gekennzeichnet, dass** der wenigstens eine Rahmen (21) der Anschluss- und/oder Funktionseinheit (7) an dem Basisklemmenträger (2) beweglich angeordnet ist und dass der Rahmen (21) an dem Basisklemmenträger (2) in eine definierte Offenstellung und eine Verschlussstellung beweglich ist.

9. Anschluss- und/oder Funktionsmodul (1) nach einem der vorstehenden Ansprüche, **dadurch gekennzeichnet, dass** an dem Elektronikgehäuse eine Handhabungsvorrichtung wie ein Schwenkbügel (26) angeordnet ist.

10. Anschluss- und/oder Funktionsmodul (1) nach einem der vorstehenden Ansprüche, **dadurch gekennzeichnet, dass** an dem Elektronikgehäuse eine Handhabungsvorrichtung wie ein Schwenkbügel (26) angeordnet ist.

11. Anschluss- und/oder Funktionsmodul (1) nach einem der vorstehenden Ansprüche, **dadurch gekennzeichnet, dass** am Schwenkbügel (26) ein Anzeigemittel (hier nicht gezeigt), beispielsweise eine LED, vorgesehen ist, die als Statusanzeige dient.

12. Anschluss- und/oder Funktionsmodul (1) nach einem der vorstehenden Ansprüche, **dadurch gekennzeichnet, dass** der Schwenkbügel (26) in eine Handhabungsstellung schwenkbar ist, welche es ermöglicht, das Elektronikgehäuse in Z-Richtung senkrecht zur Tragschiene vom Basisklemmenträger (2) abzuziehen.

## Claims

1. Bus-capable, modular connection and/or function module (1) for controlling and/or monitoring technical processes and/or for industrial and/or building automation with a plate-like and/or block-like structure, which is designed to be combined with further connection and/or function modules (1) to form a connection system, having the following features:
a) at least one base terminal carrier (2) for fixing to a mounting base, preferably provided with latching means (3, 4) for latching onto a mounting rail (27),
b) at least one electronics housing that can be placed on the base terminal carrier (2), which comprises at least one printed circuit board (6) and/or a stamped grid and/or a busbar arrangement,
c) at least one or more bus conductor contacts (11, 12) for forwarding at least one power and/or data bus in the direction of arrangement to adjacent connection and/or functional modules (1) arranged in rows,
d) wherein at least one connection and/or functional unit (7) is provided which is directly attachable to the base terminal carrier (2) or the electronics housing (5) and which has at least one, two or more separately attachable functional components (20),
**characterized in that**
e) the connection and/or functional unit (7) has a frame as a holding element for at least one, two or more of the functional components (20), which frame has at least one, two or more slots (28) for fastening and preferably receiving at least one, two or more of the functional components (20),
f) wherein in the at least one or the two or more slots (28) in each case one or more connection components can be used as the functional components (20), which is/are reversibly latched to the frame (21, 21'), in particular by the frame (21, 21 ') having a latching element (241, 221) and the functional component (20) having a counter-latching element element (222) which interact.

2. Connection and/or function module according to one of the preceding claims, **characterized in that** a removal means (201) for releasing the latching of the functional component (20) with the frame (21') is provided on the functional component (20).

3. Connection and/or function module according to one of the preceding claims, **characterized in that** a guide means (271) is provided on the frame (21'), in particular a groove or a web, with which the connection component (20) can be guided in a defined direction.

4. Connection and/or function module according to one of the preceding claims, **characterized in that** the functional components (20) have a width (203) which corresponds to a fraction of a width (281) of the slots (28), in particular a half or a whole.

5. Connection and/or function module (1) according to claim 2, 3 or 4, **characterized in that** the at least one functional component (20) comprises an electronic circuit.

6. Connection and/or function module (1) according to one of the preceding claims, that each of the connection components in each case has at least one or more conductor terminals for external conductors in an insulating housing, so that the connection components together form a connection level for connecting external conductors.

7. Connection and/or function module (1) according to one of the preceding claims, **characterized in that** the connection and/or functional unit (7) is releasably attached to the base terminal carrier (2), in particular latched thereto.

8. Connection and/or function module (1) according to one of the preceding claims, **characterized in that** the at least one frame (21) of the connection and/or functional unit (7) is movably arranged on the base terminal carrier (2) and that the frame (21) is movable on the base terminal carrier (2) into a defined open position and a closed position.

9. Connection and/or function module (1) according to one of the preceding claims, **characterized in that** a handling device such as a swivel bracket (26) is arranged on the electronics housing.

10. Connection and/or functional module (1) according to one of the preceding claims, **characterized in that** a handling device such as a swivel bracket (26) is arranged on the electronics housing.

11. Connection and/or function module (1) according to one of the preceding claims, **characterized in that** a display means (not shown here), for example an LED, is provided on the swivel bracket (26) which serves as a status indicator.

12. Connection and/or function module (1) according to one of the preceding claims, **characterized in that** the swivel bracket (26) is pivotable into a handling position, which makes it possible to withdraw the electronics housing in the Z direction perpendicular to the mounting rail of the base terminal carrier (2).

## Revendications

1. Module de raccordement et/ou fonctionnel (1) compatible avec un bus et pouvant être aligné en série selon une structure en plaque et/ou en bloc pour la commande et/ou la surveillance de processus techniques et/ou pour l'automatisation d'installations industrielles ou domotiques, conçu pour être assemblé avec d'autres modules de raccordement et/ou fonctionnels (1) pour former un système de raccordement, présentant les caractéristiques suivantes :
a. au moins un support de bornes de base (2) destiné à être fixé sur une base de montage, muni de préférence de moyens d'enclenchement (3, 4) pour s'enclencher sur un rail porteur (27),
b. au moins un boîtier électronique pouvant être posé sur le support de bornes de base (2), qui présente au moins une carte de circuits imprimés (6) et/ou une grille découpée et/ou une disposition de barre omnibus,
c. au moins un ou plusieurs contacts de conducteurs de bus (11, 12) destinés à transmettre au moins un bus d'énergie et/ou de données à des modules de raccordement et/ou fonctionnels (1) voisins alignés en série dans le sens d'alignement,
d. dans lequel est prévue au moins une unité de raccordement et/ou fonctionnelle (7) pouvant être fixée au support de bornes de base (2) ou au boîtier électronique (5), qui présente au moins un, deux ou plusieurs composants fonctionnels (20) pouvant être mis en place séparément,
**caractérisé en ce que**
e. l'unité de raccordement et/ou fonctionnelle (7) présente, pour servir d'élément de maintien pour au moins un, deux ou plusieurs des composants fonctionnels (20), un cadre qui présente au moins un, deux ou plusieurs emplacements de connexion (28) pour fixer et de préférence loger au moins un, deux ou plusieurs des composants fonctionnels (20),
f. au moins un ou plusieurs composants de raccordement pouvant être introduits dans chacun des au moins un ou deux ou plusieurs emplacements de raccordement (28) pour servir de composants fonctionnels (20), lesquels peuvent être enclenchés de façon réversible sur le cadre (21, 21'), en particulier par le fait que le cadre (21, 21') présente un élément d'enclenchement (241, 221) et le composant fonctionnel (20) un élément d'enclenchement opposé (222) qui coopèrent.

2. Module de raccordement et/ou fonctionnel selon l'une des revendications précédentes, **caractérisé en ce qu'**il est prévu sur le composant fonctionnel (20) un moyen de retrait (201) pour défaire l'enclenchement du composant fonctionnel (20) sur le cadre (21').

3. Module de raccordement et/ou fonctionnel selon l'une des revendications précédentes, **caractérisé en ce qu'**il est prévu sur le cadre (21') un moyen de guidage (271), en particulier une rainure ou une aile profilée, avec lequel le composant de raccordement (20) peut être guidé dans une direction définie.

4. Module de raccordement et/ou fonctionnel selon l'une des revendications précédentes, **caractérisé en ce que** les composants fonctionnels (20) présentent une largeur (203) qui correspond à une fraction de la largeur (281) des emplacements de connexion (28), en particulier à la moitié ou à la valeur entière.

5. Module de raccordement et/ou fonctionnel (1) selon la revendication 2, 3 ou 4, **caractérisé en ce que** l'au moins un composant fonctionnel (20) présente un circuit électronique.

6. Module de raccordement et/ou fonctionnel (1) selon l'une des revendications précédentes, **caractérisé en ce que** chacun des composants de raccordement présente au moins une ou plusieurs connexions de conducteurs pour des conducteurs externes dans un boîtier isolant, de sorte que les composants de raccordement forment ensemble un étage de connexion pour la connexion de conducteurs externes.

7. Module de raccordement et/ou fonctionnel (1) selon l'une des revendications précédentes, **caractérisé en ce que** l'unité de raccordement et/ou fonctionnelle (7) est fixée, en particulier enclenchée, de façon amovible sur le support de bornes de base (2).

8. Module de raccordement et/ou fonctionnel (1) selon l'une des revendications précédentes, **caractérisé en ce que** l'au moins un cadre (21) de l'unité de raccordement et/ou fonctionnelle (7) est disposé de façon mobile sur le support de bornes de base (2) et **en ce que** le cadre (21) est mobile sur le support de bornes de base (2) dans une position d'ouverture définie et une position de fermeture.

9. Module de raccordement et/ou fonctionnel (1) selon l'une des revendications précédentes, **caractérisé en ce qu'**un dispositif de manipulation, tel qu'un étrier pivotant (26), est disposé sur le boîtier électronique.

10. Module de raccordement et/ou fonctionnel (1) selon l'une des revendications précédentes, **caractérisé en ce qu'**un dispositif de manipulation, tel qu'un étrier pivotant (26), est disposé sur le boîtier électronique.

11. Module de raccordement et/ou fonctionnel (1) selon l'une des revendications précédentes, **caractérisé en ce qu'**il est prévu sur l'étrier pivotant (26) un moyen d'affichage (non représenté ici), par exemple une DEL, qui sert d'indicateur d'état.

12. Module de raccordement et/ou fonctionnel (1) selon l'une des revendications précédentes, **caractérisé en ce que** l'étrier pivotant (26) peut pivoter dans une position de manipulation qui permet de retirer le boîtier électronique du support de borne de base (2) dans la direction Z perpendiculairement au rail porteur.
